# EUROPEAN PATENT APPLICATION

(11) **EP 4 651 175 A1**
(43) Date of publication of application: **19.11.2025**
(21) Application number: 25176010.4
(22) Date of filing: 13.05.2025
(51) Int. Cl.: H01J 37/26, G06F 40/00

(54) **LARGE LANGUAGE MODEL ASSISTANCE FOR CHARGED-PARTICLE MICROSCOPE OPERATION**

(30) Priority: 13.05.2024 US 202418662561
(71) Applicant: FEI Company, Hillsboro, OR 97124-5793 (US)
(72) Inventor: JANCIK, Radek, Brno (CZ); MACHEK, ONDREJ, Brno (CZ); SCHOENMAKERS, Remco Hubertus Maria, Best (NL)
(74) Representative: Boult Wade Tennant LLP

(57) **Abstract**

Systems/techniques are provided for facilitating large language model assistance for charged-particle microscope operation. In various embodiments, a system can access a natural language instruction associated with a charged-particle microscope, where the natural language instruction can request that the charged-particle microscope undergo a configurable settings adjustment or perform an automated task. In various aspects, the system can cause, in response to the natural language instruction, the charged-particle microscope to capture, according to a default microscopy protocol, an image or an energy spectrum of a specimen that is currently loaded on a stage of the charged-particle microscope. In various instances, the system can execute a large language model on both the natural language instruction and the image or energy spectrum of the specimen, thereby yielding a natural language response that indicates how implementing the natural language instruction would affect the specimen.

## Description

### BACKGROUND

The technical field of charged-particle microscopy has been historically constrained by its operational complexity. Such operational complexity can prevent users from efficiently or intuitively interacting with charged-particle microscopes.

### SUMMARY

The following presents a summary to provide a basic understanding of one or more embodiments. This summary is not intended to identify key or critical elements, or delineate any scope of the particular embodiments or any scope of the claims. Its sole purpose is to present concepts in a simplified form as a prelude to the more detailed description that is presented later. In one or more embodiments described herein, devices, systems, computer-implemented methods, apparatus or computer program products that facilitate large language model assistance for charged-particle microscope operation are described.

According to one or more embodiments, a system is provided. The system can comprise a non-transitory computer-readable memory that can store computer-executable components. The system can further comprise a processor that can be operably coupled to the non-transitory computer-readable memory and that can execute the computer-executable components stored in the non-transitory computer-readable memory. In various embodiments, the computer-executable components can comprise an access component that can access a natural language instruction provided by a user of a charged-particle microscope, wherein the natural language instruction can request or command that the charged-particle microscope undergo a configurable settings adjustment or that the charged-particle microscope perform an automated task. In various aspects, the computer-executable components can comprise a state component that can cause, in response to receipt of the natural language instruction, the charged-particle microscope to capture, according to a default microscopy protocol, an image or an energy spectrum of a specimen that is currently loaded on a stage of the charged-particle microscope. In various instances, the computer-executable components can comprise a model component that can execute a large language model on both the natural language instruction and the image or energy spectrum of the specimen, thereby yielding a natural language response that can indicate how implementing the natural language instruction would affect the specimen.

According to one or more embodiments, a computer-implemented method is provided. In various embodiments, the computer-implemented method can comprise accessing, by a device operatively coupled to a processor, a natural language instruction provided by a user of a charged-particle microscope, wherein the natural language instruction can request or command that the charged-particle microscope undergo a configurable settings adjustment or that the charged-particle microscope perform an automated task. In various aspects, the computer-implemented method can comprise causing, by the device and in response to receipt of the natural language instruction, the charged-particle microscope to capture, according to a default microscopy protocol, an image or an energy spectrum of a specimen that is currently loaded on a stage of the charged-particle microscope. In various instances, the computer-implemented method can comprise executing, by the device, a large language model on both the natural language instruction and the image or energy spectrum of the specimen, thereby yielding a natural language response that can indicate how implementing the natural language instruction would affect the specimen.

According to one or more embodiments, a computer program product for facilitating large language model assistance for charged-particle microscope operation is provided. In various embodiments, the computer program product can comprise a non-transitory computer-readable memory having program instructions embodied therewith. In various aspects, the program instructions can be executable by a processor to cause the processor to access a plain text command provided by a user of a scanning electron microscope, wherein the plain text command can request that the scanning electron microscope perform a specified microscopy action. In various instances, the program instructions can be executable by the processor to cause the processor to, in response to receipt of the plain text command, cause the scanning electron microscope to capture, via a default microscopy protocol, an image or energy spectrum of a specimen that is currently loaded on a stage of the scanning electron microscope. In various cases, the program instructions can be executable by the processor to cause the processor to execute a large language model on both the plain text command and the image or energy spectrum of the specimen, wherein the large language model can produce as output a plain text response that indicates whether the specified microscopy action would damage the specimen. In various aspects, the program instructions can be executable by the processor to cause the processor to visibly or audibly render the plain text response on an electronic display or on an electronic speaker associated with the scanning electron microscope.

### DESCRIPTION OF THE DRAWINGS

Various embodiments will be readily understood by the following detailed description in conjunction with the accompanying figures. To facilitate this description, like reference numerals designate like structural elements. Embodiments are illustrated by way of example, not by way of limitation, in the figures. The figures are not necessarily drawn to scale.
FIG. 1 illustrates an example, non-limiting block diagram of a scientific instrument module in accordance with various embodiments described herein.
FIG. 2 illustrates an example, non-limiting flow diagram of a computer-implemented method in accordance with various embodiments described herein.
FIG. 3 illustrates a block diagram of an example, non-limiting system that facilitates large language model assistance for charged-particle microscope operation in accordance with one or more embodiments described herein.
FIG. 4 illustrates a block diagram of an example, non-limiting system including a specimen image, a specimen energy spectrum, and a current microscope health status that facilitates large language model assistance for charged-particle microscope operation in accordance with one or more embodiments described herein.
FIG. 5 illustrates an example, non-limiting block diagram showing how a specimen image or energy spectrum can be obtained in accordance with one or more embodiments described herein.
FIG. 6 illustrates an example, non-limiting block diagram showing how a current microscope health status can be obtained in accordance with one or more embodiments described herein.
FIG. 7 illustrates a block diagram of an example, non-limiting system including a set of relevant documents, a set of inferencing task results, and a set of simulation results that facilitates large language model assistance for charged-particle microscope operation in accordance with one or more embodiments described herein.
FIGs. 8-12 illustrate example, non-limiting block diagrams showing how a set of relevant documents, a set of inferencing task results, and a set of simulation results can be obtained in accordance with one or more embodiments described herein.
FIG. 13 illustrates a block diagram of an example, non-limiting system including a natural language response and synthesized code that facilitates large language model assistance for charged-particle microscope operation in accordance with one or more embodiments described herein.
FIGs. 14-30 illustrate example, non-limiting block diagrams or flow diagrams showing how a natural language response and synthesized code can be obtained in accordance with one or more embodiments described herein.
FIG. 31 illustrates an example, non-limiting block diagram showing how various artificial intelligence models can be trained in accordance with one or more embodiments described herein.
FIG. 32 illustrates an example, non-limiting block diagram of a graphical user interface that can be used in the performance of some or all of the methods or techniques disclosed herein, in accordance with various embodiments described herein.
FIG. 33 illustrates an example, non-limiting block diagram of a computing device that can perform some or all of the methods or techniques disclosed herein, in accordance with various embodiments described herein.
FIG. 34 illustrates an example, non-limiting block diagram of a scientific instrument support system in which some or all of the methods or techniques disclosed herein may be performed, in accordance with various embodiments described herein.
FIG. 35 illustrates a block diagram of an example, non-limiting operating environment in which one or more embodiments described herein can be facilitated.
FIG. 36 illustrates an example networking environment operable to execute various implementations described herein.
FIG. 37 illustrates an example dual beam microscope that can be implemented in accordance with various embodiments described herein.

### DETAILED DESCRIPTION

The following detailed description is merely illustrative and is not intended to limit embodiments or application/uses of embodiments. Furthermore, there is no intention to be bound by any expressed or implied information presented in the preceding Background or Summary sections, or in the Detailed Description section.

One or more embodiments are now described with reference to the drawings, wherein like referenced numerals are used to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

Various operations can be described as multiple discrete actions or operations in turn, in a manner that is most helpful in understanding the subject matter disclosed herein. However, the order of description should not be construed as to imply that these operations are necessarily order dependent. In particular, these operations can be performed in an order different from the order of presentation. Operations described can be performed in a different order from the described embodiments. Various additional operations can be performed, or described operations can be omitted in additional embodiments.

Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices. As used herein, the phrase "based on" should be understood to mean "based at least in part on," unless otherwise specified.

A charged-particle microscope (e.g., a scanning electron microscope (SEM), a transmission electron microscope (TEM), an electron energy-loss microscope (EELM)) can be any suitable computerized device that can capture or generate microscopic or nanoscopic images or energy spectra in a scientific, laboratory, research, or clinical operational environment. To facilitate the capture or generation of such images or energy spectra, charged-particle microscopes can leverage complex arrangements of actuatable parts (e.g., ion sources, electron sources, optical lenses or apertures, optical plates or deflectors, columns, coils, heaters, coolers, fluid valves, fluid pumps, circuit switches, specimen stages), sensors (e.g., ion detectors, electron detectors, voltmeters, thermistors, potentiometers, pressure gauges), or consumables (e.g., carrier fluids, calibrants, filters, reactive gases).

The technical field of charged-particle microscopy has been historically constrained by its operational complexity. In other words, because charged-particle microscopes can have such complicated constructions, they can be commensurately complicated to operate or use. Indeed, in order for a user to competently or confidently use a charged-particle microscope to analyze clinical or laboratory specimens, that user often requires extensive specialized training, education, or certification with respect to the charged-particle microscope. For example, the user can learn how to properly operate a graphical user-interface (GUI) or physical controls of the charged-particle microscope by studying weeks-long or months-long microscopy courses (after all, the charged-particle microscope can, at first glance, have a dizzying or overwhelming number of configurable software or hardware settings, buttons, knobs, sliders, or options). A user that does not undergo such extensive studying can be unable to competently use the charged-particle microscope. For example, a user that does not take an appropriate weeks-long or months-long microscopy course, but that nevertheless attempts to operate the charged-particle microscope, can be significantly likely to damage specimens or the charged-particle microscope itself.

Unfortunately, this need for extensive study can be significantly compounded in view of the fact that different types of charged-particle microscopes can be operated differently than each other. That is, specialized microscopy training, education, or certification is often not transferrable between, among, or across different charged-particle microscopes. For example, whatever training that readies one to competently operate an SEM does not necessarily ready one to competently operate a TEM. As another example, whatever training that readies one to competently operate an SEM having model number A does not necessarily ready one to competently operate an SEM having model number B. As even another example, whatever training that readies one to competently operate an SEM having model number A and software version C does not necessarily ready one to competently operate an SEM having model number A and software version D.

In any case, such immense operational complexity can prevent users from efficiently or intuitively interacting with charged-particle microscopes. In other words, such immense operational complexity can be considered as a high barrier-to-entry in the field of charged-particle microscopy.

Accordingly, systems or techniques that can reduce such barrier-to-entry (e.g., that can make charged-particle microscopes more user-friendly or easier to operate) can be desirable.

Various embodiments described herein can address this technical problem. One or more embodiments described herein can include systems, computer-implemented methods, apparatus, or computer program products that can facilitate large language model assistance for charged-particle microscope operation. In other words, various embodiments described herein can leverage large language models (LLMs), such as ChatGPT, to serve as accessible, user-friendly interfaces for charged-particle microscopes. Accordingly, when various embodiments described herein are implemented, users can interact with or otherwise operate charged-particle microscopes by typing or speaking intuitive natural language commands, requests, or queries, without knowing beforehand how to expertly traverse seas of complicated configurable microscopy settings, buttons, or options. In other words, various embodiments described herein can be considered as reducing or eliminating the need for users to first receive extensive specialized education in microscopy operation prior to using or operating charged-particle microscopes. In still other words, various embodiments described herein can be considered as significantly reducing a learning curve associated with charged-particle microscopes or as otherwise increasing accessibility or ease of use of charged-particle microscopes.

The present inventors devised various embodiments for achieving such increased accessibility or user-friendliness. As described herein, such increased accessibility or user-friendliness can be achieved by implementation of any of the following: image-or-spectrum-conditioned LLM monitoring of user microscopy commands; image-or-spectrum-conditioned LLM tutorials in response to user microscopy workflow queries; image-or-spectrum-conditioned LLM malfunction diagnoses in response to user microscopy troubleshooting queries; image-or-spectrum-conditioned LLM explanations in response to user microscopy specimen queries; or image-or-spectrum-conditioned LLM GUI generation in response to past user microscopy queries.

First, consider implementation of image-or-spectrum-conditioned LLM monitoring of user microscopy commands. In various embodiments, a user of a charged-particle microscope can issue a command to the charged-particle microscope (e.g., a command to perform some microscopy task, a command to set some microscopy parameter to a desired value). In various aspects, the user can type or speak such command into an appropriate human-computer interface of the charged-particle microscope (e.g., can type into a text field, can speak into a microphone). In various instances, the charged-particle microscope can be loaded with a given specimen, and it can be possible that performance of the command would cause undesired or otherwise unusual harm to the given specimen. In other words, it is possible that the user might, due their own inexperience or lack of expertise, inadvertently operate the charged-particle microscope in such a way so as to harm the given specimen. Various embodiments described herein can help to ameliorate such harm. In particular, various embodiments described herein can, in response to receipt of the command but prior to implementation or performance of the command, cause the charged-particle microscope to capture an image (e.g., in the case of SEM or TEM) or an energy spectrum (e.g., in the case of EELM) of the given specimen. In various aspects, such image-capture or spectrum-capture can be facilitated in accordance with any suitable default protocol of the charged-particle microscope. In various instances, both the command and the image or energy spectrum can be fed together as a collective input prompt to an LLM, thereby causing the LLM to produce a natural language response, which can be visibly played (e.g., on a computer screen) or audibly played (e.g., on an electronic speaker) so as to be seen or heard by the user. As described herein, the natural language response can textually describe or explain whether or not performance of the command would cause unreasonable or out-of-the-ordinary harm the given specimen. In other words, the image or energy spectrum captured by the charged-particle microscope can be considered as conveying at least some amount of substantive information regarding the given specimen (e.g., regarding optical or chemical properties of the given specimen), and the LLM can be considered as evaluating, judging, or otherwise double-checking the reasonability or sanity of the user's command based on that substantive information. In some cases, as described herein, that substantive information can be teased out or otherwise enhanced by: identifying documents that are relevant to both the command and the image or energy spectrum; obtaining inferencing task results (e.g., predicted or inferred classification labels) for the image or energy spectrum from ancillary or auxiliary machine learning models; or obtaining virtual experiment results regarding both the command and the image or energy spectrum from a digital twin of the charged-particle microscope. Indeed, such documents, inferencing task results, or virtual experiment results can be fed as supplemental inputs to the LLM, thereby giving the LLM even more information regarding the given specimen. In any case, the natural language response can be considered as a real-time warning or notification to the user of whether or not performance of the command would damage the given specimen. Thus, conditioning the LLM on the image or energy spectrum as described herein can help to reduce or avoid unintended or undesired harm to the given specimen, notwithstanding the user not having undergone significant training, education, or certification with respect to the charged-particle microscope.

Next, consider implementation of image-or-spectrum-conditioned LLM tutorials in response to user microscopy workflow queries. In various embodiments, the user of the charged-particle microscope can desire to perform a particular workflow (e.g., voltage contrast analysis) using the charged-particle microscope. However, the user can, due to their inexperience or lack of expertise with respect to the charged-particle microscope, not know how to properly perform the particular workflow. Accordingly, in various aspects, the user can type or speak a question into any appropriate human-computer interface of the charged-particle microscope, where that question can ask how to perform the particular workflow. As mentioned above, the charged-particle microscope can be loaded with the given specimen. In various cases, it can be possible that the particular workflow is specimen-dependent (e.g., the particular workflow can be made up of different steps or sub-steps depending upon the type of specimen that it will be performed on). So, similar to above, various embodiments described herein can, in response to receipt of the question, cause the charged-particle microscope to capture, via any suitable default microscopy protocol, an image or an energy spectrum of the given specimen. In various aspects, both the question and the image or energy spectrum can be fed together as a collective input prompt to the LLM, thereby causing the LLM to produce a natural language response, which can be visibly or audibly played so as to be seen or heard by the user. In various cases, the natural language response can textually describe or explain a specimen-tailored tutorial for performing the particular workflow. That is, the natural language response can textually describe or explain what steps, sub-steps, or other actions should be performed by the user or the charged-particle microscope in which order, so as to successfully or properly conduct the particular workflow on the given specimen. In other words, the image or energy spectrum captured by the charged-particle microscope can be considered as conveying at least some amount of substantive information regarding the given specimen, and the LLM can be considered as utilizing that substantive information to identify how to best or properly perform the particular workflow. Just as above, that substantive information can, in some instances, be enhanced by relevant documents, inferencing task results, or digital twin simulation results. In any case, the natural language response can be considered as teaching or explaining to the user how to perform the particular workflow on the given specimen. Thus, conditioning the LLM on the image or energy spectrum as described herein can help to ensure that the user is informed in real-time of how to correctly perform the particular workflow, notwithstanding the user not having undergone significant training, education, or certification with respect to the charged-particle microscope.

Now, consider implementation of image-or-spectrum-conditioned LLM malfunction diagnoses in response to user microscopy troubleshooting queries. In various embodiments, the charged-particle microscope can be loaded with the given specimen, and the charged-particle microscope can experience a particular malfunction (e.g., one or more specified symptoms or error codes) when attempting to be operated on the given specimen. The user of the charged-particle microscope can desire to troubleshoot, diagnose, or otherwise resolve the particular malfunction, but the user can, due to their inexperience or lack of expertise, not know how to do so. Accordingly, in various aspects, the user can type or speak a question into any appropriate human-computer interface of the charged-particle microscope, where that question can ask about the particular malfunction (e.g., can ask what is causing the particular malfunction, can ask how to rectify the particular malfunction). In various cases, the user's question can describe or otherwise identify at least one known detail of the given specimen (e.g., a known composition or identity of the given specimen). Various embodiments can leverage such known detail about the given specimen in order to determine how to handle the particular malfunction. Indeed, similar to above, various embodiments described herein can, in response to receipt of the question, cause the charged-particle microscope to capture, via any suitable default microscopy protocol, an image or an energy spectrum of the given specimen. In various aspects, both the question and the image or energy spectrum can be fed together as a collective input prompt to the LLM, thereby causing the LLM to produce a natural language response, which can be visibly or audibly played so as to be seen or heard by the user. In various cases, the natural language response can textually describe or explain a cause of or resolution for the particular malfunction. That is, the natural language response can textually describe or explain what specific settings or constituent components of the charged-particle microscope are causing the particular malfunction, or can textually describe or explain what steps, sub-steps, or other actions should be performed in which order so as to successfully or properly treat the particular malfunction. In other words, the image or energy spectrum captured by the charged-particle microscope can be considered as conveying at least some amount of measured information regarding the given specimen, the question typed or spoken by the user can be considered as conveying at least some known information about the given specimen, and the LLM can be considered as comparing that measured information to that known information so as to identify why or how the charged-particle microscope is suffering the particular malfunction. Similar to above, the measured information of the given specimen can, in some instances, be enhanced by relevant documents, inferencing task results, or digital twin simulation results. In some aspects, the measured data can be further enhanced by obtaining self-diagnostic test results from the charged-particle microscope itself. In any case, the natural language response can be considered as teaching or explaining to the user why the particular malfunction is occurring for the given specimen or otherwise how to prevent the particular malfunction from occurring for the given specimen. Thus, conditioning the LLM on the image or energy spectrum as described herein can help to ensure that the user is informed in real-time how to correctly resolve the particular malfunction, notwithstanding the user not having undergone significant training, education, or certification with respect to the charged-particle microscope.

Next, consider implementation of image-or-spectrum-conditioned LLM explanations in response to user microscopy specimen queries. In various embodiments, the charged-particle microscope can be loaded with the given specimen, and the user of the charged-particle microscope can desire to determine some particular characteristic or property (e.g., chemical composition, crystalline structure, surface roughness) of the given specimen. However, the user can, due to their inexperience or lack of expertise, not know how to properly utilize the charged-particle microscope so as to determine that particular characteristic or property. Accordingly, in various aspects, the user can type or speak a question into any appropriate human-computer interface of the charged-particle microscope, where that question can ask for identification of that particular characteristic or property. So, similar to above, various embodiments described herein can, in response to receipt of the question, cause the charged-particle microscope to capture, via any suitable default microscopy protocol, an image or an energy spectrum of the given specimen. In various aspects, both the question and the image or energy spectrum can be fed together as a collective input prompt to the LLM, thereby causing the LLM to produce a natural language response, which can be visibly or audibly played so as to be seen or heard by the user. In various cases, the natural language response can textually describe, explain, or otherwise identify the particular characteristic or property of the given specimen. In other words, the image or energy spectrum captured by the charged-particle microscope can be considered as conveying at least some amount of substantive information regarding the given specimen, and the LLM can be considered as leveraging that substantive information to identify or quantify the particular characteristic or property for which the user asked. Similar to above, the substantive information of the given specimen can, in some instances, be enhanced by relevant documents, inferencing task results, or digital twin simulation results. In any case, the natural language response can be considered as identifying the particular characteristic or property of the given specimen, as requested by the user. Thus, conditioning the LLM on the image or energy spectrum as described herein can help to inform the user in real-time of the particular characteristic or property, notwithstanding the user not having undergone significant training, education, or certification with respect to the charged-particle microscope.

Finally, consider implementation of image-or-spectrum-conditioned LLM GUI creation in response to past user microscopy queries. In various embodiments, the user can load the given specimen into the charged-particle microscope. Moreover, in various aspects, the user can have previously asked various questions or given various commands regarding the charged-particle microscope (e.g., microscopy setting commands, workflow queries, troubleshooting queries, specimen queries). In various instances, the charged-particle microscope can have a myriad of configurable software settings, buttons, knobs, sliders, or options that govern or otherwise control its operation. In various cases, it can be possible that various ones of such configurable settings are not relevant or applicable to the given specimen. Moreover, in various aspects, it can be possible that some of such configurable settings correspond to basic microscopy functionalities that are suitable for inexperienced operators whereas others of such configurable settings correspond to advanced microscopy functionalities that are suitable only for experienced or highly-trained operators. Accordingly, as mentioned above, various embodiments described herein can cause the charged-particle microscope to capture, via any suitable default microscopy protocol, an image or an energy spectrum of the given specimen. In various aspects, the image or energy spectrum and the past queries or commands can be fed together as a collective input prompt to the LLM, thereby causing the LLM to produce synthesized code, which can be compiled, executed, or otherwise run on the charged-particle microscope or on any suitable computerized workstation associated with the charged-particle microscope. As described herein, the synthesized code can define a GUI for the charged-particle microscope that is tailored to both the given specimen and to the user. More specifically, the image or energy spectrum captured by the charged-particle microscope can be considered as conveying at least some amount of substantive information regarding the given specimen (which can be enhanced with relevant documents, inferencing task results, or digital twin simulation results), and the LLM can be considered as utilizing that substantive information to identify which of the myriad configurable software settings or options of the charged-particle microscope are or are not relevant to the given specimen. Accordingly, the GUI defined by the synthesized code can block out, hide, or otherwise omit specimen-irrelevant settings or options. Furthermore, the user's past queries or commands can be considered as conveying at least some amount of information regarding how experienced or inexperienced the user is with respect to the charged-particle microscope, and the LLM can be considered as utilizing that information to infer which of the myriad configurable software settings or options of the charged-particle microscope are or are not appropriate for (e.g., are to advanced for) the user. Accordingly, the GUI defined by the synthesized code can block out, hide, or otherwise omit user-inappropriate settings or options. Thus, conditioning the LLM on the image or energy spectrum and on the past queries or commands as described herein can help to ensure that the user is presented with a GUI of the charged-particle microscope that is commensurate with or appropriate for both the given specimen (e.g., the GUI can vary across specimens) and an inferred experience level of the user (e.g., the GUI can vary depending upon how much or how little microscopy training the user is inferred to have undergone).

Accordingly, different specimens can require or otherwise be associated with different microscopy settings, protocols, treatments, or preparations, and various embodiments described herein can cause an LLM to account for such different microscopy settings, protocols, treatments, or preparations when synthesizing responses to user questions or commands. This can be accomplished by conditioning the LLM on (e.g., by causing the LLM to receive as inputs) specimen images or specimen energy spectra. Such an image-or-spectrum-conditioned LLM can cause charged-particle microscopes to be more accessible or user-friendly (e.g., to be intuitively usable or operatable, regardless of skill or expertise).

Various embodiments described herein can be considered as a computerized tool (e.g., any suitable combination of computer-executable hardware or computer-executable software) that can facilitate large language model assistance for charged-particle microscope operation. In various aspects, such computerized tool can comprise an access component, a state component, a context component, a model component, or a presenter component.

In various embodiments, there can be a charged-particle microscope. In various aspects, the charged-particle microscope can exhibit any suitable design or construction (e.g., can be an SEM, can be a TEM, can be an EELM, can be a dual-beam microscope). In various instances, the charged-particle microscope can comprise any suitable number of configurable operating settings. In various cases, a configurable operating setting can be any suitable selectively-controllable hardware characteristic or selectively-controllable software characteristic of the charged-particle microscope that can be directly adjusted or changed in response to electronic instructions or commands received from a user of the charged-particle microscope (e.g., can be a user-controlled voltage or current setting of the charged-particle microscope, a user-controlled temperature setting of the charged-particle microscopes, or a user-controlled actuator setting of the charged-particle microscope). In various aspects, there can be any suitable specimen (e.g., semiconductor wafer or lamella) that is currently loaded in the charged-particle microscope (e.g., that is currently located or positioned on an actuatable stage of the charged-particle microscope).

In various embodiments, there can be an LLM. In various aspects, the LLM can exhibit any suitable deep learning internal architecture. For example, the LLM can include any suitable numbers of any suitable types of layers (e.g., input layer, one or more hidden layers, output layer, any of which can be convolutional layers, dense layers, long short-term memory (LSTM) layers, transformer layers, non-linearity layers, pooling layers, batch normalization layers, or padding layers). As another example, the LLM can include any suitable numbers of neurons in various layers (e.g., different layers can have the same or different numbers of neurons as each other). As yet another example, the LLM can include any suitable activation functions (e.g., softmax, sigmoid, hyperbolic tangent, rectified linear unit) in various neurons (e.g., different neurons can have the same or different activation functions as each other). As still another example, the LLM can include any suitable interneuron connections or interlayer connections (e.g., forward connections, skip connections, recurrent connections).

Regardless of its specific internal architecture, the LLM can be configured as a generative text-to-text model. That is, the LLM can be configured to receive as input any suitable textual data (which, in various cases, may or may not be accompanied by any suitable numerical data or any suitable graphical data), and the LLM can be configured to produce as output synthesized textual content (e.g., one or more synthesized sentences or sentence fragments) that is semantically or substantively based on such inputted textual data (and based on accompanying numerical or graphical data, as the case may be).

In order to accomplish this, the LLM can be considered as comprising an encoder portion and a synthesizer portion. In various aspects, the encoder portion can be any suitable upstream layers of the LLM that are configured to receive the inputted textual data (and any accompanying numerical or graphical data) and to produce embeddings based on that inputted textual data. In various instances, the synthesizer portion can be any suitable downstream layers of the LLM that are configured to receive those embeddings and to produce the synthesized textual content based on those embeddings.

In various aspects, an embedding produced by the encoder portion of the LLM in response to a piece of inputted textual, numerical, or graphical data can be considered as any suitable mathematical quantity (e.g., scalar, vector, matrix, tensor, tokenization, or any suitable combination thereof) that numerically represents at least some substantive or semantic aspect of that inputted textual, numerical, or graphical data in a low-dimensional fashion. In other words, the embedding can be smaller in terms of size or dimensionality (e.g., in some cases, one or more orders of magnitude smaller) than such inputted textual, numerical, or graphical data; but despite such smaller size, the embedding can nevertheless be considered as substantively or semantically representing such inputted textual, numerical, or graphical data. In still other words, the embedding can be considered as a latent vector representation of such inputted textual, numerical, or graphical data.

In any case, it can be desired to leverage the LLM so as to increase accessibility or ease of operation of the charged-particle microscope. In various instances, the computerized tool described herein can accomplish this in various ways.

In some embodiments, the computerized tool can increase accessibility or ease of use of the charged-particle microscope by leveraging the LLM to perform automated sanity-checks or reasonableness-checks of commands received by a user of the charged-particle microscope.

Indeed, in various cases, there can be a natural language instruction that is associated with the charged-particle microscope. In various aspects, the natural language instruction can be unstructured or plain text that semantically requests or commands that one or more configurable operating settings of the charged-particle microscope (e.g., beam voltage setting, beam current setting, stage temperature setting) be set, changed, or otherwise adjusted to one or more desired values or states. In various instances, the natural language instruction can be typed or spoken by the user via any suitable GUI text field or microphone of the charged-particle microscope.

In various embodiments, the access component of the computerized tool can electronically access the natural language instruction. For instance, the access component can receive, retrieve, or otherwise obtain the natural language instruction from any suitable centralized or decentralized data structures (e.g., graph data structures, relational data structures, hybrid data structures). Likewise, the access component can electronically access the LLM or the charged-particle microscope. For instance, the access component can electronically interface or communicate with (e.g., send electronic commands to, read electronic signals from) the LLM or the charged-particle microscope. In any case, the access component can be considered as a conduit through which other components of the computerized tool can electronically interact with (e.g., read, write, edit, copy, manipulate, execute, activate, deactivate, modify) the natural language instruction, the LLM, or the charged-particle microscope.

In various embodiments, the state component of the computerized tool can, in response to receipt or accessing of the natural language instruction, electronically cause the charged-particle microscope to scan the specimen that is currently loaded in the charged-particle microscope. In various aspects, such scanning can cause the charged-particle microscope to capture an image (e.g., SEM scanned image, TEM scanned image) depicting or illustrating at least some portion of the specimen, or to capture an energy spectrum (e.g., electron energy-loss spectrum) of or otherwise associated with the specimen. In various instances, the state component can cause the charged-particle microscope to perform such scanning according to any suitable default microscopy protocol that is known or deemed to be non-destructive or non-damaging for wide swaths or proportions of possible microscopy specimens. As a non-limiting example, the default microscopy protocol can involve using a default beam current (e.g., on the order of nano-amps (nA) or pico-amps (pA)) and a default beam voltage (e.g., less than 5 kilo-volts (kV)) that are sufficiently low so as to be known or expected to not damage, deteriorate, or otherwise degrade all, most, or any suitable subgroup of whatever possible specimens that the charged-particle microscope is expected or designed to encounter.

In various embodiments, the model component of the computerized tool can electronically generate a natural language response, by executing the LLM on the natural language instruction, on the image or energy spectrum of the specimen, and on a damage prompt associated with the natural language instruction. More specifically, the damage prompt can be unstructured or plain text that asks or commands that it be determined whether or not performance or implementation of the natural language instruction would harm, damage, or otherwise deteriorate the specimen. In various aspects, the model component can concatenate the natural language instruction, the image or energy spectrum, and the damage prompt together. In various instances, the model component can feed that concatenation to the input layer of the LLM, that concatenation can complete a forward pass through the one or more hidden layers of the LLM, and the output layer of the LLM can calculate the natural language response based on activations provided by the one or more hidden layers of the LLM.

In various cases, the natural language response can be synthesized text that is based on the natural language instruction and on the image or energy spectrum, and that substantively or semantically responds to the damage prompt. In other words, the natural language response can be unstructured or plain text that describes or explains whether or not changing or adjusting one or more configurable operating settings of the charged-particle microscope to the one or more desired values or states, as requested or commanded by the user, would unreasonably or undesirably damage the specimen. In still other words, the image or energy spectrum can be considered as informing the LLM of at least some physical, chemical, or compositional information regarding the specimen, and the LLM can utilize that information to infer or predict whether the specimen will be harmed by the settings changes requested or commanded by the user. In yet other words, the LLM can be considered as leveraging the image or energy spectrum of the currently-loaded specimen so as to monitor or double-check a reasonableness or sanity of the natural language instruction, and the natural language response can be considered as the conclusion or determination of that monitoring or double-checking.

Now, in some cases, an accuracy level, completeness level, or amount of specificity or detail exhibited by the natural language response can be increased or otherwise improved by allowing the LLM to take into account supplemental or contextual information regarding or otherwise derived from the image or energy spectrum. In various embodiments, the context component of the computerized tool can electronically obtain, gather, or otherwise access such supplemental or contextual information.

As a non-limiting example, there can be a set of auxiliary or ancillary machine learning models that can be configured to perform respective inferencing tasks on inputted images or inputted energy spectra. As some non-limiting examples, any of such auxiliary or ancillary machine learning models can have been pre-trained to perform: image classification or energy spectrum classification; image segmentation or energy spectrum segmentation; or image regression or energy spectrum regression. Accordingly, the context component can execute respective ones of the set of auxiliary or ancillary machine learning models on the image or energy spectrum of the currently-loaded specimen, and such executions can yield a plurality inferencing task results (e.g., a plurality of predicted or inferred classification labels, segmentation masks, or regression outputs) that pertain to the specimen. So, in various aspects, the model component can concatenate the plurality of inferencing task results together with the natural language instruction, with the image or energy spectrum, and with the damage prompt, and the model component can generate the natural language response by executing the LLM on that enlarged concatenation. In various instances, the plurality of inferencing task results can be considered as providing to the LLM deeper or richer information regarding the specimen, and such deeper or richer information can enable the LLM to make the natural language response more accurate or more detailed.

As another non-limiting example, there can be a document repository comprising a plurality of documents. In various instances, each of the plurality of documents can be any suitable electronic file (e.g., word-doc file, portable document format (PDF) file, webpage file) that can textually (or, in some cases, graphically or numerically) describe, explain, or otherwise indicate any suitable technical information regarding the physical, chemical, or optical properties of any suitable specimens or regarding design, fabrication, operation, maintenance, or troubleshooting of any suitable charged-particle microscopes (e.g., various documents can be service manuals or technical handbooks (or portions thereof) of some respective charged particle microscopes; various documents can be compositional reports or reference tables of some respective laboratory specimens). In various instances, any of the plurality of documents can be or have been written (e.g., via any suitable word processing software, computer-aided design software, or quantitative analysis software) by technicians or engineers who were tasked with designing, developing, prototyping, revising, manufacturing, or researching any suitable charged-particle microscopes or any suitable specimens that are analyzable by charged-particle microscopes. Note that, in some cases, any document can exhibit or otherwise have any suitable length or size (e.g., can be one or a few pages in length; can be tens of pages in length; can be hundreds of pages in length). In any case, the context component can electronically search through the document repository for one or more documents that are substantively relevant to the natural language instruction and to the image or energy spectrum. In some aspects, the context component can accomplish this via an embedding search. For instance, the encoder portion of the LLM can be leveraged to generate a particular embedding for the natural language instruction and the image or energy spectrum; the encoder portion can be leveraged to generate a respective embedding for each document in the document repository; and whichever documents whose embeddings are closest or most similar to the particular embedding can be considered as being relevant to the natural language instruction and to the image or energy spectrum. So, in various aspects, the model component can concatenate those relevant documents together with the natural language instruction, with the image or energy spectrum, and with the damage prompt, and the model component can generate the natural language response by executing the LLM on that enlarged concatenation. In various cases, the relevant documents can be considered as providing to the LLM deeper or richer information regarding how the specimen is known or expected to interact with the charged-particle microscope, and such deeper or richer information can enable the LLM to make the natural language response more accurate or more detailed.

As yet another non-limiting example, the charged-particle microscope can be electronically synchronized with a digital twin. In various aspects, the digital twin can be any suitable combination of any suitable mathematical models or physics-based models that can numerically, computationally, or analytically predict, forecast, or otherwise simulate how the charged-particle microscope, or any suitable portion thereof, will respond to any given usage scenario. More specifically, the digital twin can comprise a parametric state, a set of input variables, and a set of output variables. In various aspects, the set of input variables can be collectively considered as the operand of the digital twin, the parametric state can be collectively considered as defining the operators of the digital twin, and the set of output variables can be computed or calculated by mathematically applying (e.g., via any suitable mathematical functions or compositions thereof) the parametric state to the set of input variables. Accordingly, the set of input variables can be assigned whatever numerical values define or describe any given usage scenario, and how the charged-particle microscope would behave or respond to that given usage scenario (e.g., the output variables) can be simulated, predicted, or forecasted by applying the parametric state to the set of input variables. In various cases, any suitable synchronization technique can be implemented to cause or otherwise ensure that the parametric state of the digital twin closely matches (e.g., is within any suitable threshold margin of) the true physical state of the charged-particle microscope. In various aspects, the LLM can generate one or more function calls for the digital twin based on the natural language instruction and on the image or energy spectrum. In various instances, execution of such one or more function calls can cause the digital twin to run or perform one or more virtual experiments regarding the charged-particle microscope and the specimen. In various cases, those one or more virtual experiments can yield respective simulation results (e.g., respective simulated or forecasted values for the output variables of the digital twin). So, in various aspects, the model component can concatenate those simulation results together with the natural language instruction, with the image or energy spectrum, and with the damage prompt, and the model component can generate the natural language response by executing the LLM on that enlarged concatenation. In various cases, those simulation results can be considered as providing to the LLM deeper or richer information regarding how the specimen is forecasted or expected to interact with the charged-particle microscope, and such deeper or richer information can enable the LLM to make the natural language response more accurate or more detailed.

In any case, the LLM can generate the natural language response, which can textually describe or explain whether or not the natural language instruction provided by the user will or is likely to undesirably or unintentionally damage or harm the currently-loaded specimen.

In various embodiments, the presenter component of the computerized tool can electronically present the natural language response to the user in any suitable fashion. As a non-limiting example, the presenter component can visually render the natural language response on any suitable computer screen or computer monitor that is associated with the charged-particle microscope, such that the user can view or read the natural language response. As another non-limiting example, the presenter component can aurally play (e.g., via any suitable text-to-speech transformation techniques) the natural language response on any suitable speaker that is associated with the charged-particle microscope, such that the user can hear or listen to the natural language response. In this way, the computerized tool can be considered as warning or notifying the user whether or not their requested or commanded settings change or adjustment would undesirably damage or harm the specimen.

In some aspects, if the LLM determines or concludes that performance or implementation of the natural language instruction would harm or damage the currently-loaded specimen, the natural language response can further include one or more recommended values or states that can or should be used instead of those specified in the natural language instruction. In such cases, the presenter component can electronically ignore the natural language instruction (e.g., can refrain from changing or adjusting the one or more configurable operating settings to the one or more desired values or states, in contravention of the natural language instruction). In such situations, the presenter component can instead electronically cause the charged-particle microscope to change or adjust the one or more configurable operating settings to the one or more recommended values or states.

In this way, the computerized tool can be considered as increasing accessibility or ease of use of the charged-particle microscope by leveraging the LLM to automatically prevent the user from unwittingly or mistakenly harming or damaging the currently-loaded specimen. Thus, even users who are inexperienced or unfamiliar with the charged-particle microscope can nevertheless use or operate it without (or with significantly reduced) fear or risk of unintentional specimen damage.

Now, in some other embodiments, the computerized tool can increase accessibility or ease of use of the charged-particle microscope by leveraging the LLM to provide specimen-tailored answers to workflow questions asked by the user of the charged-particle microscope.

Indeed, in various cases, there can be a natural language workflow query that is associated with the charged-particle microscope. In various aspects, the natural language workflow query can be unstructured or plain text that semantically requests or commands an explanation for how to correctly or properly perform some particular workflow on the charged-particle microscope (e.g., what steps are involved in a voltage contrast workflow; what steps are involved in a bend workflow). As above, the natural language workflow query can be typed or spoken by the user.

In various embodiments, the state component of the computerized tool can, in response to receipt or accessing of the natural language workflow query, electronically cause the charged-particle microscope to scan the currently-loaded specimen via any suitable default microscopy protocol. In various aspects, such scanning can cause the charged-particle microscope to capture an image or energy spectrum of the specimen.

In various embodiments, the model component of the computerized tool can electronically generate a natural language response, by executing the LLM on the natural language workflow query and on the image or energy spectrum (e.g., executing the LLM on a concatenation of the natural language workflow query with the image or energy spectrum).

In various cases, the natural language response can be synthesized text that is based on the image or energy spectrum, and that substantively or semantically responds to the natural language workflow query. In other words, the natural language response can be unstructured plain text that describes or explains what specific sequence of steps, sub-steps, or actions should (as inferred or predicted by the LLM) be implemented by the user in order to perform the particular workflow. Now, some microscopy workflows can be specimen-dependent. That is, a given microscopy workflow can involve a first sequence of steps or actions if the given microscopy workflow is to be performed with respect to a first type of specimen (e.g., a metal specimen), and the given microscopy workflow can instead involve a second sequence of steps or actions if the given microscopy workflow is to be performed with respect to a second type of specimen (e.g., a plastic specimen). For example, metal specimens can require different pre-scan cleaning or sanitation steps than plastic specimens. As another example, plastic specimens can require a sputter-coating step, whereas a sputter-coating step can be omitted for metal specimens. Accordingly, the image or energy spectrum can be considered as informing the LLM of at least some physical, chemical, or compositional information regarding the currently-loaded specimen, and the LLM can utilize that information to infer or predict what sequence of specific steps or actions are needed to correctly or properly perform the particular workflow on the charged-particle microscope for or with respect to the currently-loaded specimen. Furthermore, in some cases, it might be possible that the particular workflow is not at all suitable or appropriate for the specimen (e.g., the particular workflow can be reserved for organic specimens, but the LLM can infer that the currently-loaded specimen is inorganic). In such situations, the natural language response can describe or explain that the particular workflow is not applicable to the currently-loaded specimen. In any case, the LLM can be considered as leveraging the image or energy spectrum so as to provide specimen-tailored workflow guidance to the user.

As above, an accuracy level, completeness level, or amount of specificity or detail exhibited by the natural language response can be increased or otherwise improved by allowing the LLM to take into account supplemental or contextual information regarding or otherwise derived from the image or energy spectrum. Such supplemental or contextual information (e.g., relevant documents; auxiliary or ancillary inferencing task results; digital twin simulation results) can be electronically obtained, gathered, or otherwise accessed by the context component. Accordingly, any of such supplemental or contextual information can be fed as additional inputs to the LLM. As explained above, this can be considered as providing the LLM with deeper or richer information regarding how the charged-particle microscope and the currently-loaded specimen are known, expected, or forecasted to interact or relate to each other, and such deeper or richer information can enable the LLM to make the natural language response more accurate or more detailed.

In any case, the LLM can generate the natural language response, which can textually describe, explain, or teach how to perform the particular workflow on the charged-particle microscope in a way that is appropriate or suitable for the currently-loaded specimen.

In various embodiments, as above, the presenter component of the computerized tool can electronically present (e.g., visibly or audibly) the natural language response to the user.

In this way, the computerized tool can be considered as increasing accessibility or ease of use of the charged-particle microscope by using the LLM to automatically teach or show the user how to correctly perform a requested workflow for the currently-loaded specimen. Thus, even users who are inexperienced or unfamiliar with the charged-particle microscope or with the requested workflow can nevertheless competently use or operate the charged-particle microscope.

Next, in yet other embodiments, the computerized tool can increase accessibility or ease of use of the charged-particle microscope by leveraging the LLM to provide specimen-conditioned diagnoses or troubleshooting explanations in response to malfunction questions asked by the user.

Indeed, in various cases, there can be a natural language malfunction query that is associated with the charged-particle microscope. In various aspects, the natural language malfunction query can be unstructured or plain text that semantically requests or commands an explanation for why the charged-particle microscope is suffering from one or more particular malfunction symptoms (e.g., why is the charged-particle microscope throwing specified error codes; why is the charged-particle microscope sounding an alarm or buzzer; why is the charged-particle microscope making a grinding noise). In some instances, the natural language malfunction query can include at least some description of the currently-loaded specimen (e.g., these malfunctions occur when attempting to analyze a steel sample; these malfunctions occur when attempting to analyze a printed circuit board sample). As above, the natural language malfunction query can be typed or spoken by the user.

In various embodiments, the state component of the computerized tool can, in response to receipt or accessing of the natural language malfunction query, electronically cause the charged-particle microscope to scan the currently-loaded specimen via any suitable default microscopy protocol. In various aspects, such scanning can cause the charged-particle microscope to capture an image or energy spectrum of the specimen.

In various embodiments, the model component of the computerized tool can electronically generate a natural language response, by executing the LLM on the natural language malfunction query and on the image or energy spectrum (e.g., executing the LLM on a concatenation of the natural language malfunction query with the image or energy spectrum).

In various cases, the natural language response can be synthesized text that is based on the image or energy spectrum, and that substantively or semantically responds to the natural language malfunction query. In other words, the natural language response can be unstructured or plain text that describes or explains what (as inferred or predicted by the LLM) is causing the charged-particle microscope to suffer, exhibit, or be afflicted with the one or more particular malfunctions noted by the user. In some cases, the natural language response can include unstructured or plain text that describes or explains how (as inferred or predicted by the LLM) to solve or rectify the one or more particular malfunction symptoms.

Now, as mentioned above, the natural language malfunction query can include at least some known information regarding the currently-loaded specimen (e.g., can identify or describe, however briefly, at least one physical, chemical, or compositional property of the specimen). Moreover, the image or energy spectrum can be considered as informing the LLM of at least some measured, detected, or estimated information (e.g., measured, detected, or estimated physical, chemical, or compositional property) regarding the currently-loaded specimen. In various aspects, the LLM can be considered as utilizing any discrepancy, inconsistency, or interrelationship between such known specimen information and such measured, detected, or estimated specimen information, so as to infer or predict why the charged-particle microscope is suffering from or exhibiting the one or more particular malfunction symptoms. For example, if the natural language malfunction query specifies that the currently-loaded specimen is a silicon wafer sample, then the LLM can expect the image or energy spectrum to look or appear a certain way (e.g., to have or lack certain visual patterns or artifacts). How much or what ways the image or energy spectrum diverges from such expectation can be considered as at least partially indicating or suggesting to the LLM what is wrong with the charged-particle microscope. Accordingly, the LLM can be considered as leveraging the image or energy spectrum so as to make a more informed malfunction diagnosis for the charged-particle microscope, and the natural language response can be considered as that diagnosis.

As above, an accuracy level, completeness level, or amount of specificity or detail exhibited by the natural language response can be increased or otherwise improved by allowing the LLM to take into account supplemental or contextual information regarding or otherwise derived from the image or energy spectrum of the currently-loaded specimen. In various embodiments, such supplemental or contextual information (e.g., relevant documents; auxiliary or ancillary inferencing task results; digital twin simulation results) can be electronically obtained, gathered, or otherwise accessed by the context component. In some cases, such supplemental or contextual information can include the results of automated self-diagnostic tests or checks that the charged-particle microscope can perform on itself (e.g., can perform in response to function calls produced by the LLM). As explained above, such supplemental or contextual information can be considered as providing the LLM with deeper or richer information regarding how the charged-particle microscope and the currently-loaded specimen are known, expected, or forecasted to interact or relate to each other, and such deeper or richer information can enable the LLM to make the natural language response more accurate or more detailed.

In any case, the LLM can generate the natural language response, which can textually describe or explain why the charged-particle microscope is experiencing the one or more particular malfunction symptoms about which the user has asked.

In various embodiments, as above, the presenter component of the computerized tool can electronically present (e.g., visibly or audibly) the natural language response to the user in any suitable fashion.

In this way, the computerized tool can be considered as increasing accessibility or ease of use of the charged-particle microscope by using the LLM to automatically teach or show the user in real-time why the charged-particle microscope is suffering from a noted malfunction, or to automatically teach or show in real-time the user how to remedy such malfunction. Thus, even users who are inexperienced or unfamiliar with the charged-particle microscope can nevertheless competently address or handle malfunctions of the charged-particle microscope.

Now, in still other embodiments, the computerized tool can increase accessibility or ease of use of the charged-particle microscope by leveraging the LLM to automatically answer questions asked by the user regarding the currently-loaded specimen.

Indeed, in various cases, there can be a natural language specimen query that is associated with the charged-particle microscope. In various aspects, the natural language specimen query can be unstructured or plain text that semantically requests or commands identification of any suitable information regarding the currently-loaded specimen (e.g., what is the physical or chemical composition of the specimen; what microscopy protocol would be best for the specimen). As above, the natural language specimen query can be typed or spoken by the user.

In various embodiments, the state component of the computerized tool can, in response to receipt or accessing of the natural language specimen query, electronically cause the charged-particle microscope to scan the currently-loaded specimen via any suitable default microscopy protocol. In various aspects, such scanning can cause the charged-particle microscope to capture an image or energy spectrum of the specimen.

In various embodiments, the model component of the computerized tool can electronically generate a natural language response, by executing the LLM on the natural language specimen query and on the image or energy spectrum (e.g., executing the LLM on a concatenation of the natural language specimen query with the image or energy spectrum).

In various cases, the natural language response can be synthesized text that is based on the image or energy spectrum, and that substantively or semantically responds to the natural language specimen query. For example, if the natural language specimen query asks for identification of a particular physical or chemical attribute of the currently-loaded specimen, then the natural language response can textually describe, explain, or identify that particular physical or chemical attribute (as inferred or predicted by the LLM). As another example, if the natural language specimen query asks for identification of the best, optimal, or most preferred microscopy protocol to be used with the respect to the currently-loaded specimen, then the natural language response can textually describe, explain, or identify that best, optimal, or most preferred microscopy protocol (as inferred or predicted by the LLM). Accordingly, the image or energy spectrum can be considered as informing the LLM of at least some physical, chemical, or compositional information regarding the currently-loaded specimen, and the LLM can utilize that information to synthesize a cogent answer to the natural language specimen query. That is, the LLM can be considered as leveraging the image or energy spectrum so as to answer specimen-related questions asked by the user.

As above, an accuracy level, completeness level, or amount of specificity or detail exhibited by the natural language response can be increased or otherwise improved by allowing the LLM to take into account supplemental or contextual information regarding or otherwise derived from the image or energy spectrum of the currently-loaded specimen. Such supplemental or contextual information (e.g., relevant documents; auxiliary or ancillary inferencing task results; digital twin simulation results) can be electronically obtained, gathered, or otherwise accessed by the context component. As explained above, this can be considered as providing the LLM with deeper or richer information regarding the currently-loaded specimen, and such deeper or richer information can enable the LLM to make the natural language response more accurate or more detailed.

In any case, the LLM can generate the natural language response, which can textually answer whatever the user has asked about the currently-loaded specimen.

In various embodiments, as above, the presenter component of the computerized tool can electronically present (e.g., visibly or audibly) the natural language response to the user in any suitable fashion.

In this way, the computerized tool can be considered as increasing accessibility or ease of use of the charged-particle microscope by using the LLM to automatically answer in real-time specimen-related questions asked by the user. Thus, even users who are inexperienced or unfamiliar with the charged-particle microscope can nevertheless competently have their specimens analyzed.

Next, in yet other embodiments, the computerized tool can increase accessibility or ease of use of the charged-particle microscope by leveraging the LLM to provide specimen-tailored GUIs based on past queries provided by the user.

Indeed, in various cases, there can be a plurality of past natural language queries or commands that the user has previously asked. In various aspects, any of such past natural language queries can be unstructured or plain text requests or commands as described above (e.g., can instruct a change or adjustment to the configurable operating settings of the charged-particle microscope; can ask about a workflow of the charged-particle microscope; can ask about a malfunction of the charged-particle microscope; can ask about the currently-loaded specimen).

In various embodiments, the state component of the computerized tool can electronically command or otherwise cause the charged-particle microscope to scan the currently-loaded specimen via any suitable default microscopy protocol. In various aspects, such scanning can cause the charged-particle microscope to capture an image or energy spectrum of the currently-loaded specimen.

In various embodiments, the model component of the computerized tool can electronically generate synthesized code, by executing the LLM on the past natural language queries, on the image or energy spectrum of the currently-loaded specimen, and on a GUI prompt, where the GUI prompt can be unstructured or plain text that requests or commands that a user-customized and specimen-customized GUI be constructed for the charged-particle microscope.

In various cases, the synthesized code can be one or more lines of computer code written in any suitable computer syntax or coding language, which defines or otherwise serves as the programming script for a customized or tailored GUI of the charged-particle microscope. In particular, the charged-particle microscope can, as mentioned above, have a myriad of configurable software settings, buttons, knobs, sliders, or options. In some instances, different software settings can be relevant or irrelevant to different types of specimens (e.g., the protocols or options that are suitable for organic specimens might not be suitable for inorganic specimens). Likewise, in some instances, some software settings of the charged-particle microscope can be appropriate for inexperienced users (e.g., basic or simple settings can be suitable for technicians who are unfamiliar with the charged-particle microscope), whereas other software settings can be appropriate only for highly experienced users (e.g., advanced or critical settings can be suitable only for technicians who are thoroughly familiar with the charged-particle microscope).

In various cases, the image or energy spectrum can be considered as informing the LLM of at least some physical, chemical, or compositional information regarding the currently-loaded specimen, and the LLM can utilize that information to infer or predict which software settings are relevant to the currently-loaded specimen and which others are irrelevant to the currently-loaded specimen. Furthermore, in some cases, the past natural language queries can be considered as indirectly informing the LLM of a microscopy experience or training level of the user, and the LLM can utilize that information to infer or predict which software settings are appropriate for the user and which others are inappropriate for the user.

Accordingly, the synthesized code created by the LLM can define a GUI that contains or includes only those software settings that are both relevant to the currently-loaded specimen and appropriate for the inferred skill level of the user. In other words, the synthesized code created by the LLM can define a GUI that omits or excludes whatever software settings that are either irrelevant to the currently-loaded specimen or inappropriate for the inferred skill level of the user or technician. In any case, the LLM can be considered as leveraging the image or energy spectrum of the currently-loaded specimen and the past natural language queries asked by the user so as to provide a tailored or customized GUI for the charged-particle microscope.

As above, an accuracy level, completeness level, or amount of specificity or detail exhibited by the synthesized code can be increased or otherwise improved by allowing the LLM to take into account supplemental or contextual information regarding or otherwise derived from the image or energy spectrum. Such supplemental or contextual information (e.g., relevant documents; auxiliary or ancillary inferencing task results; digital twin simulation results) can be electronically obtained, gathered, or otherwise accessed by the context component. As explained above, this can be considered as providing the LLM with deeper or richer information regarding the currently-loaded specimen and the user, and such deeper or richer information can enable the LLM to make the synthesized code, and thus the customized GUI, more appropriate or suitable.

In any case, the LLM can generate the synthesized code, which can define or otherwise serve as the source code for a specimen-customized and user-customized GUI of the charged-particle microscope.

In various embodiments, the presenter component of the computerized tool can electronically compile, run, or otherwise execute the synthesized code, thereby visually presenting the specimen-customized and user-customized GUI of the charged-particle microscope on any suitable computer screen or monitor to the user.

In this way, the computerized tool can be considered as increasing accessibility or ease of use of the charged-particle microscope by using the LLM to automatically generate GUIs that are based on both current specimens of the charged-particle microscope and the inferred skill of the user who is attempting to use the charged-particle microscope. Thus, users can intuitively or comfortably operate or interact with the charged-particle microscope, regardless of their individual levels of microscopy experience.

Various embodiments described herein can be employed to use hardware or software to solve problems that are highly technical in nature (e.g., to facilitate large language model assistance for charged-particle microscope operation), that are not abstract and that cannot be performed as a set of mental acts by a human. Further, some of the processes performed can be performed by a specialized computer (e.g., electron microscopes such as SEMs, TEMs, or EELMs; artificial neural networks such as LLMs; digital twins) for carrying out defined acts related to the field of charged-particle microscopy.

For example, such defined acts can include: accessing, by a device operatively coupled to a processor, a natural language instruction provided by a user of a charged-particle microscope, wherein the natural language instruction can request or command that a configurable operating setting of the charged-particle microscope be changed to a target value; causing, by the device and in response to receipt of the natural language instruction, the charged-particle microscope to capture, according to a default microscopy protocol, an image or an energy spectrum of a specimen that is currently loaded on a stage of the charged-particle microscope; and executing, by the device, a large language model on both the natural language instruction and the image or energy spectrum of the specimen, thereby yielding a natural language response that can indicate whether changing the configurable operating setting to the target value would negatively affect the specimen.

As another example, such defined acts can include: accessing, by a device operatively coupled to a processor, a natural language query provided by a user of a charged-particle microscope, wherein the natural language query can request or command identification of how to perform a microscopy workflow on the charged-particle microscope; causing, by the device and in response to receipt of the natural language query, the charged-particle microscope to capture, according to a default microscopy protocol, an image or an energy spectrum of a specimen that is currently loaded on a stage of the charged-particle microscope; and executing, by the device, a large language model on both the natural language query and the image or energy spectrum of the specimen, thereby yielding a natural language response that can describe a tutorial for the microscopy workflow that is tailored to the specimen.

As yet another example, such defined acts can include: accessing, by a device operatively coupled to a processor, a natural language query provided by a user of a charged-particle microscope, wherein the natural language query can request or command identification of why the charged-particle microscope is experiencing a malfunction with respect to a specimen that is currently loaded on a stage of the charged-particle microscope; causing, by the device and in response to receipt of the natural language query, the charged-particle microscope to capture, according to a default microscopy protocol, an image or an energy spectrum of the specimen; and executing, by the device, a large language model on both the natural language query and the image or energy spectrum of the specimen, thereby yielding a natural language response that can explain a cause of the malfunction.

As still another example, such defined acts can include: accessing, by a device operatively coupled to a processor, a natural language query provided by a user of a charged-particle microscope, wherein the natural language query can request or command identification of an attribute of a specimen that is currently loaded on a stage of the charged-particle microscope; causing, by the device and in response to receipt of the natural language query, the charged-particle microscope to capture, according to a default microscopy protocol, an image or an energy spectrum of the specimen; and executing, by the device, a large language model on both the natural language query and the image or energy spectrum of the specimen, thereby yielding a natural language response that can describe or indicate the attribute of the specimen.

As even another example, such defined acts can include: accessing, by a device operatively coupled to a processor, a plurality of past natural language microscopy queries provided by a user of a charged-particle microscope; causing, by the device, the charged-particle microscope to capture, according to a default microscopy protocol, an image or an energy spectrum of a specimen that is currently loaded on a stage of the charged-particle microscope; executing, by the device, a large language model on both the plurality of past natural language microscopy queries and the image or energy spectrum of the specimen, thereby yielding synthesized code that defines a graphical user-interface for the charged-particle microscope that is tailored both to the specimen and to an inferred microscopy skill level of the user; and running, by the device, the synthesized code, thereby rendering or activating the graphical user-interface.

In various cases, any of such defined acts can involve: synthesizing, via execution of the LLM, function calls for a digital twin that is synchronized with the charged-particle microscope, based on the image or energy spectrum of the specimen; causing the digital twin to perform virtual experiments or simulations according to those synthesized function calls, thereby yielding experimentation or simulation results that pertain to the specimen; and feeding such experimentation or simulation results as supplemental inputs to the LLM to aid generation of any suitable natural language response or synthesized code.

Such defined acts are inherently computerized. Indeed, a charged-particle microscope (e.g., SEM, TEM, EELM, dual beam microscope) is a highly-technical computerized device comprising specific computerized hardware (e.g., temperature sensors, pressure sensors, voltage sensors, ion beam emitters, electron beam emitters, focusing lenses, ion detectors, electron detectors, beam apertures, fluid valves, actuatable specimen stages). A charged-particle microscope and the operations that it performs cannot be implemented by the human mind, or by a human with pen and paper, in any reasonable or practicable way without computers. Furthermore, artificial neural networks (e.g., LLMs) are also inherently computerized constructs comprising specific software-oriented architectures (e.g., input layers, hidden layers, or output layers, any of which can be made up of trainable or non-trainable internal parameters such as convolutional layers or LSTM layers). Artificial neural networks cannot be trained or executed by the human mind, or by humans with mere pen and paper, in any reasonable or practicable way without computers. Further still, a digital twin (as the word "digital" in its name suggests) is also an inherently computerized or virtual construct that is used to electronically forecast or simulate future behavior of charged-particle microscopes. A digital twin simply cannot be facilitated or executed by the human mind, or by a human with pen and paper, in any reasonable or practicable way without computers.

Moreover, various embodiments described herein can integrate into a practical application various teachings relating to the field of charged-particle microscopy. As explained above, charged-particle microscopes are highly complex, complicated devices that often require extensive specialized training, education, or certification to learn how to operate. Indeed, they can have multitudes of configurable or selectable settings, buttons, knobs, sliders, or options, which can be overwhelming for inexperienced users. In other words, charged-particle microscopes can be considered as user-unfriendly, inaccessible, or otherwise difficult to operate.

Various embodiments described herein can help to ameliorate this problem, by implementing large language model assistance for charged-particle microscope operation. That is, various embodiments described herein can leverage LLMs so as to increase user-friendliness, accessibility, or ease of operation of charged-particle microscopes. As described herein, various embodiments can accomplish such increase via any of the following: image-or-spectrum-conditioned LLM monitoring of user microscopy commands; image-or-spectrum-conditioned LLM tutorials in response to user microscopy workflow queries; image-or-spectrum-conditioned LLM malfunction diagnoses in response to user microscopy troubleshooting queries; image-or-spectrum-conditioned LLM explanations in response to user microscopy specimen queries; image-or-spectrum-conditioned LLM GUI creation in response to past user microscopy queries.

Indeed, when given a microscopy command (e.g., a plain text instruction to adjust or change configurable microscopy settings) from a user of the charged-particle microscope, various embodiments can involve: causing the charged-particle microscope to automatically capture an image or energy spectrum of a currently-loaded specimen of the charged-particle microscope; and feeding both the microscopy command and the image or energy spectrum as inputs to an LLM, thereby causing the LLM to produce a plain text response that explains whether or not implementation of the microscopy command would unusually or undesirably harm the currently-loaded specimen. That is, the LLM can be considered as utilizing whatever physical, chemical, or compositional information about the currently-loaded specimen that is conveyed by the image or energy spectrum to infer whether the currently-loaded specimen is likely to be degraded by the microscopy command. Note that such physical, chemical, or compositional information about the currently-loaded specimen can be optionally enhanced, supplemented, or accompanied by relevant documents found via embedding searching, by inferencing task results predicted by ancillary machine learning models, or by simulation results produced by a digital twin. In any case, various embodiments described herein can be considered as continually or continuously providing real-time, background monitoring of the user's commands, so as to warn or notify the user when or if their commands are not appropriate for the currently-loaded specimen. This can be considered as increasing accessibility or user-friendliness of the charged-particle microscope, so that even inexperienced users can operate the charged-particle microscope without fear of unintentionally or unwittingly damaging specimens. Equivalently, this can be considered as protecting or safeguarding specimens from the inexperience of poorly trained users.

Moreover, when given a microscopy workflow question (e.g., a plain text question asking how to perform a specific microscopy workflow) from a user of the charged-particle microscope, various embodiments can involve: causing the charged-particle microscope to automatically capture an image or energy spectrum of a currently-loaded specimen of the charged-particle microscope; and feeding both the microscopy workflow question and the image or energy spectrum as inputs to an LLM, thereby causing the LLM to produce a plain text response that explains or teaches what specific sequence of steps the user should perform in order to properly or acceptably apply the specific microscopy workflow to the currently-loaded specimen. That is, the LLM can be considered as utilizing whatever physical, chemical, or compositional information about the currently-loaded specimen that is conveyed by the image or energy spectrum to infer what microscopy workflow steps should be performed in what order on the currently-loaded specimen. Again, note that such physical, chemical, or compositional information about the currently-loaded specimen can be optionally enhanced, supplemented, or accompanied by relevant documents, ancillary inferencing task results, or digital twin simulation results. In any case, various embodiments described herein can be considered as providing to the user real-time, specimen-tailored tutelage or guidance for performing microscopy workflows. This can be considered as increasing accessibility or user-friendliness of the charged-particle microscope, so that even inexperienced or untrained users can competently perform workflows on the charged-particle microscope.

Furthermore, when given a microscopy malfunction question (e.g., a plain text question asking why a specific microscopy malfunction is occurring) from a user of the charged-particle microscope, various embodiments can involve: causing the charged-particle microscope to automatically capture an image or energy spectrum of a currently-loaded specimen of the charged-particle microscope; and feeding both the microscopy malfunction question and the image or energy spectrum as inputs to an LLM, thereby causing the LLM to produce a plain text response that explains or describes a likely reason, cause, or resolution for the specific microscopy malfunction. In particular, the microscopy malfunction question can identify any suitable known attribute of the currently-loaded specimen, the image or energy spectrum can be considered as conveying at least some measured or detected attributes of the currently-loaded specimen, and the LLM can be considered as comparing such known and measured/detected attributes to infer why the charged-particle microscope is not operating as it should be or otherwise how the charged-particle microscope can be repaired or rectified. Again, such measured/detected information of the currently-loaded specimen can be optionally enhanced, supplemented, or accompanied by relevant documents, ancillary inferencing task results, or digital twin simulation results. In any case, various embodiments described herein can be considered as providing to the user real-time troubleshooting advice for the charged-particle microscope. This can be considered as increasing accessibility or user-friendliness of the charged-particle microscope, so that even inexperienced or untrained users can competently deal with malfunctions of the charged-particle microscope.

Further still, when given a microscopy specimen question (e.g., a plain text question asking for identification of some attribute of a currently-loaded specimen) from a user of the charged-particle microscope, various embodiments can involve: causing the charged-particle microscope to automatically capture an image or energy spectrum of the currently-loaded specimen; and feeding both the microscopy specimen question and the image or energy spectrum as inputs to an LLM, thereby causing the LLM to produce a plain text response that identifies or describes the requested attribute of the currently-loaded specimen. That is, the LLM can be considered as utilizing whatever physical, chemical, or compositional information about the currently-loaded specimen that is conveyed by the image or energy spectrum to infer the requested attribute. Again, such physical, chemical, or compositional information about the currently-loaded specimen can be optionally enhanced, supplemented, or accompanied by relevant documents, ancillary inferencing task results, or digital twin simulation results. In any case, various embodiments described herein can be considered as providing to the user real-time specimen characterization or analysis in response to intuitive natural language questions of the user. This can be considered as increasing accessibility or user-friendliness of the charged-particle microscope, so that even inexperienced or untrained users can competently analyze their desired specimens with the charged-particle microscope.

In some cases, when given a history of microscopy questions from a user of the charged-particle microscope, various embodiments can involve: causing the charged-particle microscope to automatically capture an image or energy spectrum of a currently-loaded specimen of the charged-particle microscope; and feeding both the history of microscopy questions and the image or energy spectrum as inputs to an LLM, thereby causing the LLM to produce synthesized code that defines a GUI for the charged-particle microscope that: presents configurable microscopy settings that are both relevant to the currently-loaded specimen and suitable for an inferred experience level of the user; and hides configurable microscopy settings that are either irrelevant to the currently-loaded specimen or unsuitable for the inferred experience level of the user. That is, the LLM can be considered as utilizing whatever physical, chemical, or compositional information about the currently-loaded specimen that is conveyed by the image or energy spectrum to infer which configurable settings of the charged-particle microscope are applicable or inapplicable to the currently-loaded specimen. Likewise, the LLM can be considered as utilizing the history of microscopy questions to infer how much or how little training or skill the user has with respect to the charged-particle microscope and to thereby identify which configurable settings of the charged-particle microscope are handleable (e.g., not too advanced) or not handleable (e.g., too advanced) by the user. In any case, the LLM can utilize such inferred information to construct or define a GUI of the charged-particle microscope that is customized to both the currently-loaded specimen and the user. This can be considered as increasing accessibility or user-friendliness of the charged-particle microscope, so that any or all users of the charged-particle microscope can be automatically presented with GUIs that are commensurate with their experiences and with their desired specimens.

For at least the above reasons, various embodiments described herein can be considered as addressing or ameliorating various problems or disadvantages regarding accessibility of charged-particle microscopes. Therefore, various embodiments described herein can be considered as a concrete and tangible technical improvement in the field of charged-particle microscopy. Accordingly, various embodiments described herein certainly qualify as useful and practical applications of computers.

Furthermore, various embodiments described herein can control real-world tangible devices based on the disclosed teachings. For example, various embodiments described herein can electronically activate, deactivate, or otherwise actuate real-world hardware (e.g., ion beam emitters, ion focusing lenses, carrier fluid valves/pumps) of real-world charged-particle microscopes (e.g., SEMs, TEMs, EELMs, dual-beam microscopes).

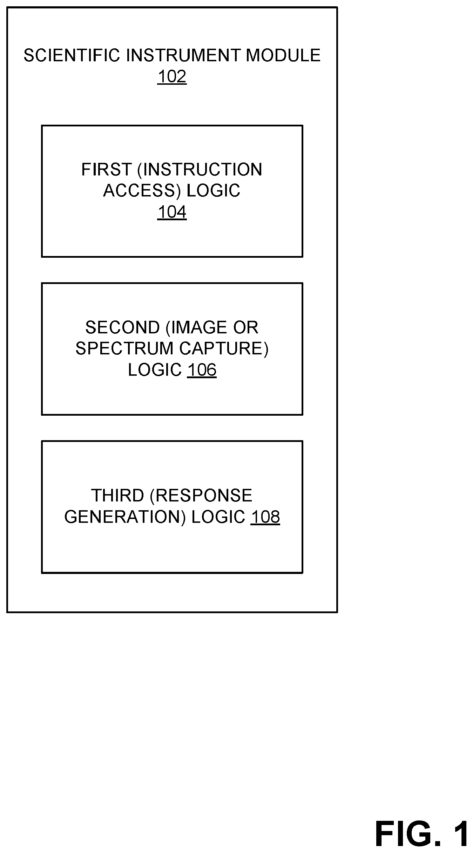

FIG. 1 illustrates an example, non-limiting block diagram of a scientific instrument module 102 in accordance with various embodiments described herein.

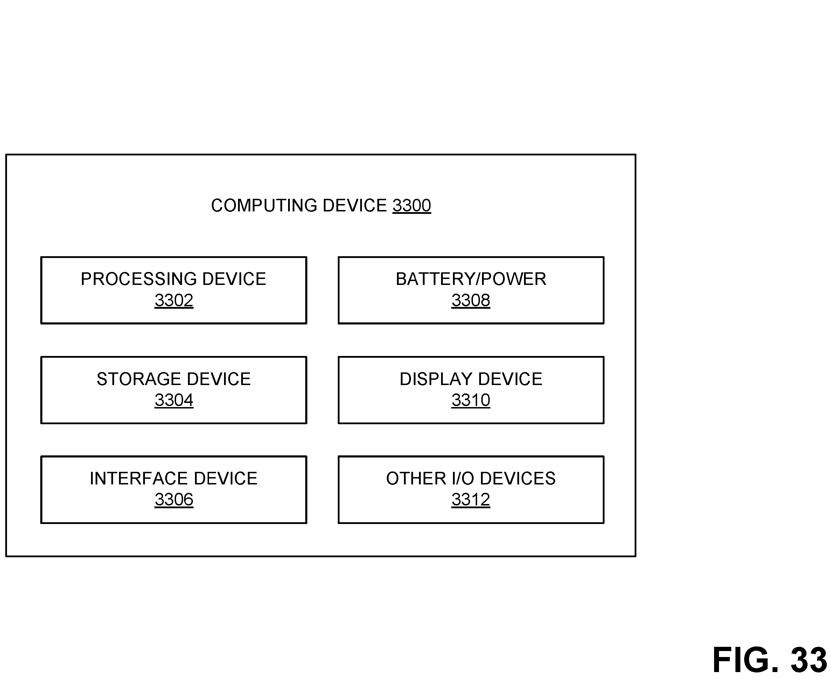

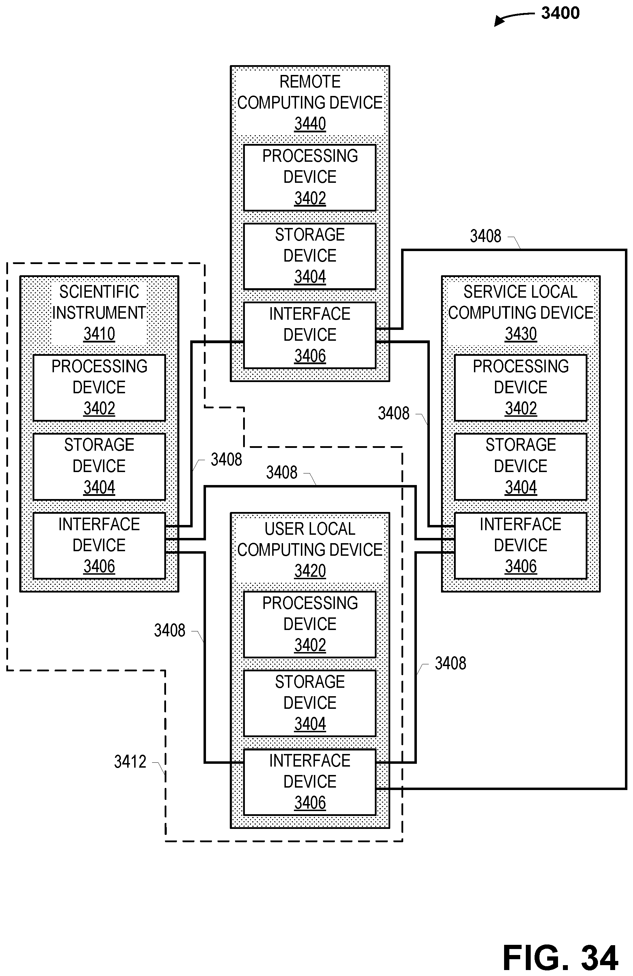

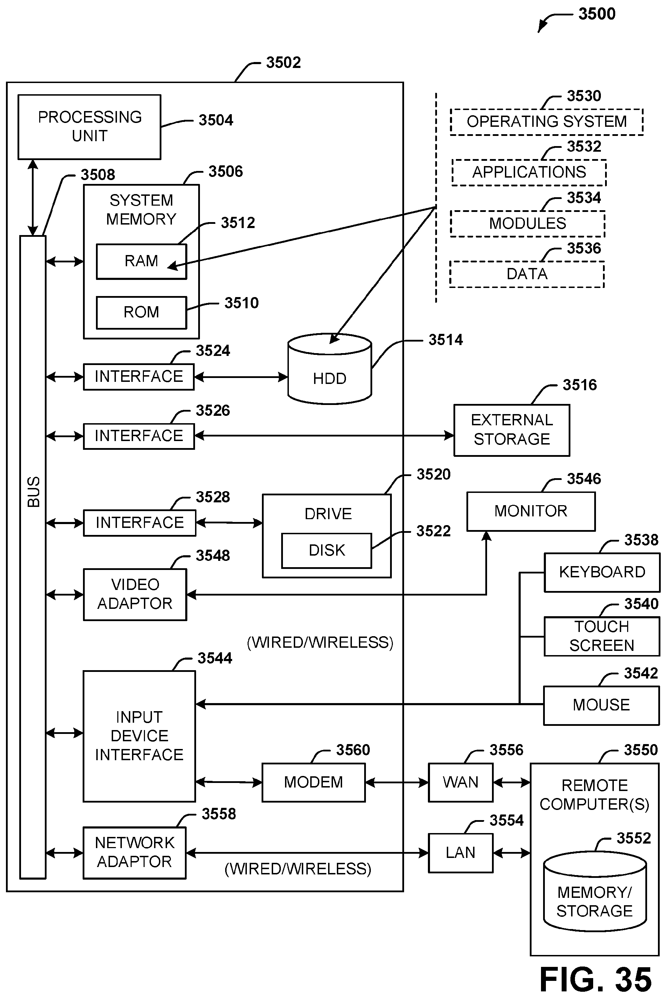

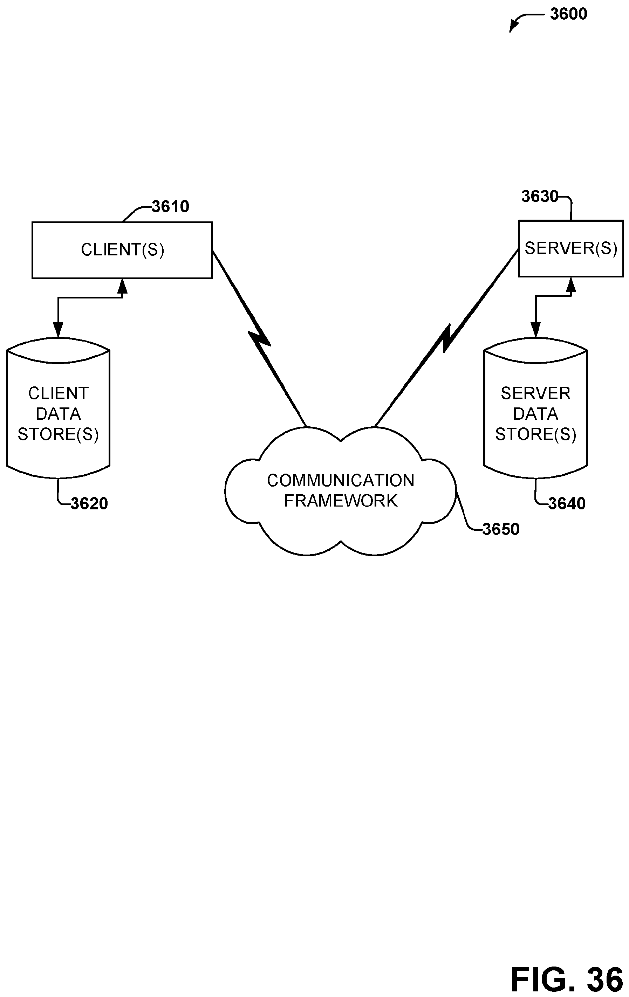

In various embodiments, the scientific instrument module 102 can be implemented by circuitry (e.g., including electrical or optical components), such as a programmed computing device. Logic of the scientific instrument module 102 can be included in a single computing device or can be distributed across multiple computing devices that are in communication with each other as appropriate. Examples of computing devices that may, singly or in combination, implement the scientific instrument module 102 are discussed herein with reference to FIGs. 33 and 35, and examples of systems or networks of interconnected computing devices, in which the scientific instrument module 102 may be implemented across one or more of the computing devices, are discussed herein with reference to FIGs. 34 and 36.

The scientific instrument module 102 can include first logic 104, second logic 106, and third logic 108. As used herein, the term "logic" can include an apparatus that is to perform a set of operations associated with the logic. For example, any of the logic elements included in the scientific instrument module 102 can be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" can refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module can omit one or more of the logic elements depicted in the associated drawings; for example, a module may include a subset of the logic elements depicted in the associated drawings when that module is to perform a subset of the operations discussed herein with reference to that module.

In various embodiments, there can be a scientific instrument corresponding to the scientific instrument module 102. In various aspects, the scientific instrument can be any suitable computerized device that can electronically measure some scientifically-relevant, clinically-relevant, or research-relevant characteristic, property, or attribute of an analytical specimen (e.g., of a known or unknown mixture, compound, or collection of matter). As a non-limiting example, a scientific instrument can be a scanning electron microscope. In such case, the scientific instrument can measure or determine a surface topography of the analytical specimen. As another non-limiting example, a scientific instrument can be a transmission electron microscope. In such case, the scientific instrument can measure or determine internal structural details of the analytical specimen. As yet another non-limiting example, a scientific instrument can be an electron energy-loss microscope. In such case, the scientific instrument can measure or determine location-wise counts or intensities across a range of defined energy-loss bins or bands for the analytical specimen. As a more general non-limiting example, a scientific instrument can be any suitable type of charged-particle microscope (e.g., some types of microscopes can use beams of non-electron ions to capture images or energy spectra).

In various embodiments, the first logic 104 can access a natural language instruction typed or spoken by a user of the scientific instrument. In various aspects, the natural language instruction can be one or more unstructured sentences that request or command that one or more configurable operating parameters of the scientific instrument by set to one or more target values.

In various embodiments, the second logic 106 can involve causing, in response to receipt of the natural language instruction, the scientific instrument to capture an image or energy spectrum of whatever specimen is currently loaded in or on the scientific instrument. In various aspects, the scientific instrument can utilize any suitable default instrument protocol to capture the image or energy spectrum (e.g., can utilize a default beam voltage or beam current that is known to be non-destructive for all or many different types of specimens).

In various embodiments, the third logic 108 can involve executing an LLM on both the natural language instruction and the image or energy spectrum of the currently-loaded specimen. In various instances, such execution can cause the LLM to synthesize a natural language response that describes, explains, or otherwise indicates whether or not fulfillment of the natural language instruction (e.g., whether or not changing the one or more configurable operating parameters to the one or more target values) would cause damage to the currently-loaded specimen. That is, the image or energy spectrum can be considered as conveying or containing at least some physical, chemical, or compositional information about the currently-loaded specimen, and the LLM can be considered as utilizing that information to infer or predict whether or not the natural language instruction is likely to damage the currently-loaded specimen. In various cases, the third logic 108 can further include visibly or audibly presenting the natural language response to the user (e.g., via a computer screen or computer speaker of the scientific instrument).

Accordingly, the scientific instrument module 102 can facilitate large language model assistance for charged-particle microscope operation (e.g., can continually monitor user-provided commands for the scientific instrument, to warn or notify the user whether or not such commands are likely to harm loaded specimens).

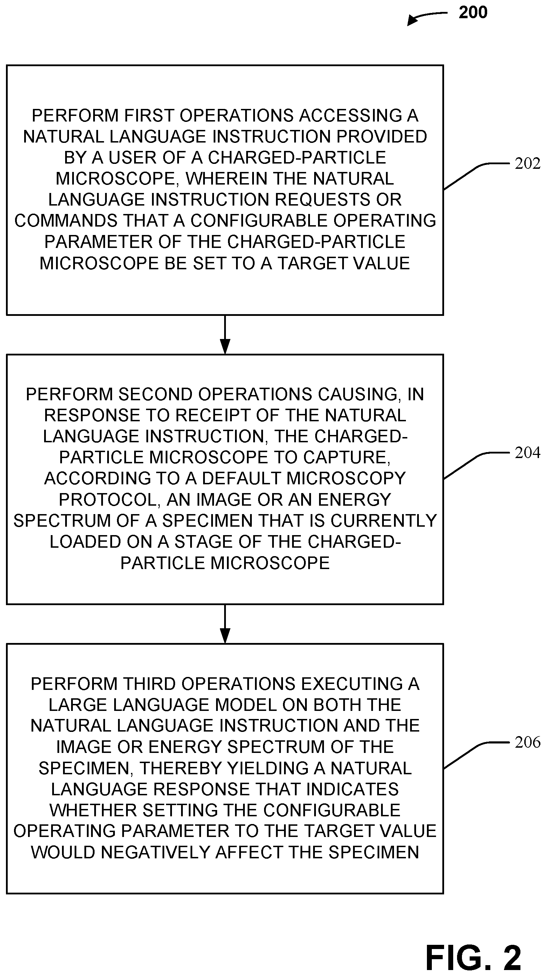

FIG. 2 is an example, non-limiting flow diagram of a computer-implemented method 200 in accordance with various embodiments described herein. The operations of the computer-implemented method 200 may be used in any suitable context to perform any suitable operations (e.g., can be performed by or used in conjunction with any of the various modules, computing devices, or graphical user interfaces described with respect to of FIGs. 1, 32, 33, 34, 35, and 36). Operations are illustrated once each and in a particular order in FIG. 2, but the operations may be reordered or repeated as desired and appropriate (e.g., different operations performed may be performed in parallel, as suitable).

In various aspects, act 202 can include performing first operations accessing a natural language instruction provided by a user of a charged-particle microscope. In various instances, the natural language instruction can request or command that a configurable operating parameter of the charged-particle microscope be set to a target value. In various cases, the first logic 104 can perform or otherwise facilitate act 202.

In various aspects, act 204 can include performing second operations causing, in response to receipt of the natural language instruction, the charged-particle microscope to capture, according to a default microscopy protocol, an image or an energy spectrum of a specimen that is currently loaded on a stage of the charged-particle microscope. In various instances, the second logic 106 can perform or otherwise facilitate act 204.

In various cases, act 206 can include performing third operations executing a large language model on both the natural language instruction and the image or energy spectrum of the specimen. Such execution can yield a natural language response that indicates whether setting the configurable operating parameter to the target value would negatively affect the specimen.

Accordingly, the computer-implemented method 200 can facilitate large language model assistance for charged-particle microscope operation.

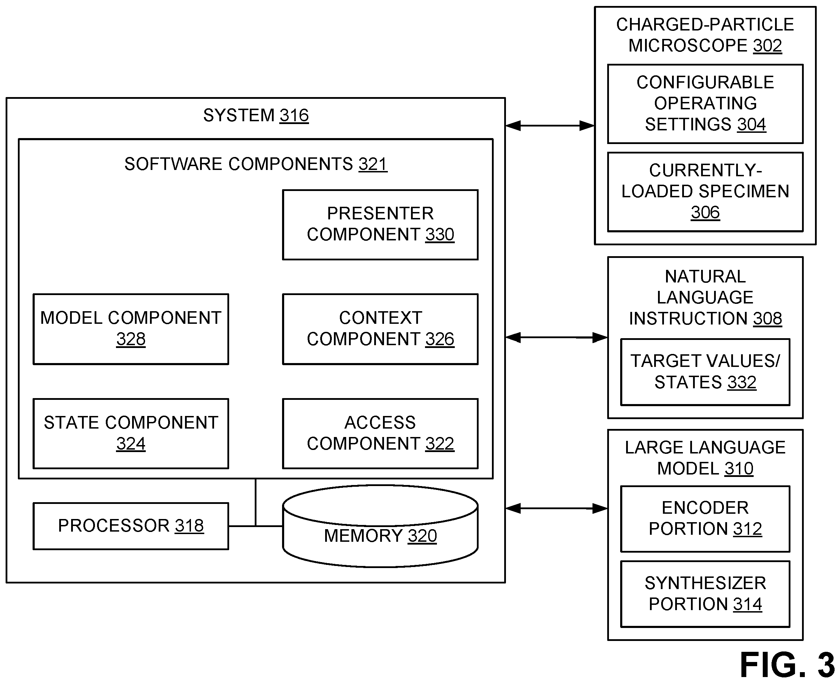

FIG. 3 illustrates a block diagram of an example, non-limiting system that can facilitate large language model assistance for charged-particle microscope operation in accordance with one or more embodiments described herein.

In various embodiments, there can be a charged-particle microscope 302. In various aspects, the charged-particle microscope 302 can be as described above. That is, the charged-particle microscope 302 can be any suitable computerized device that can leverage its constituent hardware (e.g., electron sources, anodes, condenser lenses, condenser apertures, scan coils, objective lenses, objective apertures, deflectors, condensers, stigmators, electron detectors, X-ray detectors, actuatable specimen stages) to electronically capture any suitable image of any suitable analytical specimen or any suitable energy spectrum of any suitable analytical specimen. As a non-limiting example, the charged-particle microscope 302 can be any suitable SEM. As another non-limiting example, the charged-particle microscope 302 can be any suitable TEM. As yet another non-limiting example, the charged-particle microscope 302 can be any suitable scanning-transmission electron microscope (STEM). As even another non-limiting example, the charged-particle microscope 302 can be any suitable EELM. As still another non-limiting example, the charged-particle microscope 302 can be any suitable dual-beam microscope.

Although not explicitly shown in the figures, the charged-particle microscope 302 can be electronically integrated with any suitable human-computer interface device, which can be remote from or local to the charged-particle microscope 302. Accordingly, a user or technician associated with the charged-particle microscope 302 can interact with or otherwise control the charged-particle microscope 302. Some non-limiting examples of the human-computer interface device can be a keyboard of the charged-particle microscope 302, a keypad of the charged-particle microscope 302, a touchscreen of the charged-particle microscope 302, or a voice-command system of the charged-particle microscope 302.

In any case, the charged-particle microscope 302 can comprise a plurality of configurable operating settings 304. In various aspects, each of the plurality of configurable operating settings 304 can be any suitable hardware-related characteristic or software-related characteristic of the charged-particle microscope 302 that can guide, affect, or otherwise dictate how the charged-particle microscope 302 runs, operates, or functions with respect to any given analytical specimen and that can be selectively controlled, changed, adjusted, or otherwise set by the user or technician (e.g., via interaction with the human-computer interface device of the charged-particle microscope 302). As a non-limiting example, any of the plurality of configurable operating settings 304 can be a user-controllable electric voltage setting (e.g., beam voltage) or electric current setting (e.g., beam current), which can allow the user or technician to selectively control an electrode of the charged-particle microscope 302, so as to selectively increase or decrease an electric voltage or electric current within, or that is applied by, the charged-particle microscope 302. As another non-limiting example, any of the plurality of configurable operating settings 304 can be a user-controllable temperature setting, which can allow the user or technician to control a heater (e.g., stage heater, heating coil) or cooler (e.g., cooling fan, heat pump, refrigerator) of the charged-particle microscope 302, so as to selectively increase or decrease a temperature within, or that is applied by, the charged-particle microscope 302. As still another non-limiting example, any of the plurality of configurable operating settings 304 can be a user-controllable mechanical actuator setting, which can allow the user or technician to control a mechanical actuator (e.g., electric motor, specimen stage, iris aperture, fluid pump or syringe) of the charged-particle microscope 302, so as to selectively move the mechanical actuator. As yet another non-limiting example, any of the plurality of configurable operating settings 304 can be a user-controllable optics setting, which can allow the user or technician to control an optical element (e.g., optical lens, an optical deflector) of the charged-particle microscope 302, so as to selectively change an optical quality (e.g., focal spot size or location, astigmatism, defocus) that is applied by the charged-particle microscope 302.

In various aspects, the charged-particle microscope 302 can have or otherwise be associated with a currently-loaded specimen 306. In various instances, the currently-loaded specimen 306 can (as its name suggests) be presently loaded on or within the charged-particle microscope 302. As a non-limiting example, the currently-loaded specimen 306 can be presently positioned, located, or otherwise affixed onto an actuatable stage of the charged-particle microscope 302, such that the currently-loaded specimen 306 is analyzable or scannable by the charged-particle microscope 302. In various cases, the currently-loaded specimen 306 can be any suitable type of medical, clinical, scientific, or laboratory specimen or sample that can exhibit any suitable physical, chemical, compositional, or other properties, attributes, or characteristics. As a non-limiting example, the currently-loaded specimen 306 can be a lamella taken from a semiconductor substrate or wafer. As another non-limiting example, the currently-loaded specimen 306 can be a sample or fragment taken from a failed load-bearing structure.

In various embodiments, there can be a natural language instruction 308. In various aspects, the natural language instruction 308 can be any suitable number of plain text or unstructured sentences or sentence fragments that request (e.g., as in the case of interrogative sentences) or command (e.g., as in the case of imperative sentences) that one or more of the plurality of configurable operating settings 304 be respectively set to one or more target values or states 332. In various instances, the one or more target values or states 332 can be one or more scalars, one or more vectors, one or more matrices, one or more tensors, one or more character strings, one or more categories, or any suitable combination thereof to which the user or technician wants or desires respective ones of the plurality of configurable operating settings 304 to be changed or adjusted. As some non-limiting examples, the natural language instruction 308 can be any of the following: "Set beam voltage to 30 kV."; "Change beam current to 0.2 nA."; or "Can you please increase specimen stage temperature by 10%?".

It is to be understood and appreciated that, rather than explicitly requesting or commanding specific ones of the plurality of configurable operating settings 304 to be changed to the one or more target values or states 332, the natural language instruction 308 can, in some cases, instead request or command that the charged-particle microscope 302 take, activate, or initiate one or more specified microscopy actions or tasks. As some non-limiting examples, the natural language instruction 308 can be any of the following: "Load inorganic protocol suite."; "Commence voltage contrast analysis."; or "Please begin milling." For ease of illustration and explanation, the remainder of this disclosure describes various embodiments in which the natural language instruction 308 comprises the one or more target values or states 332. However, it is to be nevertheless appreciated that any of such embodiments are equally applicable or extendable to situations in which the natural language instruction 308 instead requests or commands the initiation or performance of microscopy tasks, actions, or functions without the explicit recitation of the one or more target values or states 332.

In various instances, the natural language instruction 308 can be provided or inputted by the user or technician of the charged-particle microscope 302 via any suitable human-computer interface device associated with the charged-particle microscope 302. As a non-limiting example, the user or technician can type (e.g., via a keyboard, keypad, or touchscreen) the natural language instruction 308 into any suitable GUI text field of the charged-particle microscope 302 or of a computerized workstation that assists or is paired with the charged-particle microscope 302. As another non-limiting example, the user or technician can verbally speak into any suitable microphone of the charged-particle microscope 302 or of a computerized workstation that assists or is paired with the charged-particle microscope 302, and any suitable speech-to-text transcription system, service, or technique can convert the spoken words of the user or technician into the natural language instruction 308.

In various embodiments, there can be a large language model 310 (hereafter "LLM 310"). In various aspects, the LLM 310 can comprise an encoder portion 312 and a synthesizer portion 314. In various cases, the encoder portion 312 can be considered as being upstream from the synthesizer portion 314. Equivalently, the synthesizer portion 314 can be considered as being downstream of the encoder portion 312.

In various aspects, the encoder portion 312 can exhibit any suitable deep learning internal architecture. Indeed, in various cases, the encoder portion 312 can have an input layer, one or more hidden layers, and an output layer. In various instances, any of such layers can be coupled together by any suitable interneuron connections or interlayer connections, such as forward connections, skip connections, or recurrent connections. Furthermore, in various cases, any of such layers can be any suitable types of neural network layers having any suitable learnable or trainable internal parameters. For example, any of such input layer, one or more hidden layers, or output layer can be convolutional layers, whose learnable or trainable parameters can be convolutional kernels. As another example, any of such input layer, one or more hidden layers, or output layer can be dense layers, whose learnable or trainable parameters can be weight matrices or bias values. As still another example, any of such input layer, one or more hidden layers, or output layer can be batch normalization layers, whose learnable or trainable parameters can be shift factors or scale factors. As even another example, any of such input layer, one or more hidden layers, or output layer can be LSTM layers, whose learnable or trainable parameters can be input-state weight matrices or hidden-state weight matrices. As yet another example, any of such input layer, one or more hidden layers, or output layer can be transformer layers, whose learnable or trainable parameters can be single-head or multi-head attention blocks or other weight matrices. Further still, in various cases, any of such layers can be any suitable types of neural network layers having any suitable fixed or non-trainable internal parameters. For example, any of such input layer, one or more hidden layers, or output layer can be non-linearity layers, padding layers, pooling layers, or concatenation layers.

Likewise, in various instances, the synthesizer portion 314 can exhibit any suitable deep learning internal architecture. Indeed, in various cases, the synthesizer portion 314 can have an input layer, one or more hidden layers, and an output layer. In various instances, any of such layers can be coupled together by any suitable interneuron connections or interlayer connections (e.g., forward connections, skip connections, recurrent connections). Furthermore, in various cases, any of such layers can be any suitable types of neural network layers having any suitable learnable or trainable internal parameters (e.g., any of such input layer, one or more hidden layers, or output layer can be convolutional layers, dense layers, batch normalization layers, LSTM layers, or transformer layers). Further still, in various cases, any of such layers can be any suitable types of neural network layers having any suitable fixed or non-trainable internal parameters (e.g., any of such input layer, one or more hidden layers, or output layer can be non-linearity layers, padding layers, pooling layers, or concatenation layers).

Regardless of the specific internal architecture (e.g., the specific numbers, types, or organizations of layers) that is implemented within the encoder portion 312, the encoder portion 312 can be configured to receive textual data (which can be accompanied by any suitable numerical or graphical data) and to produce embeddings based on such inputted textual data. In contrast, regardless of the specific internal architecture that is implemented within the synthesizer portion 314, the synthesizer portion 314 can be configured to receive embeddings produced by the encoder portion 312 and to produce synthesized textual content based on such embeddings. As some non-limiting examples, the LLM 310 can be any of the following: ChatGPT; Gene.Al; Ollama; Bard; or Claude.

In various embodiments, a system 316 can be electronically integrated (e.g., via any suitable wired or wireless electronic connections) with the charged-particle microscope 302, with the natural language instruction 308, or with the LLM 310. As described herein, the system 316 can leverage the LLM 310 and the charged-particle microscope 302 so as to monitor or check a reasonableness or sanity of the natural language instruction 308.

In various aspects, the system 316 can comprise a processor 318 (e.g., computer processing unit, microprocessor) and a non-transitory computer-readable memory 320 that is operably or operatively or communicatively connected or coupled to the processor 318. The non-transitory computer-readable memory 320 can store computer-executable instructions which, upon execution by the processor 318, can cause the processor 318 or other components of the system 316 (e.g., access component 322, state component 324, context component 326, model component 328, presenter component 330) to perform one or more acts. In various embodiments, the non-transitory computer-readable memory 320 can store computer-executable components (e.g., access component 322, state component 324, context component 326, model component 328, presenter component 330), and the processor 318 can execute the computer-executable components.

In various embodiments, the system 316 can comprise an access component 322. In various aspects, the access component 322 can electronically access the charged-particle microscope 302 or the LLM 310. That is, the access component 322 can electronically communicate or otherwise electronically interact with (e.g., transmit electronic instructions or commands to, receive electronic data from) the charged-particle microscope 302 or the LLM 310. Accordingly, the access component 322 can be considered as a proxy or conduit through which other components of the system 316 can interact with, communicate with, or otherwise manipulate the charged-particle microscope 302 or with the LLM 310. In various instances, the access component 322 can electronically access the natural language instruction 308. That is, the access component 322 can electronically receive, electronically retrieve, or otherwise electronically obtain the natural language instruction 308, from any suitable electronic source or database (e.g., possibly from the charged-particle microscope 302 or from an associated computerized workstation). In any case, the access component 322 can be considered as a proxy or conduit through which other components of the system 316 can interact with, control, or otherwise manipulate the natural language instruction 308. However, these are mere non-limiting examples. In other cases, the access component 322 can be omitted, and any other components of the system 316 can communicate or interact directly with the charged-particle microscope 302, with the LLM 310, or with the natural language instruction 308.

In various embodiments, the system 316 can comprise a state component 324. In various aspects, the state component 324 can, as described herein, cause the charged-particle microscope 302 to capture an image or energy spectrum of the currently-loaded specimen 306. In some cases, the state component 324 can also obtain a current health status of the charged-particle microscope 302 from a digital twin associated with the charged-particle microscope 302.

In various embodiments, the system 316 can comprise a context component 326. In various instances, the context component 326 can, as described herein, identify various supplemental information that can provide valuable or enriching context for the natural language instruction 308, for the image or energy spectrum of the currently-loaded specimen 306, or for the current health status of the charged-particle microscope 302.

In various embodiments, the system 316 can comprise a model component 328. In various cases, the model component 328 can, as described herein, execute the LLM 310 on the natural language instruction 308, on the image or energy spectrum of the currently-loaded specimen 306, on the current health status of the charged-particle microscope 302, or on any of the supplemental data obtained by the context component 326. In various aspects, such execution can yield a natural language response that can explain or describe whether or not fulfillment or implementation of the natural language instruction 308 will undesirably harm the currently-loaded specimen 306.

In various embodiments, the system 316 can comprise a presenter component 330. In various instances, the presenter component 330 can, as described herein, visibly or audibly render the natural language response so as to be viewable or hearable by the user or technician of the charged-particle microscope 302.

Note that, in various instances, the access component 322, the state component 324, the context component 326, the model component 328, and the presenter component 330 can collectively be considered as being one or more software components 321 of the system 316. In various aspects, it should be appreciated that the one or more software components 321 are described primarily herein as comprising five components (e.g., the access component 322, the state component 324, the context component 326, the model component 328, and the presenter component 330) for ease of explanation and illustration. However, the one or more software components 321 are not limited to being implemented as exactly such five components in every embodiment. Indeed, in some embodiments, the functionalities described herein of such five components can be combined in any suitable fashions, so as to be implemented in or by fewer than five components (e.g., in some cases, a single component can perform all of the functionalities that are described herein with respect to the access component 322, the state component 324, the context component 326, the model component 328, and the presenter component 330). In other embodiments, the functionalities described herein of such five components can instead be distributed, separated, split, or fragmented in any suitable fashions, so as to be implemented in or by more than five components (e.g., two or more components can facilitate the functionalities that are performable by the access component 322; two or more components can facilitate the functionalities that are performable by the state component 324; two or more components can facilitate the functionalities that are performable by the context component 326; two or more components can facilitate the functionalities that are performable by the model component 328; two or more components can facilitate the functionalities that are performable by the presenter component 330).

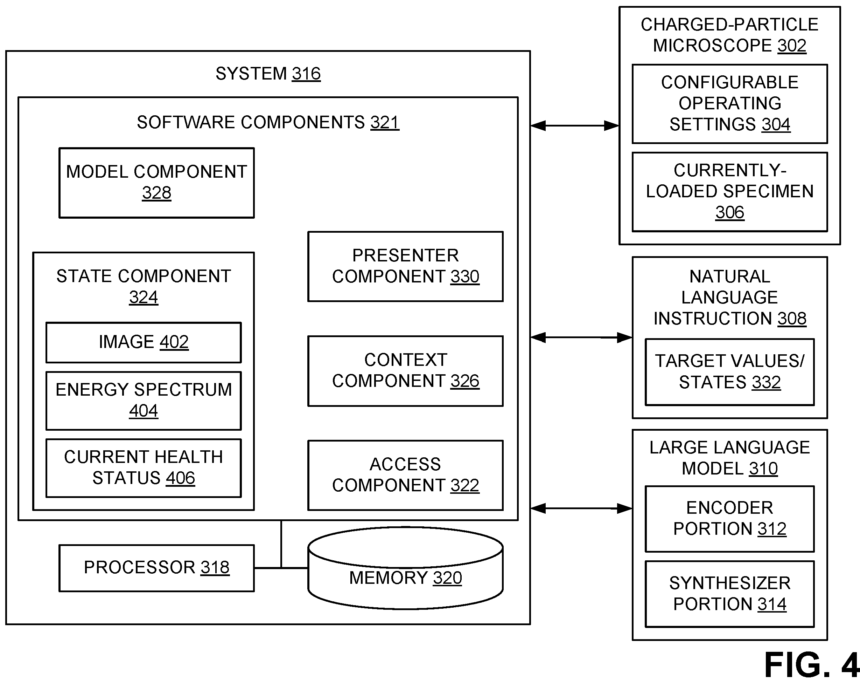

FIG. 4 illustrates a block diagram of an example, non-limiting system including a specimen image, a specimen energy spectrum, and a current microscope health status that can facilitate large language model assistance for charged-particle microscope operation in accordance with one or more embodiments described herein.

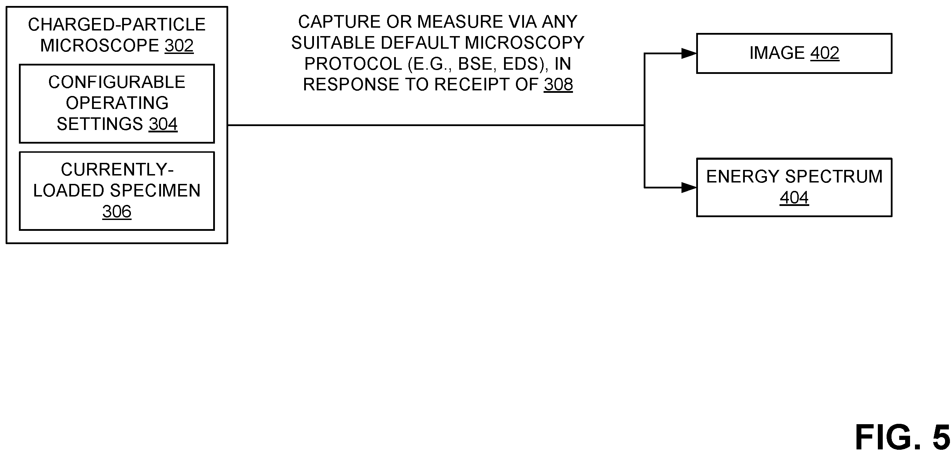

In various embodiments, the state component 324 can, in response to electronic receipt or electronic accessing of the natural language instruction 308, electronically collect various information pertaining to a current or present-time state of the charged-particle microscope 302. In various aspects, such information can comprise an image 402, an energy spectrum 404, or a current health status 406. Various non-limiting aspects are described with respect to FIGs. 5-6.

FIG. 5 illustrates an example, non-limiting block diagram showing how the image 402 or the energy spectrum 404 can be obtained in accordance with one or more embodiments described herein.

In various embodiments, the state component 324 can, in response to receipt or accessing of the natural language instruction 308, cause, instruct, or otherwise command the charged-particle microscope 302 to electronically scan the currently-loaded specimen 306. In various aspects, such scanning can be in accordance with any suitable default microscopy protocol that is implementable by the charged-particle microscope 302 and that is known or expected to be non-destructive with respect to all, most, many, or any suitable subset of whatever population of specimens that the charged-particle microscope 302 might potentially encounter in clinical, scientific, or laboratory fields. In other words, the default microscopy protocol can be any suitable microscopy scan in which any of the plurality of configurable operating settings 304 are set, changed, or adjusted to any suitable default values or states that are known or expected to be safe for wide swaths of potential or possible specimens. As some non-limiting examples, the default microscopy protocol can involve a beam current setting, a beam voltage setting, and a stage temperature setting of the charged-particle microscope 302 being set, changed, or adjusted to any suitable default amperage, voltage, and temperature values that are known or expected to not damage, harm, or deteriorate most potential specimens. For instance, the beam voltage, beam current, and stage temperature of the default microscopy protocol can be set, changed, or adjusted to whatever low, threshold, or otherwise non-extreme values are widely recognized to not harm many specimens (e.g., if it is known or expected that most or many different types of specimens are not harmed by beam voltages below 10 kV, then the default microscopy protocol can have a beam voltage setting that is set to any suitable value below 10 kV; if it is known or expected that most or many different types of specimens are not harmed by beam currents below 0.1 nA, then the default microscopy protocol can have a beam current setting that is set to any suitable value below 0.1 nA; if it is known or expected that most or many different types of specimens are not harmed by stage temperatures of 300 Kelvin (K), then the default microscopy protocol can have a stage temperature setting that is set to 300 K). In some aspects, such scanning can yield an image 402. In other aspects, such scanning can yield an energy spectrum 404.

In various instances, the image 402 can visually depict or illustrate the currently-loaded specimen 306, or any portion thereof, in any suitable fashion. In some cases, the image 402 can be an x-by-y array of pixels, for any suitable positive integers x and y. In other cases, the image 402 can be an x-by-y-by-z array of voxels, for any suitable positive integers *x, y,* and *z*. In various aspects, the visual qualities or appearance (e.g., brightness, contrast, resolution, colors) of the image 402 can vary with or otherwise depend upon the default microscopy protocol that is implemented by the charged-particle microscope 302 (e.g., can depend upon the default values or states of the plurality of configurable operating settings 304 that the charged-particle microscope 302 uses to scan the currently-loaded specimen 306). As a non-limiting example, the default microscopy protocol can be any suitable type of backscattered electron detection (BSE) scan. In such case, the image 402 can be considered as capturing, conveying, or otherwise representing various crystallographic, topographic, or magnetic field information regarding the currently-loaded specimen 306. As another non-limiting example, the default microscopy protocol can be any suitable type of electron backscatter diffraction (EBSD) scan. In such case, the image 402 can be considered as capturing, conveying, or otherwise representing various crystalline structure or orientation information regarding the currently-loaded specimen 306. As even another non-limiting example, the default microscopy protocol can be any suitable cathodoluminescence scan. In such case, the image 402 can be considered as capturing, conveying, or otherwise representing high-resolution topographic information regarding luminescent portions (if any) of the currently-loaded specimen 306.

In various aspects, the energy spectrum 404 can be considered as a plot of measured intensity versus energy (or energy-loss). As a non-limiting example, the energy spectrum 404 can be any suitable graph whose abscissa axis can represent or span any suitable number of electron energy bins or bands (e.g., measured in eV), and whose ordinate axis can represent or indicate detected electron counts (e.g., measured in numbers of electrons or in arbitrary units (A.U.)). In other words, the charged-particle microscope 302 can irradiate the currently-loaded specimen 306 with an electron beam (or any other suitable charged-particle beam), such irradiated electrons can interact (e.g., pass through, bounce off, emit X-rays during or after collision with) the currently-loaded specimen 306, the unique chemical composition of the currently-loaded specimen 306 can cause different proportions of such irradiated electrons to interact with the currently-loaded specimen 306 according to different energy levels, and the energy spectrum 404 can be considered as showing how many irradiated electrons were detected to have interacted with the currently-loaded specimen 306 in each defined energy level. As above, the visual qualities or appearance of the energy spectrum 404 can vary with or otherwise depend upon the default microscopy protocol that is implemented by the charged-particle microscope 302. As a non-limiting example, the default microscopy protocol can be any suitable energy-dispersive X-ray spectroscopy (EDS) scan. In such case, the energy spectrum 404 can be considered as capturing, conveying, or otherwise representing elemental composition or chemical characterization of the currently-loaded specimen 306. As another non-limiting example, the default microscopy protocol can be any suitable electron energy-loss (EEL) scan. In such case, the energy spectrum 404 can be considered as capturing, conveying, or otherwise representing atomic cross-sections or atomic concentrations of the currently-loaded specimen 306.

In some embodiments, the state component 324 can cause the charged-particle microscope 302 to generate only the image 402 and not the energy spectrum 404. In other embodiments, the state component 324 can cause the charged-particle microscope 302 to generate only the energy spectrum 404 and not the image 402. In still other embodiments, the state component 324 can cause the charged-particle microscope 302 to generate both the image 402 and the energy spectrum 404. In yet other embodiments, the state component 324 can cause the charged-particle microscope 302 to generate multiple instances of the image 402 (e.g., one image using a default BSE scan, another image using a default EBSD scan, yet another image using a default cathodoluminescence scan) or multiple instances of the energy spectrum 404 (e.g., one energy spectrum using a default EDS scan, another energy spectrum using a default EEL scan).

In any case, the image 402 or the energy spectrum 404 can be considered as representing, containing, or conveying at least some information regarding any suitable physical, chemical, or compositional attributes, properties, or characteristics of the currently-loaded specimen 306.

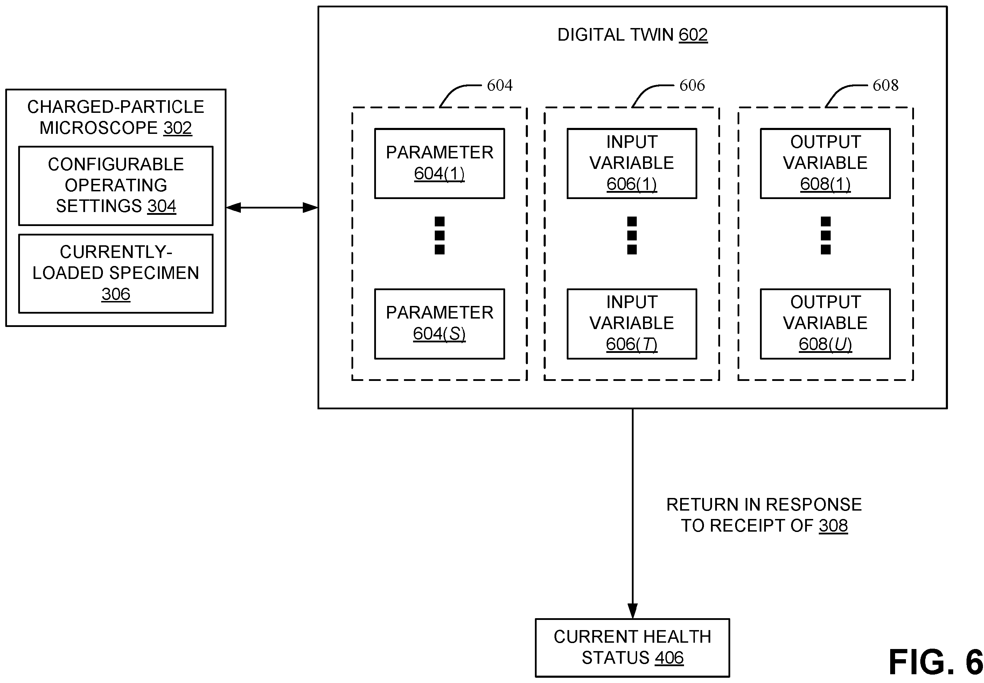

FIG. 6 illustrates an example, non-limiting block diagram showing how the current health status 406 can be obtained in accordance with one or more embodiments described herein.

In various embodiments, the charged-particle microscope 302 can be electronically synchronized with a digital twin 602. In various aspects, the digital twin 602 can comprise a parametric state 604, a set of input variables 606, and a set of output variables 608.

In various aspects, the digital twin 602 can be any suitable collection or set of any suitable mathematical or physics-based models that can collectively simulate, forecast, or otherwise predict any suitable behavioral detail or aspect of the charged-particle microscope 302. As a non-limiting example, the digital twin 602 can comprise any suitable mass continuity equations, inequalities, or formulas that pertain in some way to the charged-particle microscope 302. As another non-limiting example, the digital twin 602 can comprise any suitable energy balance equations, inequalities, or formulas that pertain in some way to the charged-particle microscope 302. As even another non-limiting example, the digital twin 602 can comprise any suitable heat transfer equations, inequalities, or formulas that pertain in some way to the charged-particle microscope 302. As still another non-limiting example, the digital twin 602 can comprise any suitable fluid flow equations, inequalities, or formulas that pertain in some way to the charged-particle microscope 302. As yet another non-limiting example, the digital twin 602 can comprise any suitable kinetic or kinematic equations, inequalities, or formulas that pertain in some way to the charged-particle microscope 302. As another non-limiting example, the digital twin 602 can comprise any suitable Newtonian mechanics or quantum mechanics equations, inequalities, or formulas that pertain in some way to the charged-particle microscope 302. As still another non-limiting example, the digital twin 602 can comprise any suitable corrosion or degradation equations, inequalities, or formulas that pertain in some way to the charged-particle microscope 302.

In any case, the digital twin 602 can be considered as a collection or set of mathematical or physics-based models that can simulate, forecast, or predict something about the charged-particle microscope 302, and those mathematical or physics-based models can be considered as being made up the parametric state 604, the set of input variables 606, and the set of output variables 608. In particular, the parametric state 604 can be considered as defining the operators or coefficients of those mathematical or physics-based models, the set of input variables 606 can be considered as the operands or arguments of those mathematical or physics-based models, and the set of output variables 608 can be considered as the simulated, predicted, or forecasted results computed by those mathematical or physics-based models.

In various aspects, the parametric state 604 of the digital twin 602 can comprise s parameters, for any suitable positive integer s: a parameter 604(1) to a parameter 604(s). In various cases, each parameter of the parametric state 604 can be any suitable mathematical quantity that can represent a respective physical or theoretical characteristic, attribute, or property of the charged-particle microscope 302. For instance, the parameter 604(1) can be a scalar, a vector, a matrix, a tensor, or any suitable combination thereof that can represent a first physical or theoretical characteristic, attribute, or property of the charged-particle microscope 302. Likewise, the parameter 604(s) can be a scalar, a vector, a matrix, a tensor, or any suitable combination thereof that can represent an s-th physical or theoretical characteristic, attribute, or property of the charged-particle microscope 302. As some non-limiting examples, any parameter of the parametric state 604 can represent: a length of the charged-particle microscope 302 or of any portion or component thereof; a width of the charged-particle microscope 302 or of any portion or component thereof; a height of the charged-particle microscope 302 or of any portion or component thereof; a thickness of the charged-particle microscope 302 or of any portion or component thereof; a radius of curvature of the charged-particle microscope 302 or of any portion or component thereof; a mass or density of the charged-particle microscope 302 or of any portion or component thereof; a stiffness of the charged-particle microscope 302 or of any portion or component thereof; a damping coefficient of the charged-particle microscope 302 or of any portion or component thereof; an electrical resistance of the charged-particle microscope 302 or of any portion or component thereof; an electrical impedance of the charged-particle microscope 302 or of any portion or component thereof; a thermal resistance of the charged-particle microscope 302 or of any portion or component thereof; a thermal conductivity of the charged-particle microscope 302 or of any portion or component thereof; a heat capacity of the charged-particle microscope 302 or of any portion or component thereof; an optical opaqueness of the charged-particle microscope 302 or of any portion or component thereof; an optical aberration coefficient (e.g., defocus coefficient, 2-fold astigmatism coefficient) of the charged-particle microscope 302 or of any portion or component thereof; a decoherence time of the charged-particle microscope 302 or of any portion or component thereof; or a quantum Hamilton element of the charged-particle microscope 302 or of any portion or component thereof.

In some cases, any parameter of the parametric state 604 can represent a physical or theoretical characteristic, attribute, or property that is expected to be intransient, constant, or fixed. That is, the value of such physical or theoretical characteristic, attribute, or property can be expected to not drift, decay, or otherwise change over time or with use of the charged-particle microscope 302. However, in other cases, any parameter of the parametric state 604 can represent a physical or theoretical characteristic, attribute, or property that is expected to be transient, unfixed, or not constant. That is, the value of such physical or theoretical characteristic, attribute, or property can be expected to slowly or quickly drift, decay, or otherwise change over time or with use of the charged-particle microscope 302.

Note that, in various aspects, it can be the case that any parameter of the parametric state 604 can be not directly or explicitly controlled or selected by any of the plurality of configurable operating settings 304. Despite this lack of direct and explicit control, it can nevertheless be the case that any parameter of the parametric state 604 can be indirectly influenced or changed by one or more of the plurality of configurable operating settings 304. As a non-limiting example, suppose that the parametric state 604 includes an aberration coefficient parameter. Although an aberration coefficient can be considered as a useful theoretical property that helps to quantitatively describe optical performance or behavior of the charged-particle microscope 302, the charged-particle microscope 302 can lack an aberration coefficient knob, slider, joystick, physical button, or software button that allows for explicit, direct selection of a specific desired aberration coefficient value. But despite this, the configurable knobs, sliders, joysticks, physical buttons, or software buttons that the charged-particle microscope 302 does have (e.g., defocusing knob, stigmator knob, specimen stage actuator joystick, voltage knob, temperature knob) can nevertheless indirectly influence the aberration coefficient of the charged-particle microscope 302 (e.g., adjusting any of the defocusing knob, stigmator knob, specimen stage actuator joystick, voltage knob, or temperature knob can cause the aberration coefficient of the charged-particle microscope 302 to increase or decrease).

In various aspects, the set of input variables 606 of the digital twin 602 can comprise *t* variables, for any suitable positive integer t: an input variable 606(1) to an input variable 606(t). In various cases, each of the set of input variables 606 can be any suitable mathematical quantity that can represent any suitable dimension, feature, detail, or aspect of a usage scenario that the charged-particle microscope 302 can encounter or experience. For instance, the input variable 606(1) can be a scalar, a vector, a matrix, a tensor, or any suitable combination thereof that can represent a first dimension, feature, detail, or aspect of a usage scenario that is encounterable by the charged-particle microscope 302. Likewise, the input variable 606(t) can be a scalar, a vector, a matrix, a tensor, or any suitable combination thereof that can represent a t-th dimension, feature, detail, or aspect of a usage scenario that is encounterable by the charged-particle microscope 302. As some non-limiting examples, any of the set of input variables 606 can represent: a mass or density of an analytical specimen that the charged-particle microscope 302 can analyze; a chemical composition of an analytical specimen that the charged-particle microscope 302 can analyze; a crystalline structure of an analytical specimen that the charged-particle microscope 302 can analyze; an absorption coefficient of an analytical specimen that the charged-particle microscope 302 can analyze; a warm-up time afforded or allocated to the charged-particle microscope 302 for analysis of an analytical specimen; a run time afforded or allocated to the charged-particle microscope 302 for analysis of an analytical specimen; a cooldown time afforded or allocated to the charged-particle microscope 302 for analysis of an analytical specimen; a maximum or minimum voltage level to be used by the charged-particle microscope 302 for analysis of an analytical specimen; a maximum or minimum radiation level to be used by the charged-particle microscope 302 for analysis of an analytical specimen; a maximum or minimum fluid flow rate to be used by the charged-particle microscope 302 for analysis of an analytical specimen; or a maximum or minimum temperature level to be used by the charged-particle microscope 302 for analysis of an analytical specimen.

In various aspects, the set of output variables 608 of the digital twin 602 can comprise u variables, for any suitable positive integer u: an output variable 608(1) to an output variable 608(u). In various cases, each of the set of output variables 608 can be any suitable mathematical quantity that can represent any suitable characteristic, attribute, property, feature, detail, or behavioral aspect of the charged-particle microscope 302 that is desired to be simulated, forecasted, or predicted. For instance, the output variable 608(1) can be a scalar, a vector, a matrix, a tensor, or any suitable combination thereof that can represent a first simulated, forecasted, or predicted characteristic, attribute, property, feature, detail, or behavioral aspect of the charged-particle microscope 302. Likewise, the output variable 608(u) can be a scalar, a vector, a matrix, a tensor, or any suitable combination thereof that can represent a u-th simulated, forecasted, or predicted characteristic, attribute, property, feature, detail, or behavioral aspect of the charged-particle microscope 302. As a non-limiting example, any of the set of output variables 608 can represent a simulated image or simulated energy spectrum that is capturable or generatable by the charged-particle microscope 302 in response to any given usage scenario. As another non-limiting example, any of the set of output variables 608 can represent a total or marginal amount of degradation or wear that the charged-particle microscope 302, or any portion or component thereof, can experience or accumulate in response to any given usage scenario. As yet another non-limiting example, any of the set of output variables 608 can represent a total or marginal amount of fuel, calibrant, or electricity that is consumable by the charged-particle microscope 302 during or in response to any given usage scenario. As even another non-limiting example, any of the set of output variables 608 can represent an amount of useful life (e.g., expressed in hours, runs, or scans) of the charged-particle microscope 302 that will remain or be left in response to any given usage scenario.

Accordingly, the digital twin 602 can simulate, forecast, or predict how the charged-particle microscope 302 will respond to any particular usage scenario. Specifically, the set of input variables 606 can be assigned any suitable numerical values that correspond to or otherwise define that particular usage scenario, the parametric state 604 can be applied (e.g., according to whatever mathematical functions, operations, or formulas make up the digital twin 602) to the set of input variables 606, and the set of output variables 608 can be equal to the computational results (e.g., products, differences, sums, quotients) of such application.

In various aspects, the state component 324 can, in response to electronic receipt or accessing of the natural language instruction 308, command or otherwise cause the digital twin 602 to return or provide the current health status 406. In various instances, the current health status 406 can be any suitable electronic data that is computed or tracked by the digital twin 602 and that pertains to the present-time health or maintenance of the charged-particle microscope 302. As a non-limiting example, the current health status 406 can comprise: the most recent or present-time version of the parametric state 604 or any subset thereof (e.g., can comprise the present-time or most-recently synchronized aberration coefficients of the charged-particle microscope 302); or the most recently computed or recorded version of the set of output variables 608 or any subset thereof (e.g., can comprise the present-time total or accumulated wear of the charged-particle microscope 302 or of any constituent part thereof; can comprise the present-time remaining useful life of the charged-particle microscope 302 or of any constituent part thereof).

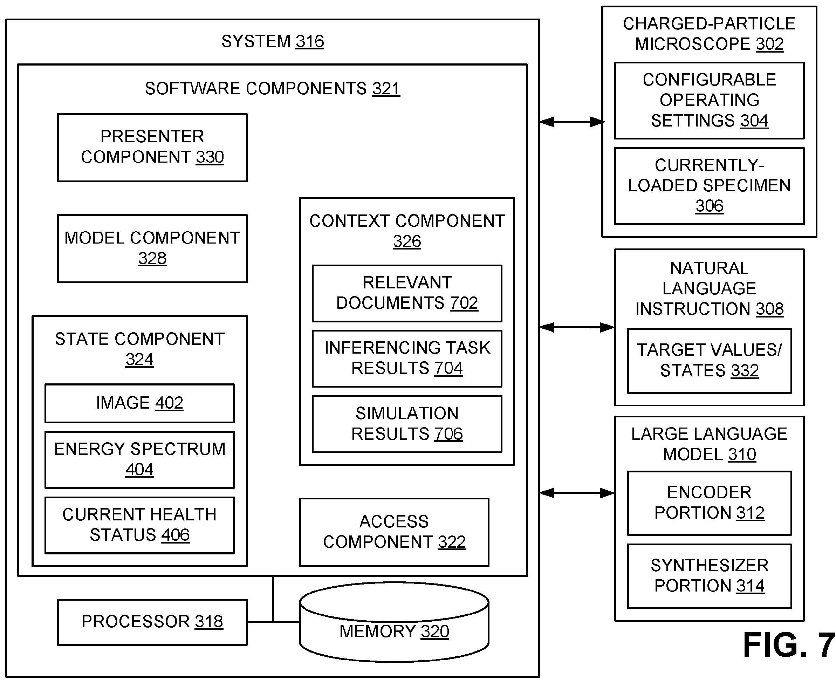

FIG. 7 illustrates a block diagram of an example, non-limiting system including a set of relevant documents, a set of inferencing task results, and a set of simulation results that can facilitate large language model assistance for charged-particle microscope operation in accordance with one or more embodiments described herein.

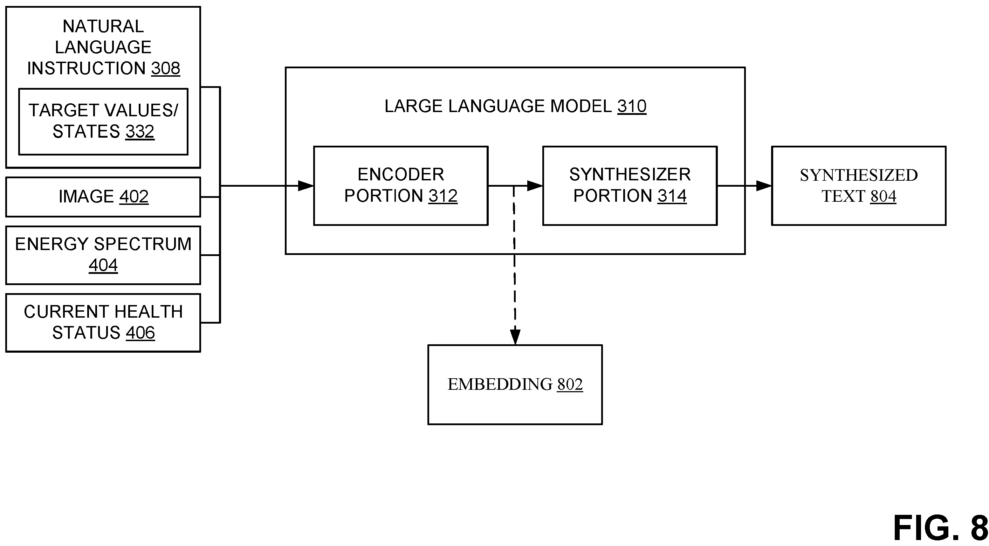

In various embodiments, the context component 326 can electronically collect various supplemental or additional information that enhances or otherwise provides context for the natural language instruction 308, the image 402, the energy spectrum 404, or the current health status 406. In various aspects, such supplemental or additional information can comprise a set of relevant documents 702, a set of inferencing task results 704, or a set of simulation results 706. Various non-limiting aspects are described with respect to FIGs. 8-12.

FIGs. 8-12 illustrate example, non-limiting block diagrams showing how the set of relevant documents 702, the set of inferencing task results 704, and the set of simulation results 706 can be obtained in accordance with one or more embodiments described herein.

First, consider FIG. 8. In various aspects, the context component 326 can electronically execute the LLM 310 on the natural language instruction 308, on the image 402, on the energy spectrum 404, on the current health status 406, or on any suitable combination thereof. In various instances, such execution can cause the LLM 310 to produce some synthesized text 804.

More specifically, the context component 326 can concatenate the natural language instruction 308, the image 402, the energy spectrum 404, and the current health status 406 together. Note that, in some cases, such concatenation can comprise any other combination of the aforementioned (e.g., can comprise fewer than all of the natural language instruction 308, the image 402, the energy spectrum 404, and the current health status 406). In various instances, the context component 326 can feed or route that concatenation to the input layer of the encoder portion 312. In various cases, that concatenation can complete a forward pass through the one or more hidden layers of the encoder portion 312. In various aspects, the output layer of the encoder portion 312 can compute or otherwise calculate an embedding 802, based on activation maps or feature maps provided by the one or more hidden layers of the encoder portion 312.

In various instances, the embedding 802 can be considered as a latent vector representation that the encoder portion 312 believes or infers corresponds to the concatenation of the natural language instruction 308, the image 402, the energy spectrum 404, or the current health status 406. More specifically, the embedding 802 can be one or more scalars, one or more vectors, one or more matrices, one or more tensors, or any suitable combination thereof. In various aspects, the dimensionality of the embedding 802 (e.g., the total number or cardinality of numerical elements within the embedding 802) can be smaller (e.g., many orders of magnitude smaller, in some cases) than the total or cumulative dimensionality of the natural language instruction 308, the image 402, the energy spectrum 404, or the current health status 406. In various instances, despite its smaller dimensionality, the embedding 802 can nevertheless be considered as representing, albeit in hidden or non-apparent fashion, at least some substantive or semantic content of the natural language instruction 308, the image 402, the energy spectrum 404, or the current health status 406. In other words, the embedding 802 can be considered as a compact or compressed numerical representation of the natural language instruction 308, the image 402, the energy spectrum 404, or the current health status 406. Note that the embedding 802 can be considered as representing the natural language instruction 308, the image 402, the energy spectrum 404, or the current health status 406 in a latent, obscure, or otherwise hidden fashion, since a third-party that has no connection or relationship to the encoder portion 312 would be unable to recreate or guess the natural language instruction 308, the image 402, the energy spectrum 404, or the current health status 406 from the embedding 802 alone.

Now, in various aspects, the embedding 802 can be fed or routed to the input layer of the synthesizer portion 314. In various cases, the embedding 802 can complete a forward pass through the one or more hidden layers of the synthesizer portion 314. In various aspects, the output layer of the synthesizer portion 314 can compute or otherwise calculate the synthesized text 804, based on activation maps or feature maps provided by the one or more hidden layers of the synthesizer portion 314.

In various aspects, the synthesized text 804 can be one or more declarative sentences or sentence fragments that the synthesizer portion 314 has generated based on the embedding 802. Note that the synthesized text 804 can be not an estimated or approximated reconstruction of the natural language instruction 308, the image 402, the energy spectrum 404, or the current health status 406. Instead, the synthesized text 804 can be any suitable number of synthetic sentences that somehow semantically or substantively relate to the embedding 802 and thus to the natural language instruction 308, the image 402, the energy spectrum 404, or the current health status 406. In some cases, the synthesized text 804 can be considered as containing hallucinations that are semantically or substantively related to the natural language instruction 308, the image 402, the energy spectrum 404, or the current health status 406.

In various aspects, the context component 326 can ignore, discard, or delete the synthesized text 804. However, the context component 326 can record, preserve, store, or otherwise maintain the embedding 802. In other words, the context component 326 can extract the embedding 802 from the encoder portion 312 (e.g., from hidden layers of the LLM 310).

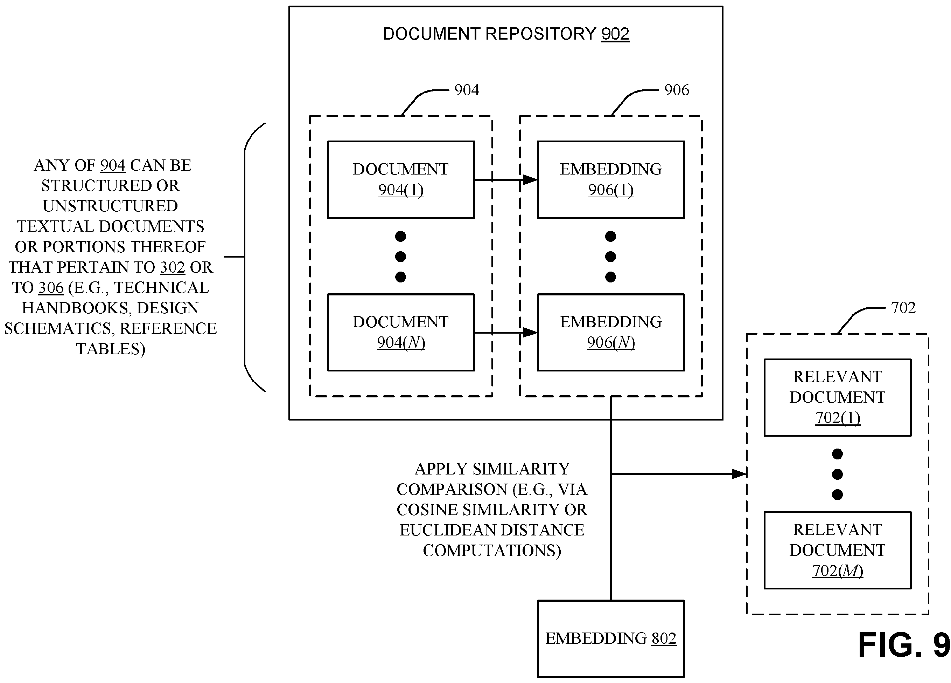

Now, consider FIG. 9. In various embodiments, there can be a document repository 902. In various aspects, the document repository 902 can comprise a plurality of documents 904. In various instances, the plurality of documents 904 can comprise n documents, for any suitable positive integer n > 1: a document 904(1) to a document 904(n). In various instances, each of the plurality of documents 904 can be any suitable electronic file (e.g., word-doc file, PDF file, webpage file) that textually (or, in some cases, graphically or numerically) describes, teaches, shows, indicates, or otherwise conveys one or more technical features, details, or aspects of any suitable charged-particle microscopes (which may or may not include the charged-particle microscope 302), or one or more technical features, details, or aspects of any suitable microscopy specimens (which may or may not include the currently-loaded specimen 306). As some non-limiting examples, any of the plurality of documents 904 can be service manuals, maintenance handbooks, schematics, failure mode reports, or any portions thereof that describe or explain: the technological or scientific designs of any suitable charged-particle microscopes (e.g., can list or show different constituent pieces, parts, or subsystems of various microscopes and can describe how those constituent pieces, parts, or subsystems work); how to operate any suitable charged-particle microscopes (e.g., can list or show different user-configurable settings or controls of various microscopes and can explain what such settings or controls do); any suitable information regarding expected use or expected operation of any suitable charged-particle microscopes (e.g., can show or explain various operating conditions or use-case scenarios that various microscopes are designed to handle or are not designed to handle); any suitable information regarding how any suitable charged-particle microscopes are expected or supposed to be maintained (e.g., can list, show, or explain various servicing tasks that are expected to be performed for various microscopes); any suitable information regarding troubleshooting of any suitable charged-particle microscopes (e.g., can describe or explain how to resolve various malfunction symptoms of various microscopes); or any suitable information regarding tabulated material properties or characteristics of any suitable specimens that are often or commonly analyzed by microscopes (e.g., can list, describe, or explain how different types of specimens should be analyzed or prepared for analysis; can list, describe, or explain how different types of specimens can be affected by different types of microscopes or by different microscopy settings).

It is to be appreciated and understood that any of the plurality of documents 904 can be any sub-portion or sub-part of some larger document. For example, any of the plurality of documents 904 can be a chapter, section, paragraph, or even sentence from some lengthier document.

In various aspects, the context component 326 can electronically generate a plurality of embeddings 906, by executing the LLM 310 as described above on each of the plurality of documents 904.

As a non-limiting example, the context component 326 can execute the LLM 310 on the document 904(1), and the context component 326 can extract, during that execution, an embedding 906(1) from the LLM 310. More specifically, the context component 326 can feed or route the document 904(1) to the input layer of the encoder portion 312, the document 904(1) can complete a forward pass through the one or more hidden layers of the encoder portion 312, and the output layer of the encoder portion 312 can compute or otherwise calculate the embedding 906(1), based on activation maps or feature maps provided by the one or more hidden layers of the encoder portion 312. Note that the embedding 906(1) can have the same format, size, or dimensionality as the embedding 802 (e.g., an embedding can be a uniform-dimensional or uniform-size vector representing a sentence; sentence-wise embeddings of a paragraph of sentences can be aggregated or averaged together to yield an embedding for the paragraph; paragraph-wise embeddings of a section or chapter can be aggregated or averaged together to yield an embedding for the section or chapter; section-wise or chapter-wise embeddings of an overall document can be aggregated or averaged together to yield an embedding for the overall document), and thus the embedding 906(1) can be considered as a latent vector representation of the document 904(1). In various cases, the embedding 906(1) can then complete a forward pass through the synthesizer portion 314, but the context component 326 can ignore, disregard, or delete whatever synthesized textual content the synthesizer portion 314 creates based on the embedding 906(1).

As another non-limiting example, the context component 326 can execute the LLM 310 on the document 904(n), and the context component 326 can extract, during that execution, an embedding 906(n) from the LLM 310. Indeed, just as described above, the context component 326 can feed or route the document 904(n) to the input layer of the encoder portion 312, the document 904(n) can complete a forward pass through the one or more hidden layers of the encoder portion 312, and the output layer of the encoder portion 312 can compute or otherwise calculate the embedding 906(*n*), based on activation maps or feature maps provided by the one or more hidden layers of the encoder portion 312. So, the embedding 906(*n*) can have the same format, size, or dimensionality as the embedding 802, and thus the embedding 906(n) can be considered as a latent vector representation of the document 904(*n*). As above, the embedding 906(n) can then complete a forward pass through the synthesizer portion 314, but the context component 326 can ignore, disregard, or delete whatever synthesized textual content the synthesizer portion 314 creates based on the embedding 906(*n*).

In various cases, the embedding 906(1) to the embedding 906(n) can collectively be considered as the plurality of embeddings 906.

In various aspects, the context component 326 can electronically determine or identify the set of relevant documents 702, by comparing the embedding 802 to the plurality of embeddings 906. In particular, for each given embedding of the plurality of embeddings 906, the context component 326 can compute any suitable error or similarity value between that given embedding and the embedding 802. As some non-limiting examples, such error or similarity value can involve: mean absolute error (MAE) computation; mean squared error (MSE) computation; cosine similarity computation; Euclidean distance computation; or cross-entropy computation. In any case, the context component 326 can conclude that the set of relevant documents 702 are whichever of the plurality of documents 904 whose embeddings (e.g., in 906) are most similar or closest to the embedding 802. As a non-limiting example, the context component 326 can identify whichever m of the plurality of documents 904 have the most similar or closest embeddings to the embedding 802, and such m documents can be considered as the set of relevant documents 702, for any suitable positive integer m. That is, the set of relevant documents 702 can comprise m documents: a relevant document 702(1) to a relevant document 702(m). In other words, the relevant document 702(1) can be whichever of the plurality of documents 904 whose embedding is closest or most similar to the embedding 802, whereas the relevant document 702(m) can be whichever of the plurality of documents 904 whose embedding is the m-th closest or m-th most similar to the embedding 802.

In any case, the set of relevant documents 702 can be considered as being substantively or semantically related in some way to the natural language instruction 308, to the image 402, to the energy spectrum 404, or to the current health status 406. As a non-limiting example, suppose that the natural language instruction 308 requests or commands that the beam voltage and stage temperature of the charged-particle microscope be set to certain desired values. In such case, any of the set of relevant documents 702 can be structured or unstructured text that describes or explains: how the beam voltage setting or the stage temperature setting of the charged-particle microscope 302 can be manipulated or adjusted; how manipulation or adjustment of the beam voltage setting or the stage temperature setting is known or expected to affect the charged-particle microscope 302 given the current health status 406; or how specimens, whose captured images or energy spectra match or look like the image 402 or the energy spectrum 404, are known or expected to respond to changes in beam voltage or to changes in stage temperature when given the current health status 406. Accordingly, the set of relevant documents 702 can be considered as providing valuable contextual information regarding the natural language instruction 308, the image 402, the energy spectrum 404, or the current health status 406.

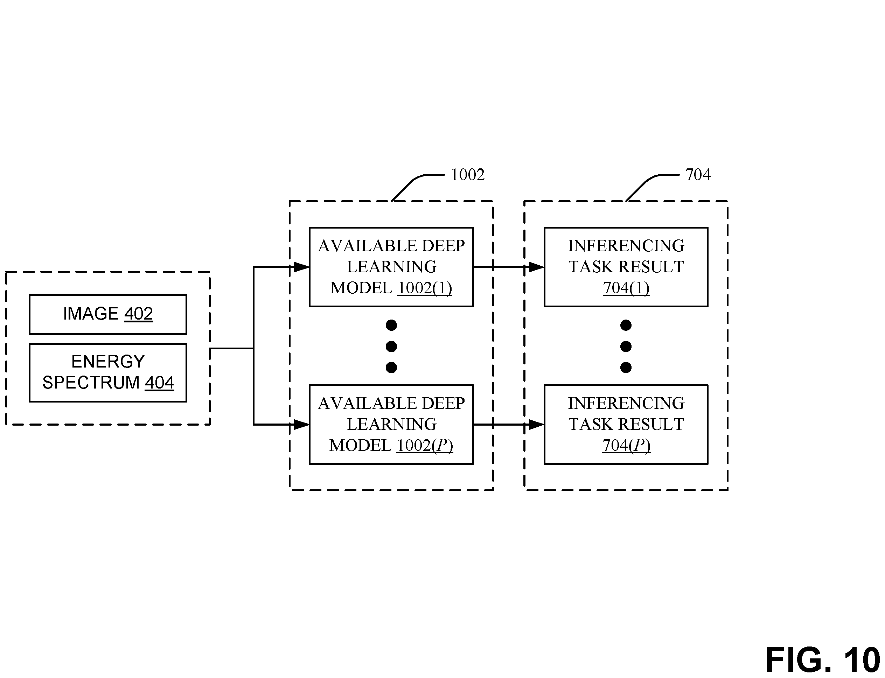

Next, consider FIG. 10. In various embodiments, there can be a set of available deep learning models 1002. In various aspects, the set of available deep learning models 1002 can comprise p models, for any suitable positive integer p: an available deep learning model 1002(1) to an available deep learning model 1002(p). In various instances, any of the set of available deep learning models 1002 can exhibit any suitable deep learning internal architecture. Indeed, in various cases, any of the set of available deep learning models 1002 can have an input layer, one or more hidden layers, and an output layer. In various instances, any of such layers can be coupled together by any suitable interneuron connections or interlayer connections (e.g., forward connections, skip connections, recurrent connections). Furthermore, in various cases, any of such layers can be any suitable types of neural network layers having any suitable learnable or trainable internal parameters (e.g., any of such input layer, one or more hidden layers, or output layer can be convolutional layers, dense layers, batch normalization layers, LSTM layers, or transformer layers). Further still, in various cases, any of such layers can be any suitable types of neural network layers having any suitable fixed or non-trainable internal parameters (e.g., any of such input layer, one or more hidden layers, or output layer can be non-linearity layers, padding layers, pooling layers, or concatenation layers).

Regardless of their specific internal architectures, each of the set of available deep learning models 1002 can be configured to perform a respective inferencing task on inputted specimen images or on inputted specimen energy spectra. In various aspects, an inferencing task can be any suitable computerized prediction or forecast of any suitable detail regarding whatever specimen whose image or energy spectrum is being analyzed. As a non-limiting example, any of the set of available deep learning models 1002 can be configured to perform classification on inputted specimen images or on inputted specimen energy spectra, so as to classify given specimens into one of two or more defined classes or categories (e.g., a chemical composition category, a failure mode category, a structure-presence category, a structure-absence category). As another non-limiting example, any of the set of available deep learning models 1002 can be configured to perform segmentation on inputted specimen images or on inputted energy spectra, so as to classify each discrete portion (e.g., individual pixels/voxels or groups thereof, individual energy bins or groups thereof) of such inputted images or energy spectra into one of two or more defined classes or categories. As even another non-limiting example, any of the set of available deep learning models 1002 can be configured to perform regression on inputted specimen images or on inputted energy spectra, so as to compute one or more continuously-varying scalars, vectors, matrices, or tensors for each of such inputted images or energy spectra (e.g., regression can include resolution enhancement, denoising, bounding box computation, or any other suitable data transformation). It is to be understood that different ones of the set of available deep learning models 1002 can be configured to perform different inferencing tasks on inputted images or on inputted energy spectra. Moreover, it is to be appreciated that any of the set of available deep learning models 1002 can be configured to receive as input the image 402 alone, that any of the set of available deep learning models 1002 can be configured to receive as input the energy spectrum 404 alone, or that any of the set of available deep learning models 1002 can be configured to receive as input both the image 402 and the energy spectrum 404.

In various aspects, the context component 326 can electronically generate the set of inferencing task results 704 by respectively executing the set of available deep learning models 1002 on the image 402 or on the energy spectrum 404.

As a non-limiting example, the context component 326 can execute the available deep learning model 1002(1) on the image 402 or on the energy spectrum 404, and such execution can yield an inferencing task result 704(1). More specifically, the context component 326 can feed the image 402 or the energy spectrum 404 (either one alone, or a concatenation of both) to the input layer of the available deep learning model 1002(1), such inputted data can complete a forward pass through the one or more hidden layers of the available deep learning model 1002(1), and the output layer of the available deep learning model 1002(1) can compute or otherwise calculate the inferencing task result 704(1) based on activation maps or feature maps provided by the one or more hidden layers of the available deep learning model 1002(1). Accordingly, the inferencing task result 704 can be whatever classification label, segmentation mask, or regression output that the available deep learning model 1002(1) has predicted or inferred for the image 402 or for the energy spectrum 404.

As another non-limiting example, the context component 326 can execute the available deep learning model 1002(p) on the image 402 or on the energy spectrum 404, and such execution can yield an inferencing task result 704(p). More specifically, the context component 326 can feed the image 402 or the energy spectrum 404 (either one alone, or a concatenation of both) to the input layer of the available deep learning model 1002(p), such inputted data can complete a forward pass through the one or more hidden layers of the available deep learning model 1002(p), and the output layer of the available deep learning model 1002(p) can compute or otherwise calculate the inferencing task result 704(p) based on activation maps or feature maps provided by the one or more hidden layers of the available deep learning model 1002(p). Accordingly, the inferencing task result 704 can be whatever classification label, segmentation mask, or regression output that the available deep learning model 1002(p) has predicted or inferred for the image 402 or for the energy spectrum 404.

In various cases, the inferencing task result 704(1) to the inferencing task result 704(p) can collectively be considered as the set of inferencing task results 704.

Accordingly, the set of inferencing task results 704 can be considered as providing valuable supplemental information regarding the image 402 or the energy spectrum 404, and thus regarding the currently-loaded specimen 306.

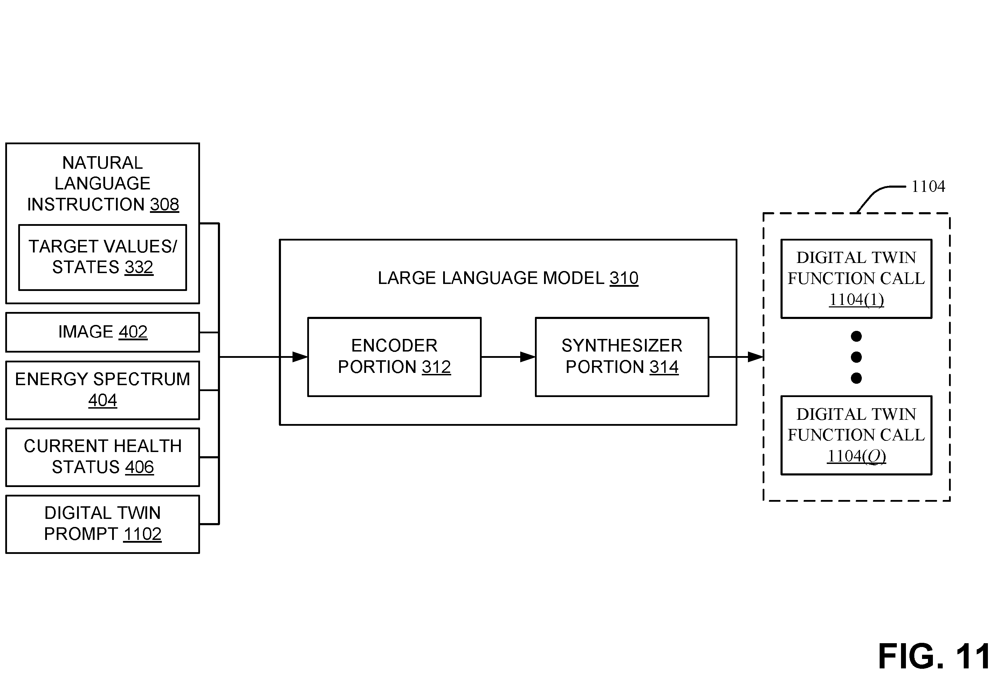

Now, consider FIG. 11. In various embodiments, there can be a digital twin prompt 1102. In various aspects, the digital twin prompt 1102 can be one or more unstructured or plain text sentences or sentence fragments that request or command that virtual experiments regarding the natural language instruction 308 be run or performed by the digital twin 602. As a non-limiting example, for any suitable positive integer q, the digital twin prompt 1102 can be the following sentences: "Specimen characterized by image 402 or energy spectrum 404. Microscope characterized by current health status 406. Design q different experiments for the digital twin 602 to test how the specimen or the microscope would react if the natural language instruction 308 were followed."

So, in various instances, the context component 326 can electronically execute the LLM 310 on the natural language instruction 308, on the image 402, on the energy spectrum 404, on the current health status 406, on the digital twin prompt 1102, or on any suitable combination thereof. In various cases, such execution can cause the LLM 310 to produce a set of digital twin function calls 1104. More specifically, the context component 326 can concatenate the natural language instruction 308, the image 402, the energy spectrum 404, the current health status 406, and the digital twin prompt 1102 together. Note that, in some cases, the concatenation can comprise any other combination of the aforementioned (e.g., can comprise fewer than all of the natural language instruction 308, the image 402, the energy spectrum 404, the current health status 406, and the digital twin prompt 1102). In various aspects, the context component 326 can feed that concatenation to the input layer of the encoder portion 312. In various aspects, that concatenation can complete a forward pass through the one or more hidden layers of the encoder portion 312. In various instances, the output layer of the encoder portion 312 can compute or otherwise calculate one or more embeddings (not shown), based on activation maps or feature maps provided by the one or more hidden layers of the encoder portion 312. In various cases, those one or more embeddings can be routed to the input layer of the synthesizer portion 314. In various aspects, those one or more embeddings can complete a forward pass through the one or more hidden layers of the synthesizer portion 314, and the output layer of the synthesizer portion 314 can compute or otherwise calculate the set of digital twin function calls 1104 based on activation maps or feature maps provided by the one or more hidden layers of the synthesizer portion 314.

In various instances, as mentioned above, the digital twin prompt 1102 can request or command the creation of q distinct virtual experiments to be performed by the digital twin 602. Accordingly, the set of digital twin function calls 1104 can comprise q calls: a digital twin function call 1104(1) to a digital twin function call 1104(q). In various cases, each of the set of digital twin function calls 1104 can be considered as being one or more respective lines of synthesized computer code that is readable by the digital twin 602 and that defines (e.g., in whatever syntax is understood by the digital twin, such as JSON code or Python code) a respective virtual experiment that is performable by the digital twin 602. As a non-limiting example, the digital twin function call 1104(1) can be one or more first lines of synthesized computer code that defines a first virtual experiment that can be run on the digital twin 602. In other words, the digital twin function call 1104(1) can specify first values that the LLM 310 infers should be assigned to the set of input variables 606 or to the parametric state 604 so as to investigate the natural language instruction 308. As another non-limiting example, the digital twin function call 1104*(q*) can be one or more q-th lines of synthesized computer code that defines a q-th virtual experiment that can be run on the digital twin 602. That is, the digital twin function call 1104(q) can specify q-th values that the LLM 310 infers should be assumed by or assigned to the set of input variables 606 or to the parametric state 604 so as to investigate the natural language instruction 308.

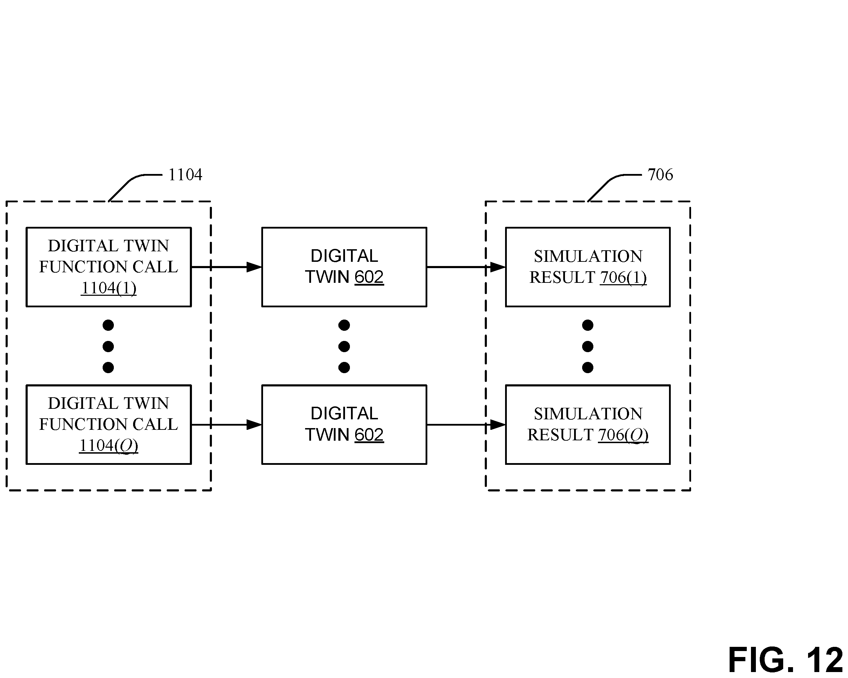

Next, consider FIG. 12. In various embodiments, the context component 326 can electronically instruct, command, or otherwise cause the digital twin 602 to run, perform, or execute each of the set of digital twin function calls 1104, thereby yielding the set of simulation results 706.

As a non-limiting example, the context component 326 can cause the digital twin 602 to execute the digital twin function call 1104(1). That is, the context component 326 can cause the digital twin 602 to assign to the set of input variables 606 or the parametric state 604 whatever values are specified in the digital twin function all 1104(1), and the digital twin 602 can accordingly run a first virtual experiment using those newly assigned values. In various aspects, such first virtual experiment can yield a simulation result 706(1), where the simulation result 706(1) can be any of the set of output variables 608 that the digital twin 602 has computed for or because of the digital twin function call 1104(1). Note that the simulation result 706(1) can, in some cases, be considered as indicating what health status the charged-particle microscope 302 would have if the natural language instruction 308 were implemented according to whatever first usage scenario is defined or specified by the digital twin function call 1104(1).

As another non-limiting example, the context component 326 can cause the digital twin 602 to execute the digital twin function call *1104(q).* That is, the context component 326 can cause the digital twin 602 to assign to the set of input variables 606 or the parametric state 604 whatever values are specified in the digital twin function all *1104(q),* and the digital twin 602 can accordingly run a q-th virtual experiment using those newly assigned values. In various aspects, such q-th virtual experiment can yield a simulation result 706(q), where the simulation result 706(q) can be any of the set of output variables 608 that the digital twin 602 has computed for or because of the digital twin function call 1104(*q*)*.* As above, the simulation result 706(q) can, in some cases, be considered as indicating what health status the charged-particle microscope 302 would have if the natural language instruction 308 were implemented according to whatever q-th usage scenario is defined or specified by the digital twin function call *1104(q).*

In various cases, the simulation result 706(1) to the simulation result 706(q) can collectively be considered as the set of simulation results 706.

Accordingly, the set of simulation results 706 can be considered as providing valuable supplemental information regarding the charged-particle microscope 302, the natural language instruction 308, the image 402, or the energy spectrum 404.

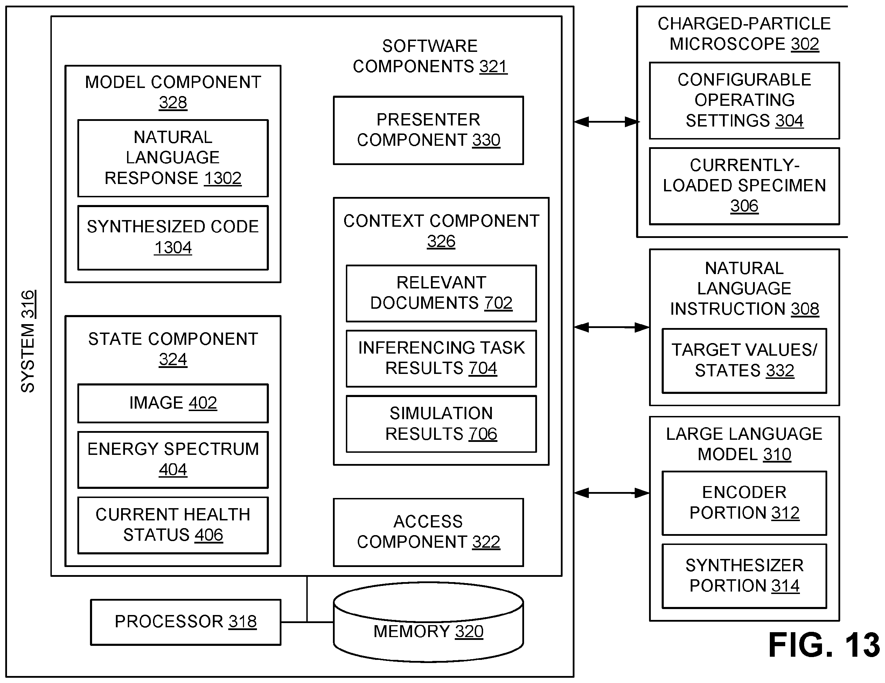

FIG. 13 illustrates a block diagram of an example, non-limiting system including a natural language response and synthesized code that can facilitate large language model assistance for charged-particle microscope operation in accordance with one or more embodiments described herein.

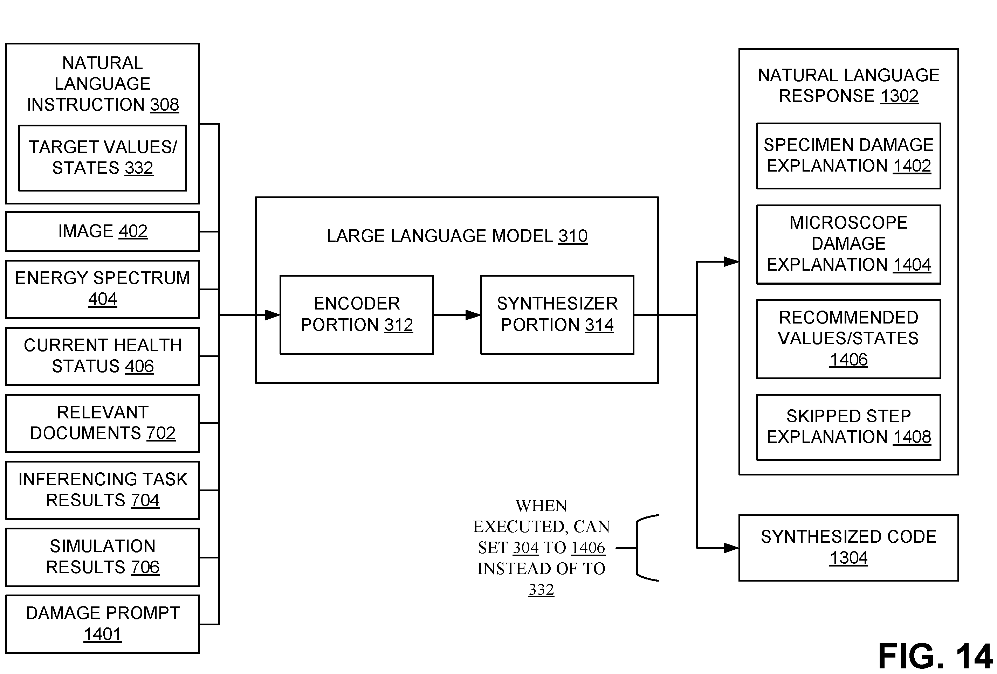

In various embodiments, the model component 328 can utilize the LLM 310 to electronically generate a natural language response 1302 or synthesized code 1304, based on the natural language instruction 308 as well as based on any of the information or data that is gathered or obtained by the state component 324 or by the context component 326. Various non-limiting aspects are described with respect to FIG. 14.

As shown in FIG. 14, there can be a damage prompt 1401. In various aspects, the damage prompt 1401 can be one or more unstructured or plain text sentences or sentence fragments that request or command that the natural language instruction 308 be evaluated for likelihood of specimen damage. In other words, the damage prompt 1401 can ask whether or not fulfillment of the natural language instruction 308 will or is likely to cause damage to the currently-loaded specimen 306. As a non-limiting example, the damage prompt 1401 can be the following sentences: "Specimen characterized by image 402 or energy spectrum 404. Microscope characterized by current health status 406. Will implementing the natural language instruction 308 on the microscope deteriorate the specimen?". As another non-limiting example, the damage prompt 1401 can be the following sentence: "Determine whether following the natural language instruction 308 will hurt the specimen shown in the image 402 or in the energy spectrum 404."

So, in various instances, the model component 328 can electronically execute the LLM 310 on the natural language instruction 308, on the image 402, on the energy spectrum 404, on the current health status 406, on the set of relevant documents 702, on the set of inferencing task results 704, on the set of simulation results 706, on the damage prompt 1401, or on any suitable combination thereof. In various cases, such execution can cause the LLM 310 to produce the natural language response 1302 or synthesized code 1304. More specifically, the context component 326 can concatenate the natural language instruction 308, the image 402, the energy spectrum 404, the current health status 406, the set of relevant document 702, the set of inferencing task results 704, the set of simulation results 706, and the damage prompt 1401 together. As above, note that, in various cases, the concatenation can comprise any other combination of the aforementioned (e.g., can comprise fewer than all of the natural language instruction 308, the image 402, the energy spectrum 404, the current health status 406, the set of relevant document 702, the set of inferencing task results 704, the set of simulation results 706, and the damage prompt 1401). In various instances, the model component 328 can feed that concatenation to the input layer of the encoder portion 312. In various aspects, that concatenation can complete a forward pass through the one or more hidden layers of the encoder portion 312. In various instances, the output layer of the encoder portion 312 can compute or otherwise calculate one or more embeddings (not shown), based on activation maps or feature maps provided by the one or more hidden layers of the encoder portion 312. In various cases, those one or more embeddings can be routed to the input layer of the synthesizer portion 314. In various aspects, those one or more embeddings can complete a forward pass through the one or more hidden layers of the synthesizer portion 314, and the output layer of the synthesizer portion 314 can compute or otherwise calculate the natural language response 1302 or the synthesized code 1304 based on activation maps or feature maps provided by the one or more hidden layers of the synthesizer portion 314.

In various aspects, as shown, the natural language response 1302 can comprise a specimen damage explanation 1402. In various instances, the specimen damage explanation 1402 can be one or more unstructured or plain text declarative sentences or sentence fragments that semantically answer the damage prompt 1401. That is, the specimen damage explanation 1402 can be synthesized text that describes or states whether or not following, fulfilling, or otherwise implementing the natural language instruction 308 (as requested by the user or technician of the charged-particle microscope 302) will degrade, harm, deteriorate, or otherwise damage the currently-loaded specimen 306.

As a non-limiting example, suppose that the natural language instruction 308 requests or commands that the beam voltage of the charged-particle microscope 302 be set to 50 kV, and suppose that (unbeknownst to the user or technician) the currently-loaded specimen 306 has a chemical composition that would be negatively affected or harmed by exposure to a 50 kV beam. As mentioned above, the image 402 or the energy spectrum 404 can be considered as conveying at least some information regarding the chemical, physical, or compositional properties of the currently-loaded specimen 306. Because the LLM 310 can be conditioned on (e.g., can receive as input) the image 402 or the energy spectrum 404, the LLM 310 can be considered as having access to that chemical, physical, or compositional information. Thus, the LLM 310 can infer or predict that the currently-loaded specimen 306 is likely to be harmed by the natural language instruction 308, and the LLM 310 can accordingly synthesize the specimen damage explanation 1402 to state or describe that such harm will occur if the natural language instruction 308 is obeyed. Note that the set of relevant documents 702, the set of inferencing task results 704, or the set of simulation results 706 can be considered as additional, supplemental, contextual, or otherwise enriching information that aids or assists the LLM 310 in correctly or accurately synthesizing the specimen damage explanation 1402 (e.g., in correctly or accurately inferring or predicting that the currently-loaded specimen 306 would be harmed by the natural language instruction 308).

As another non-limiting example, suppose that the natural language instruction 308 requests or commands that a stage temperature of the charged-particle microscope 302 be set to 400 Kelvin, and suppose that (unbeknownst to the user or technician) the currently-loaded specimen 306 has a chemical composition that would be negatively affected or harmed by exposure to such elevated temperature. Again, the image 402 or the energy spectrum 404 can be considered as conveying at least some information regarding the chemical, physical, or compositional properties of the currently-loaded specimen 306. Because the LLM 310 can be conditioned on the image 402 or the energy spectrum 404, the LLM 310 can thus infer or predict that the currently-loaded specimen 306 is likely to be harmed by the natural language instruction 308 and can accordingly synthesize the specimen damage explanation 1402 to state or describe that harm will occur. As above, the set of relevant documents 702, the set of inferencing task results 704, or the set of simulation results 706 can be considered as additional, supplemental, contextual, or otherwise enriching information that aids or assists the LLM 310 in correctly or accurately synthesizing the specimen damage explanation 1402.

Now, in some cases, the damage prompt 1401 can ask not just whether the natural language instruction 308 will harm the currently-loaded specimen 306, but also whether or not the natural language instruction 308 will harm the charged-particle microscope 302 itself. As a non-limiting example, the damage prompt 1401 can comprise the following sentences: "Specimen characterized by image 402 or energy spectrum 404. Microscope characterized by current health status 406. Will the natural language instruction 308 deteriorate or damage the specimen or the microscope?". In such situations, the natural language response 1302 can comprise a microscope damage explanation 1404. In various instances, the microscope damage explanation 1404 can be one or more unstructured or plain text declarative sentences or sentence fragments that semantically answer the damage prompt 1401 with respect to the charged-particle microscope 302. That is, the microscope damage explanation 1404 can be synthesized text that describes or states whether or not following, fulfilling, or otherwise implementing the natural language instruction 308 (as requested by the user or technician) will degrade, harm, deteriorate, or otherwise damage the charged-particle microscope 302 itself.

Consider again the above non-limiting example where the natural language instruction 308 requests or commands that the beam voltage of the charged-particle microscope 302 be set to 50 kV. Now, suppose that (unbeknownst to the user or technician) the charged-particle microscope 302 has a cathode ray tube is nearly depleted, and suppose that attempting 50 kV with a nearly-depleted cathode ray tube can expose the charged-particle microscope 302 to excessive wear or damage. In various cases, the current health status 406 can be considered as conveying (directly or indirectly) the near-depletion of the cathode ray tube of the charged-particle microscope 302. Because the LLM 310 can be conditioned on the current health status 406, the LLM 310 can be considered as having access to that piece of information regarding the nearly-depleted cathode ray tube. Thus, the LLM 310 can infer or predict that the charged-particle microscope 302 is likely to be harmed or damaged by the natural language instruction 308, and the LLM 310 can accordingly synthesize the microscope damage explanation 1404 to state or describe that such harm will occur. Note that the set of relevant documents 702 or the set of simulation results 706 can be considered as additional, supplemental, contextual, or otherwise enriching information that aids or assists the LLM 310 in correctly or accurately synthesizing the microscope damage explanation 1404 (e.g., in correctly or accurately inferring or predicting that the charged-particle microscope 302 would be harmed by the natural language instruction 308).

As another non-limiting example, suppose that the natural language instruction 308 requests or commands that a vacuum chamber of the charged-particle microscope 302 be set to 0.0001 Pascals, and suppose that (unbeknownst to the user or technician) the currently-loaded specimen 306 has a chemical or physical composition that would burst at such pressure, potentially damaging the charged-particle microscope 302. As mentioned above, the image 402 or the energy spectrum 404 can be considered as conveying at least some information regarding the chemical, physical, or compositional properties of the currently-loaded specimen 306. Because the LLM 310 can be conditioned on the image 402 or the energy spectrum 404, the LLM 310 can be considered as having access to that chemical, physical, or compositional information, can thus infer or predict that the currently-loaded specimen 306 is likely to burst due to the natural language instruction 308 and thereby damage the charged-particle microscope 302, and can accordingly synthesize the microscope damage explanation 1404 to state or describe that such damage may occur. Again, the set of relevant documents 702, the set of inferencing task results 704, or the set of simulation results 706 can be considered as additional, supplemental, contextual, or otherwise enriching information that aids or assists the LLM 310 in correctly or accurately synthesizing the microscope damage explanation 1404.

In various aspects, as mentioned above, the natural language instruction 308 can request or command that one or more of the plurality of configurable operating settings 304 be set, changed, or adjusted to the one or more target values or states 332. In situations where the LLM 310 infers or predicts that following the natural language instruction 308 will harm the currently-loaded specimen 306 or will harm the charged-particle microscope 302, the natural language response 1302 can, in various aspects, comprise one or more recommended values or states 1406. In various instances, the one or more recommended values or states 1406 can be considered as alternative versions of the one or more target values or states 332 that the LLM 310 has inferred or predicted will not harm or damage the currently-loaded specimen 306 or the charged-particle microscope 302.

As a non-limiting example, suppose again that the natural language instruction 308 requests or commands a beam voltage of 50 kV. Furthermore, suppose that the LLM 310 has inferred or predicted (based on the image 402 or the energy spectrum 404, as supplemented by the current health status 406, the set of relevant documents 702, the set of inferencing task results 704, the set of simulation results 706, or any combination thereof) that a 50 kV beam voltage will harm either the currently-loaded specimen 306 or the charged-particle microscope 302. In such case, the LLM 310 can infer or predict (based on 402 or 404, as supplemented by 406, 702, 704, 706, or any combination thereof) that such damage can be avoided by a beam current of 15 kV (e.g., here, 15 kV can be considered as the one or more recommended values or states 1406). Accordingly, the LLM 310 can synthesize the natural language response 1302 to state, describe, or explain that whatever specimen damage or microscope damage will be caused a 50 kV beam voltage can be avoided by instead using a 15 kV beam voltage.

In some embodiments, as shown, the natural language response 1302 can comprise a skipped step explanation 1408. In various instances, the skipped step explanation 1408 can be one or more unstructured or plain text sentences or sentence fragments that describe, state, or otherwise identify one or more steps, actions, or tasks that the user or technician can perform with respect to the charged-particle microscope 302 or with respect to the currently-loaded specimen 306, so as to avoid whatever damage is inferred or predicted to be caused by the natural language instruction 308. That is, the LLM 310 can, in some cases, infer or predict that the natural language instruction 308 would be non-damaging for the currently-loaded specimen 306 or for the charged-particle microscope 302, but only after the performance of some other step, action, or task that the user or technician has not yet performed (e.g., that the user or technician has inadvertently skipped or forgotten).

As a non-limiting example, suppose that the natural language instruction 308 requests or commands that the charged-particle microscope 302 perform a voltage contrast analysis, and suppose that (unbeknownst to the user or technician) the currently-loaded specimen 306 should first be cleaned (e.g., with an alcohol solution) prior to the voltage contrast analysis. As mentioned above, the image 402 or the energy spectrum 404 can be considered as conveying at least some information regarding the chemical, physical, or compositional properties of the currently-loaded specimen 306. Because the LLM 310 can be conditioned on the image 402 or the energy spectrum 404, the LLM 310 can thus infer or predict that the currently-loaded specimen 306 is contaminated or is not yet clean and that cleansing is necessary prior to voltage contrast analysis. Accordingly, the LLM 310 can cause the skipped step explanation 1408 to textually state or describe such inferences. Again, the set of relevant documents 702, the set of inferencing task results 704, or the set of simulation results 706 can be considered as additional, supplemental, contextual, or otherwise enriching information that aids or assists the LLM 310 in correctly or accurately synthesizing the skipped step explanation 1408 (e.g., in correctly or accurately inferring or predicting that the currently-loaded specimen 306 is not yet clean and that such cleaning is needed prior to commencement of voltage contrast analysis).

In various aspects, as mentioned above, the LLM 310 can generate the synthesized code 1304 in addition to (or, in some cases, instead of) the natural language response 1302. In various instances, the synthesized code 1304 can be one or more lines of computer code (e.g., of Python code, of C₊₊ code, of JSON code) that can (upon execution, running, or compilation) perform any suitable computerized action with respect to the charged-particle microscope 302 or with respect to the natural language response 1302. As a non-limiting example, in situations where the natural language response 1302 comprises the one or more recommended values or states 1406, execution of the synthesized code 1304 can cause the charged-particle microscope 302 to automatically set, change, or adjust one or more of the plurality of configurable operating settings 304 to the one or more recommended values or states 1406 instead of the one or more target values or states 332.

In various embodiments, the presenter component 330 can electronically perform any suitable actions with respect to the natural language response 1302 or with respect to the synthesized code 1304. As a non-limiting example, the presenter component 330 can visibly render, on any suitable electronic display (e.g., computer screen) of the charged-particle microscope 302 or of any suitable computerized workstation associated with the charged-particle microscope 302, the natural language response 1302. In such case, the natural language response 1302 can be seen or viewed by the user or technician of the charged-particle microscope 302. As another non-limiting example, the presenter component 330 can audibly play, on any suitable electronic speaker of the charged-particle microscope 302 or of any suitable computerized workstation associated with the charged-particle microscope 302, the natural language response 1302. In such case, the natural language response 1302 can be heard or listened to by the user or technician of the charged-particle microscope 302. In either case, the presenter component 330 can be considered as warning or notifying the user or technician of unintentional or undesired harm that would occur if the natural language instruction were fulfilled or followed. Accordingly, even if the user or technician is unskilled or untrained in the field of charged-particle microscopy, the user or technician can nevertheless operate the charged-particle microscope 302 with less fear of unwittingly damaging the currently-loaded specimen 306 or the charged-particle microscope 302 itself. In this way, the system 316 can be considered as helping to protect the currently-loaded specimen 306 or the charged-particle microscope 302 itself from inexperience of the user or technician.

In some instances, the presenter component 330 can electronically execute, run, or compile the synthesized code 1304. In various cases, this can cause the charged-particle microscope 302 to automatically implement the one or more recommended values or states 1406 instead of the one or more target values or states 332. In other words, the microscopy settings requested by the user or technician can be ignored, and the microscopy settings inferred by the LLM 310 for the currently-loaded specimen 306 can be automatically implemented. Again, the system 316 can be considered as helping to protect the currently-loaded specimen 306 or the charged-particle microscope 302 itself from inexperience of the user or technician.

In some embodiments, the damage prompt 1401 can be replaced with a more general result prompt. That is, rather than asking specifically whether or not implementation of the natural language instruction 308 will harm the currently-loaded specimen 306 or the charged-particle microscope 302, the result prompt can instead ask how the currently-loaded specimen 306 or the charged-particle microscope 302 will respond to implementation of the natural language instruction 308. In other words, the result prompt can be one or more unstructured or plain text sentences or sentence fragments that request or command identification of whatever consequence (good or bad, positive or negative) that is likely to occur with respect to the currently-loaded specimen 306 or with respect to the charged-particle microscope 302, if the natural language instruction 308 were to be obeyed. As a non-limiting example, the result prompt can be the following sentences: "Specimen characterized by image 402 or energy spectrum 404. Microscope characterized by current health status 406. How will implementation of the natural language instruction 308 affect the specimen or the microscope?". As another non-limiting example, the result prompt can be the following sentences: "Specimen characterized by image 402 or energy spectrum 404. Microscope characterized by current health status 406. Tell me what will happen to the specimen or microscope if the natural language instruction 308 is followed."

In such case, the specimen damage explanation 1402 can be replaced with a more general specimen result explanation, and the microscope damage explanation 1404 can likewise be replaced with a more general microscope result explanation. In various aspects, the specimen result explanation can be one or more synthesized, declarative sentences or sentence fragments that describe or state how the currently-loaded specimen 306 would be affected if the natural language instruction 308 were followed, fulfilled, or otherwise implemented. Similarly, the microscope result explanation can be one or more synthesized, declarative sentences or sentence fragments that describe or state how the charged-particle microscope 302 would be affected if the natural language instruction 308 were followed, fulfilled, or otherwise implemented.

As a non-limiting example, suppose that the natural language instruction 308 requests or commands that the beam voltage of the charged-particle microscope 302 be set to 50 kV, and suppose that (unbeknownst to the user or technician) the currently-loaded specimen 306 has a chemical composition that would not be damaged or degraded by exposure to a 50 kV beam, but that would be non-homogenously charged (thereby leading to undesired charging artifacts) by exposure to a 50 kV beam. As mentioned above, the image 402 or the energy spectrum 404 can be considered as conveying at least some information regarding the chemical, physical, or compositional properties of the currently-loaded specimen 306. Because the LLM 310 can be conditioned on (e.g., can receive as input) the image 402 or the energy spectrum 404, the LLM 310 can be considered as having access to that chemical, physical, or compositional information. Thus, the LLM 310 can infer or predict that the currently-loaded specimen 306 is likely to be non-homogeneously charged, and the LLM 310 can accordingly synthesize the specimen result explanation to state or describe that such charging will occur if the natural language instruction 308 is obeyed. As above, the set of relevant documents 702, the set of inferencing task results 704, or the set of simulation results 706 can be considered as additional, supplemental, contextual, or otherwise enriching information that aids or assists the LLM 310 in correctly or accurately synthesizing the specimen result explanation (e.g., in correctly or accurately inferring or predicting that the currently-loaded specimen 306 would be non-homogeneously charged by the natural language instruction 308).

In this way, various embodiments described herein can be considered as proactively predicting the likely consequences that implementation of the natural language instruction 308 will have on the currently-loaded specimen 306 or on the charged-particle microscope 302, even though such consequences might not be damage or deterioration. Again, the system 316 can be considered as helping to protect in real-time the user or technician from their own microscopy inexperience.

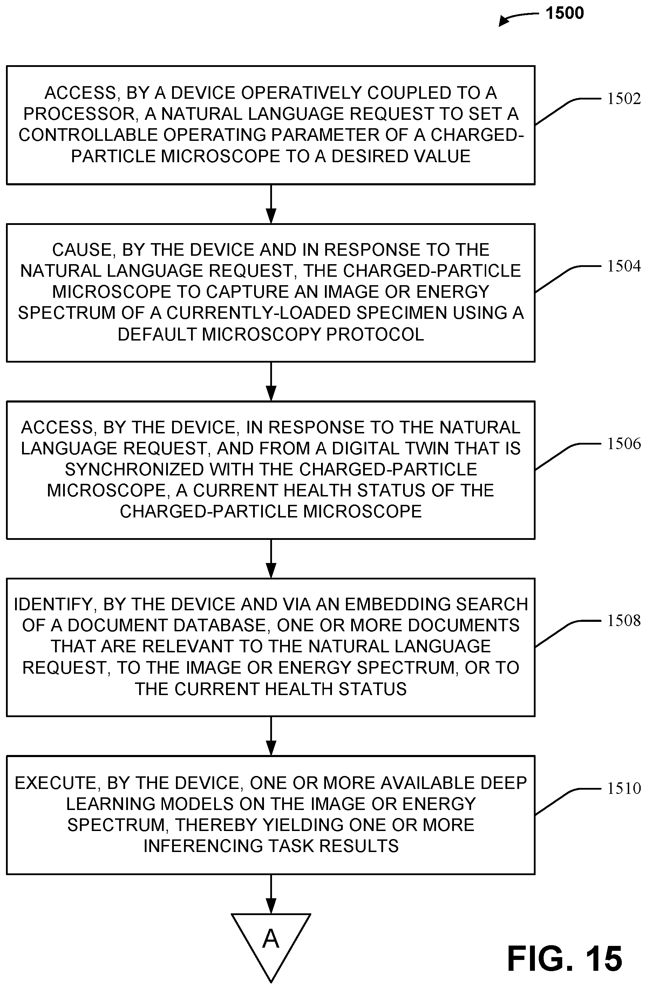

FIGs. 15-16 illustrate example, non-limiting flow diagrams of computer-implemented methods in accordance with one or more embodiments described herein.

First, consider FIG. 15. In various embodiments, act 1502 can include accessing, by a device (e.g., via 322) operatively coupled to a processor (e.g., 318), a natural language request (e.g., 308) to set a controllable operating parameter (e.g., one of 304) of a charged-particle microscope (e.g., 302) to a desired value (e.g., one of 332).

In various aspects, act 1504 can include causing, by the device (e.g., via 324) and in response to the natural language request, the charged-particle microscope to capture an image (e.g., 402) or energy spectrum (e.g., 404) of a currently-loaded specimen (e.g., 306) using a default microscopy protocol.

In various instances, act 1506 can include accessing, by the device (e.g., via 324), in response to the natural language request, and from a digital twin (e.g., 602) that is synchronized with the charged-particle microscope, a current health status (e.g., 406) of the charged-particle microscope.

In various cases, act 1508 can include identifying, by the device (e.g., via 326) and via an embedding search of a document database (e.g., 902), one or more documents (e.g., 702) that are relevant to the natural language request, to the image or energy spectrum, or to the current health status.

In various aspects, act 1510 can include executing, by the device (e.g., via 326), one or more available deep learning models (e.g., 1002) on the image or energy spectrum, thereby yielding one or more inferencing task results (e.g., 704). In various cases, as shown, the computer-implemented method 1500 can proceed to act 1602 of the computer-implemented method 1600.

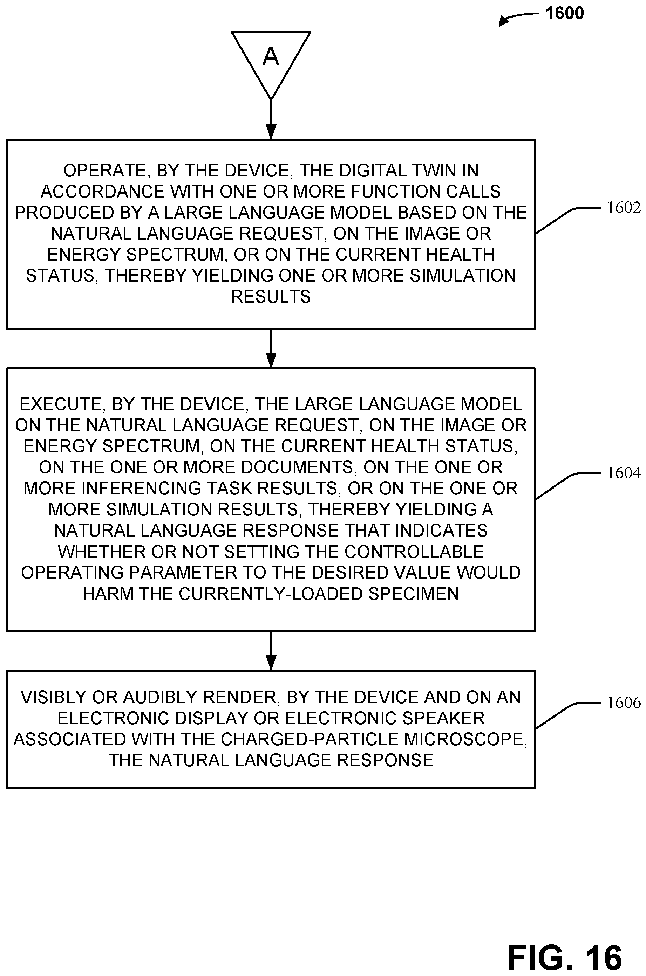

Now consider FIG. 16. In various embodiments, act 1602 can include operating, by the device (e.g., via 326), the digital twin in accordance with one or more function calls (e.g., 1104) produced by a large language model (e.g., 310) based on the natural language request, on the image or energy spectrum, or on the current health status. In various cases, this can cause the digital twin to yield one or more simulation results (e.g., 706).

In various aspects, act 1604 can include executing, by the device (e.g., via 328), the large language model on the natural language request, on the image or energy spectrum, on the current health status, on the one or more documents, on the one or more inferencing task results, or on the one or more simulation results. In various cases, this can cause the large language model to yield a natural language response (e.g., 1302 comprising 1402) that indicates whether or not setting the controllable operating parameter to the desired value would harm the currently-loaded specimen.

In various instances, act 1606 can include visibly or audibly rendering, by the device (e.g., via 330) and on an electronic display or electronic speaker associated with the charged-particle microscope, the natural language response. In this way, an untrained or inexperienced user of the charged-particle microscope can be warned or notified in real-time of whether or not their requests would unwittingly or unintentionally cause damage to the currently-loaded specimen.

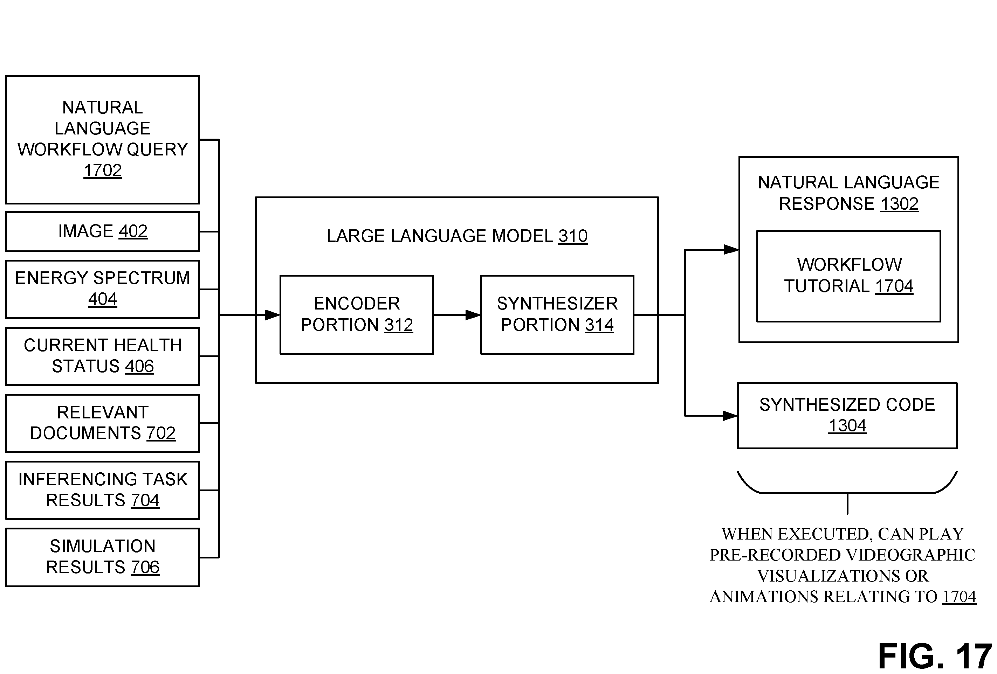

Thus far, various embodiments have been described with respect to the natural language instruction 308. That is, various embodiments have been described in which the user or technician requests or commands that the charged-particle microscope 302 adjust its settings in a particle way or otherwise perform some particular microscopy task. However, the user or technician might have various other types of requests for the charged-particle microscope 302. Non-limiting examples of such various other types of requests are described with respect to FIGs. 17-30.

First, consider FIG. 17. Rather than providing the natural language instruction 308, the user or technician of the charged-particle microscope 302 can instead provide a natural language workflow query 1702.

In various aspects, the natural language workflow query 1702 can be any suitable number of plain text or unstructured sentences or sentence fragments that request or command identification of how to properly perform, conduct, or otherwise implement any suitable microscopy workflow on or using the charged-particle microscope 302. As some non-limiting examples, the natural language workflow query 1702 can be any of the following: "Explain how to perform a voltage contrast analysis on this microscope."; "What steps are needed for bend analysis?"; or "How should I perform diffraction analysis?".

As above, the natural language workflow query 1702 can be provided or inputted by the user or technician of the charged-particle microscope 302 via any suitable human-computer interface device associated with the charged-particle microscope 302 (e.g., the natural language workflow query 1702 can be typed or spoken by the user or technician).

Also as above, the state component 324 can electronically obtain, receive, retrieve, or otherwise access the image 402, the energy spectrum 404, or the current health status 406, in response to receipt or accessing of the natural language workflow query 1702.

Yet also as above, the context component 326 can electronically obtain, receive, retrieve, or otherwise access the set of inferencing task results 704, by respectively executing the set of available deep learning models 1002 on the image 402 or on the energy spectrum 404.

Now, in various cases, the context component 326 can electronically identify the set of relevant documents 702 based on the natural language workflow query 1702 instead of based on the natural language instruction 308. As a non-limiting example, the context component 326 can concatenate the natural language workflow query 1702, the image 402, the energy spectrum 404, the current health status 406, or any combination thereof together, and can execute the LLM 310 on that concatenation. Such execution can cause the LLM 310 to yield a particular embedding (e.g., such as described with respect to FIG. 8) that substantively or semantically represents the natural language workflow query 1702, the image 402, the energy spectrum 404, or the current health status 406. Accordingly, the context component 326 can perform an embedding search through the document repository 902 so as to identify the set of relevant documents 702. In such case, the set of relevant documents 702 can be considered as being substantively or semantically related or pertinent to the natural language workflow query 1702 instead of to the natural language instruction 308. In other words, the set of relevant documents 702 can be obtained as described with respect to FIGs. 8-9, but with the natural language instruction 308 being replaced by the natural language workflow query 1702.

Similarly, in various cases, the context component 326 can electronically obtain the set of simulation results 706 based on the natural language workflow query 1702 instead of based on the natural language instruction 308. As a non-limiting example, the digital twin prompt 1102 can be one or more unstructured or plain text sentences or sentence fragments that request or command that virtual experiments regarding the natural language workflow query 1702 be run or performed by the digital twin 602. For instance, the digital twin prompt 1102 can be the following sentences: "Specimen characterized by image 402 or energy spectrum 404. Microscope characterized by current health status 406. Design q different experiments for the digital twin 602 to test how the specimen or the microscope would react to the microscopy workflow identified in the natural language workflow query 1702." So, the context component 326 can concatenate the natural language workflow query 1702, the image 402, the energy spectrum 404, the current health status 406, the digital twin prompt 1102, or any combination thereof together and can execute the LLM 310 on that concatenation. Such execution can cause the LLM 310 to yield a set of digital twin function calls (e.g., such as described with respect to FIG. 11) that pertain to the natural language workflow query 1702, the image 402, the energy spectrum 404, or the current health status 406. Accordingly, the context component 326 can cause the digital twin 602 to run that set of function calls, thereby yielding the set of simulation results 706. In such case, the set of simulation results 706 can be considered as arising from virtual experiments that test or investigate whatever microscopy workflow is specified in the natural language workflow query 1702, instead of arising from virtual experiments that test or investigate the natural language instruction 308. In other words, the set of simulation results 706 can be obtained as described with respect to FIGs. 11-12, but with the natural language instruction 308 being replaced by the natural language workflow query 1702.

So, in various aspects, the model component 328 can electronically execute the LLM 310 on a concatenation of the natural language workflow query 1702, the image 402, the energy spectrum 404, the current health status 406, the set of relevant documents 702, the set of inferencing task results 704, or the set of simulation results 706, and such execution can cause the LLM 310 to produce the natural language response 1302 or the synthesized code 1304.

In such embodiments, the natural language response 1302 can comprise a workflow tutorial 1704. In various aspects, the workflow tutorial 1704 can be one or more unstructured or plain text declarative sentences or sentence fragments that semantically answer the natural language workflow query 1702. That is, the workflow tutorial 1704 can be synthesized text that describes, states, or lists (e.g., as bullet points) what sequence of steps are needed or required in order to perform the particular microscopy workflow that is specified in the natural language workflow query 1702. In various instances, some microscopy workflows can be specimen-dependent. Accordingly, the workflow tutorial 1704 can be considered as describing or teaching what specific sequence steps are required or needed to properly perform the specified microscopy workflow on the currently-loaded specimen 306, notwithstanding that the natural language workflow query 1702 might be completely silent regarding the currently-loaded specimen 306.

As a non-limiting example, suppose that the natural language workflow query 1702 asks about voltage contrast analysis. Moreover, suppose that voltage contrast analysis can require steps A, B, and C to be performed in sequence for organic specimens, and suppose that voltage contrast analysis can instead require steps D, B, E, and C to be performed in sequence for inorganic specimens. As mentioned above, the image 402 or the energy spectrum 404 can be considered as conveying at least some information regarding the chemical, physical, or compositional properties of the currently-loaded specimen 306. Because the LLM 310 can be conditioned on the image 402 or the energy spectrum 404, the LLM 310 can be considered as having access to that chemical, physical, or compositional information. Thus, the LLM 310 can infer or predict whether the currently-loaded specimen 306 is organic or inorganic, and the LLM 310 can accordingly synthesize the workflow tutorial 1704 to state, describe, or list the appropriate sequence of voltage contrast analysis steps (e.g., if the LLM 310 infers that the currently-loaded specimen 306 is organic, the workflow tutorial 1704 can teach the sequences of steps A, B, and C; instead, if the LLM 310 infers that the currently-loaded specimen 306 is inorganic, the workflow tutorial 1704 can instead teach the sequences of steps D, B, E, and C). As above, note that the set of relevant documents 702, the set of inferencing task results 704, or the set of simulation results 706 can be considered as additional, supplemental, contextual, or otherwise enriching information that aids or assists the LLM 310 in correctly or accurately synthesizing the workflow tutorial 1704 (e.g., in correctly or accurately inferring or predicting what sequence of steps is needed or required to properly perform the specified microscopy workflow on the currently-loaded specimen 306).

In some instances, it can be possible that (e.g., due to a lack of training, skill, or experience of the user or technician) the workflow specified in the natural language workflow query 1702 can be inappropriate for or otherwise not performable on the currently-loaded specimen 306 (e.g., some workflows might not be able to be conducted for specimens containing certain chemicals or exhibiting certain physical structures). In such cases, the LLM 310 can infer or predict (due to the image 402, the energy spectrum 404, or any of their supplemental or contextual data) that the specified microscopy workflow is not able to be properly performed at all on the currently-loaded specimen 306, and the workflow tutorial 1704 can state or describe as much. In various aspects, the LLM 310 can infer or predict (again, due to the image 402, the energy spectrum 404, or any of their supplemental or contextual data) some alternative microscopy workflow that is performable on or otherwise appropriate for the currently-loaded specimen 306. In such case, the workflow tutorial 1704 can describe or explain whatever sequence of steps is needed or required to properly perform that alternative microscopy workflow on the currently-loaded specimen 306.

In various aspects, as mentioned above, the LLM 310 can generate the synthesized code 1304 in addition to (or, in some cases, instead of) the natural language response 1302. Also as mentioned above, the synthesized code 1304 can be one or more lines of computer code that can (upon execution, running, or compilation) perform any suitable computerized action with respect to the charged-particle microscope 302 or with respect to the natural language response 1302. As a non-limiting example, in situations where the natural language response 1302 comprises the workflow tutorial 1704, execution of the synthesized code 1304 can cause an electronic display of the charged-particle microscope 302 (or of any suitable computerized workstation associated with the charged-particle microscope 302) to play one or more pre-recorded videographic visualizations or animations relating to the workflow tutorial 1704. For instance, suppose that the workflow tutorial 1704 textually explains or teaches how to properly perform voltage contrast analysis on the currently-loaded specimen 306, and suppose that there is a database or storage bank of pre-recorded videos or animations for various microscopy workflows. In such case, the LLM 310 can be considered as identifying which specific videos or animations in that database or storage bank correspond to whatever specific steps of voltage contrast analysis are inferred to be appropriate or needed for the currently-loaded specimen 306. Thus, the LLM 310 can cause the synthesized code 1304 to refer to or otherwise invoke those identified videos or animations, such that execution of the synthesized code 1304 can cause those identified videos or animations to be visually played on one or more computer screens (e.g., each video or animation can visually show how to perform one or more respective steps of voltage contrast analysis).

As above, the presenter component 330 can electronically perform any suitable actions with respect to the natural language response 1302 or with respect to the synthesized code 1304, such as visually rendering or audibly playing the natural language response 1302. In some cases, the presenter component 330 can electronically execute, run, or compile the synthesized code 1304, thereby playing whatever pre-recorded videos or animations correspond to the workflow tutorial 1704. Accordingly, even if the user or technician is unskilled or untrained in the field of charged-particle microscopy, the user or technician can nevertheless competently perform microscopy workflows on or using the charged-particle microscope 302 in ways or fashions that are appropriate for the currently-loaded specimen 306. In this way, the system 316 can be considered as providing real-time, specimen-conditioned workflow guidance to the user or technician.

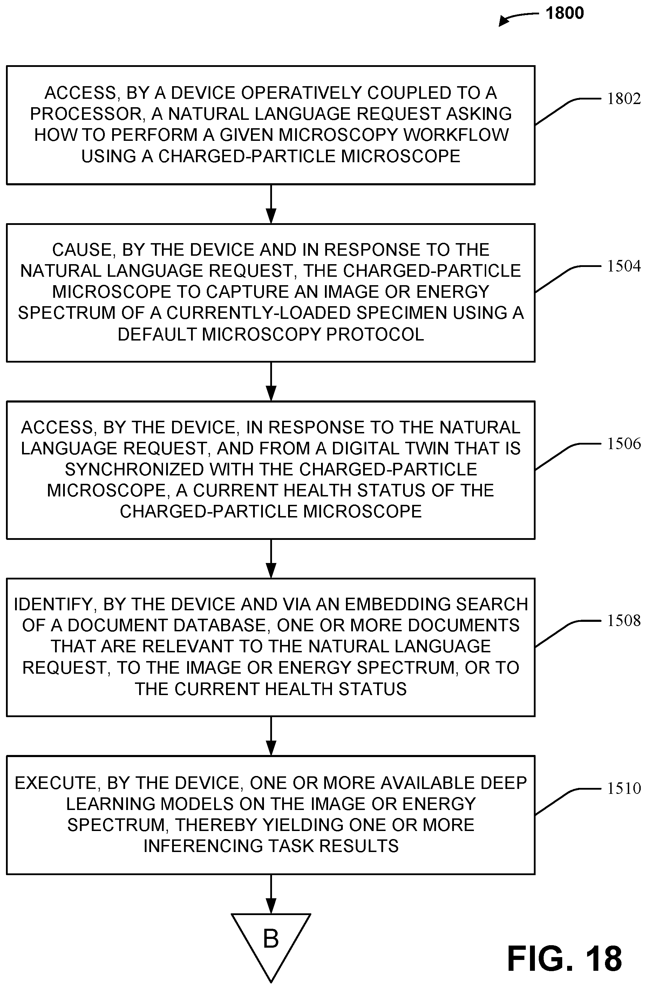

FIGs. 18-19 illustrate example, non-limiting flow diagrams of computer-implemented methods in accordance with one or more embodiments described herein.

First, consider FIG. 18. In various embodiments, act 1802 can include accessing, by a device (e.g., via 322) operatively coupled to a processor (e.g., 318), a natural language request (e.g., 1702) asking how to perform a given microscopy workflow using a charged-particle microscope (e.g., 302).

In various aspects, as shown, the computer-implemented method 1800 can proceed to acts 1504, 1506, 1508, and 1510, as described above. The computer-implemented method 1800 can then proceed to act 1602 of the computer-implemented method 1900.

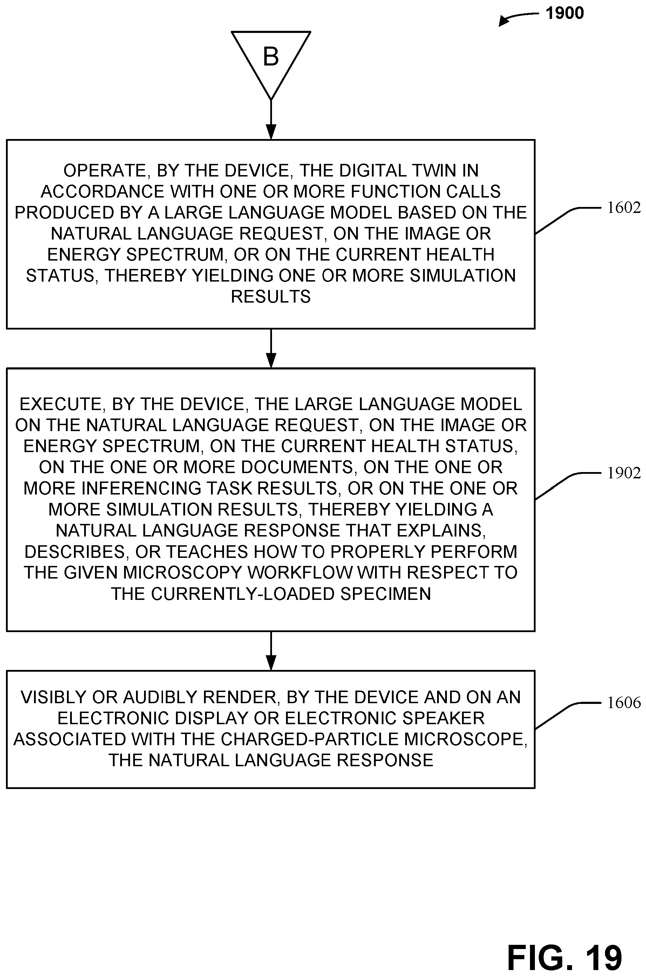

Now, consider FIG. 19. In various instances, act 1602 can be as described above, and the computer-implemented method 1900 can proceed to act 1902. In various cases, act 1902 can include executing, by the device (e.g., via 328), the large language model (e.g., 310) on the natural language request (e.g., 1702), on the image (e.g., 402) or energy spectrum (e.g., 404), on the current health status (e.g., 406), on the one or more documents (e.g., 702), on the one or more inferencing task results (e.g., 704), or on the one or more simulation results (e.g., 706). In various cases, this can cause the large language model to yield a natural language response (e.g., 1302 comprising 1704) that explains, describes, or teaches how to properly perform the given microscopy workflow with respect to the currently-loaded specimen (e.g., 306).

As shown, the computer-implemented method 1900 can proceed to act 1606 as described above.

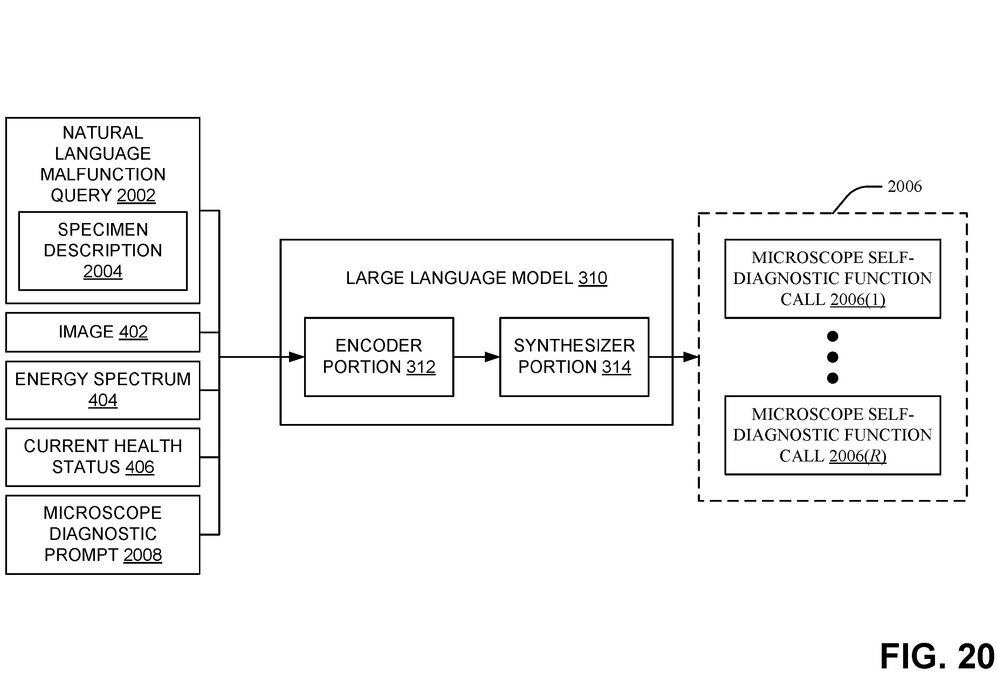

Next, consider FIG. 20. Rather than providing the natural language instruction 308, the user or technician of the charged-particle microscope 302 can instead provide a natural language malfunction query 2002.

In various aspects, the natural language malfunction query 2002 can be any suitable number of plain text or unstructured sentences or sentence fragments that request or command identification of why the charged-particle microscope 302 is experiencing any suitable microscopy malfunction symptom. In some cases, the natural language malfunction query 2002 can comprise a specimen description 2004, which can be one or more unstructured or plain text sentences or sentence fragments that identify at least some known aspect, detail, feature, or property of the currently-loaded specimen 306. As some non-limiting examples, the natural language malfunction query 2002 can be any of the following: "I have a steel sample. Why are my images blurry?"; "I have an organic sample. Why is the microscope throwing error code ABC?"; or "Tell me why the microscope is sounding a buzzer for my printed circuit board sample.".

As above, the natural language malfunction query 2002 can be provided or inputted by the user or technician via any suitable human-computer interface device associated with the charged-particle microscope 302.

Also as above, the state component 324 can electronically obtain, receive, retrieve, or otherwise access the image 402, the energy spectrum 404, or the current health status 406, in response to receipt or accessing of the natural language malfunction query 2002.

Yet also as above, the context component 326 can electronically obtain, receive, retrieve, or otherwise access the set of inferencing task results 704, by respectively executing the set of available deep learning models 1002 on the image 402 or on the energy spectrum 404.

In various aspects, the context component 326 can electronically obtain, receive, retrieve, or otherwise access the set of relevant documents 702 as described with respect to FIGs. 8-9, but with the natural language instruction 308 being replaced by the natural language malfunction query 2002.

Similarly, in various instances, the context component 326 can electronically obtain, receive, retrieve, or otherwise access the set of simulation results 706 as described with respect to FIGs. 11-12, but with the natural language instruction 308 being replaced by the natural language malfunction query 2002. In some of such cases, the digital twin prompt 1102 can be the following sentences: "Specimen characterized by image 402 or energy spectrum 404. Microscope characterized by current health status 406. Design q different experiments for the digital twin 602 to investigate the malfunction symptom specified in the natural language malfunction query 2002."

Furthermore, in some aspects, there can be a microscope diagnostic prompt 2008. In various aspects, the microscope diagnostic prompt 2008 can be one or more unstructured or plain text sentences or sentence fragments that request or command that self-diagnostic protocols or tests (e.g., automated lens or aperture functionality tests, automated electron gun functionality tests) of the charged-particle microscope 302 be run or performed. As a non-limiting example, for any suitable positive integer r, the microscope diagnostic prompt 2008 can be the following sentences: "Specimen characterized by image 402 or energy spectrum 404. Microscope characterized by current health status 406. Instruct the microscope to run the r most relevant self-diagnostic checks to investigate the malfunction specified in the natural language malfunction query 2002."

So, in various instances, the context component 326 can electronically execute the LLM 310 on the natural language malfunction query 2002, on the image 402, on the energy spectrum 404, on the current health status 406, on the microscope diagnostic prompt 2008, or on any suitable combination thereof. In various cases, such execution can cause the LLM 310 to produce a set of microscope self-diagnostic function calls 2006. More specifically, the context component 326 can concatenate the natural language malfunction query 2002, the image 402, the energy spectrum 404, the current health status 406, the microscope diagnostic prompt 2008, or any combination thereof together, and the context component 326 can feed that concatenation to the input layer of the encoder portion 312. In various aspects, that concatenation can complete a forward pass through the one or more hidden layers of the encoder portion 312. In various instances, the output layer of the encoder portion 312 can compute or otherwise calculate one or more embeddings (not shown), based on activation maps or feature maps provided by the one or more hidden layers of the encoder portion 312. In various cases, those one or more embeddings can be routed to the input layer of the synthesizer portion 314. In various aspects, those one or more embeddings can complete a forward pass through the one or more hidden layers of the synthesizer portion 314, and the output layer of the synthesizer portion 314 can compute or otherwise calculate the set of microscope self-diagnostic function calls 2006 based on activation maps or feature maps provided by the one or more hidden layers of the synthesizer portion 314.

In various instances, as mentioned above, the microscope diagnostic prompt 2008 can request or command that *r* distinct self-diagnostic protocols, tests, or checks to be performed by the charged-particle microscope 302. Accordingly, the set of microscope self-diagnostic function calls 2006 can comprise r calls: a microscope self-diagnostic function call 2006(1) to a microscope self-diagnostic function call 2006(r). In various cases, each of the set of microscope self-diagnostic function calls 2006 can be considered as being one or more respective lines of synthesized computer code that is readable by the charged-particle microscope 302 and that invokes or activates (e.g., in whatever syntax is understood by the charged-particle microscope 302, such as JSON code or Python code) a respective self-diagnostic check or test that is performable by the charged-particle microscope 302. As a non-limiting example, the microscope self-diagnostic function call 2006(1) can be one or more first lines of synthesized computer code that invokes a first self-diagnostic check that can be run on the charged-particle microscope 302 (e.g., an automated focusing lens self-check protocol). As another non-limiting example, the microscope self-diagnostic function call 2006(r) can be one or more r-th lines of synthesized computer code that defines an r-th self-diagnostic check that can be run on the charged-particle microscope 302 (e.g., an automated gas injector self-check protocol).

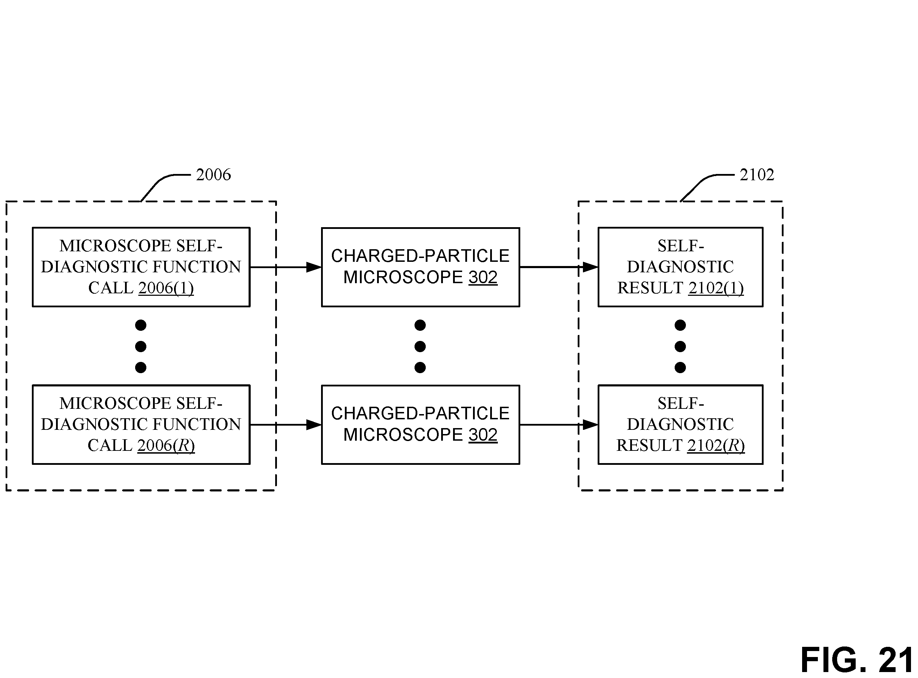

Next, consider FIG. 21. In various embodiments, the context component 326 can electronically instruct, command, or otherwise cause the charged-particle microscope 302 to run, perform, or execute each of the set of microscope self-diagnostic function calls 2006, thereby yielding a set of self-diagnostic results 2102.

As a non-limiting example, the context component 326 can cause the charged-particle microscope 302 to execute the microscope self-diagnostic function call 2006(1). That is, the context component 326 can cause the charged-particle microscope 302 to automatically initiate, perform, or conduct the first self-diagnostic check that is defined by the microscope self-diagnostic function call 2006(1). In various aspects, such first self-diagnostic check can yield a self-diagnostic result 2102(1), where the self-diagnostic result 2102(1) can be one or more scalars, one or more vectors, one or more matrices, one or more tensors, one or more character strings, or any suitable combination thereof that the charged-particle microscope 302 measures or returns during or in response to performance of the first self-diagnostic check.

As another non-limiting example, the context component 326 can cause the charged-particle microscope 302 to execute the microscope self-diagnostic function call 2006(r). That is, the context component 326 can cause the charged-particle microscope 302 to automatically initiate, perform, or conduct the r-th self-diagnostic check that is defined by the microscope self-diagnostic function call 2006(r). Just as above, such r-th self-diagnostic check can yield a self-diagnostic result 2102(r), where the self-diagnostic result 2102(r) can be one or more scalars, one or more vectors, one or more matrices, one or more tensors, one or more character strings, or any suitable combination thereof that the charged-particle microscope 302 measures or returns during or in response to performance of the r-th self-diagnostic check.

In various cases, the self-diagnostic result 2102(1) to the self-diagnostic result 2102(r) can collectively be considered as the set of self-diagnostic results 2102.

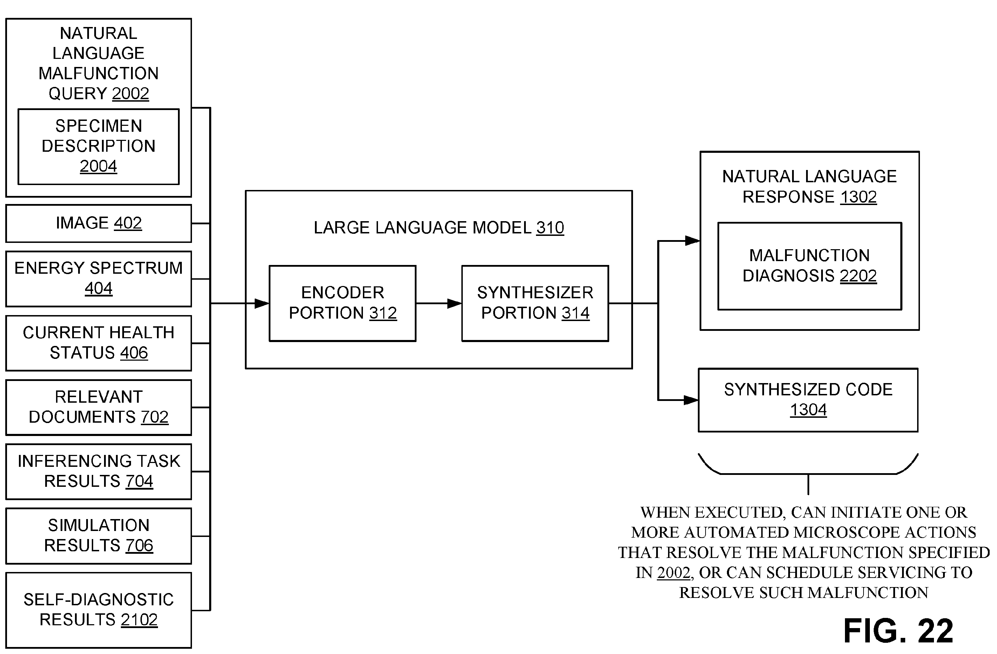

Now, consider FIG. 22. In various aspects, the model component 328 can electronically execute the LLM 310 on a concatenation of the natural language malfunction query 2002, the image 402, the energy spectrum 404, the current health status 406, the set of relevant documents 702, the set of inferencing task results 704, the set of simulation results 706, or the set of self-diagnostic results 2102, and such execution can cause the LLM 310 to produce the natural language response 1302 or the synthesized code 1304.

In such embodiments, the natural language response 1302 can comprise a malfunction diagnosis 2202. In various aspects, the malfunction diagnosis 2202 can be one or more unstructured or plain text declarative sentences or sentence fragments that semantically answer the natural language malfunction query 2002. That is, the malfunction diagnosis 2202 can be synthesized text that describes, states, or explains what seems to be causing the charged-particle microscope 302 to experience the particular microscopy malfunction symptom that is specified in the natural language malfunction query 2002. In various instances, the specimen description 2004 can be considered as known information regarding the currently-loaded specimen 306. In contrast, the image 402 or the energy spectrum 404 (or any of their supplemental or contextual information, such as 702, 704, 706, or 2102) can be considered as measured or detected information regarding the currently-loaded specimen 306. In some cases, an inconsistency, mismatch, or other interrelationship between that known information and that measured or detected information can inform or otherwise suggest what may be causing a specific problem of the charged-particle microscope 302. Accordingly, the LLM 310 can be considered as leveraging such inconsistency, mismatch, or interrelationship so as to infer or predict a cause of the particular malfunction symptom specified in the natural language malfunction query 2002. In various instances, the malfunction diagnosis 2202 can describe or explain not just a cause of whatever malfunction symptom is specified in the natural language malfunction query 2002, but can also describe or explain what sequence of steps should be taken to resolve such malfunction symptom.

As a non-limiting example, suppose that the natural language malfunction query 2002 asks why the charged-particle microscope 302 is generating blurry images of an organic sample. Moreover, suppose that organic samples must first be dehydrated prior analysis by charged-particle microscopes, so as to avoid the occurrence of condensation artifacts. As mentioned above, the specimen description 2004 in this non-limiting example can indicate that the currently-loaded specimen 306 is organic. Because the LLM 310 can be conditioned on such information, the LLM 310 can infer or predict that the currently-loaded specimen 306 needs to be dehydrated prior to microscopy analysis. Now, in some cases, the image 402 or the energy spectrum 404 can contain artifacts or abnormalities that are normally, frequently, or otherwise often associated with lens condensation. Accordingly, the LLM 310 can determine or conclude that the currently-loaded specimen 306 did not receive its required dehydration prior to analysis. So, the LLM 310 can accordingly synthesize the malfunction diagnosis 2202 to state or explain that failure to dehydrate the currently-loaded specimen 306 is causing the particular microscopy malfunction specified in the natural language malfunction query 2002. In some cases, the malfunction diagnosis 2202 can further explain how such malfunction can be resolved (e.g., by wiping or drying the lenses of the charged-particle microscope 302, and by applying a dehydrating protocol to the currently-loaded specimen 306). As above, note that the set of relevant documents 702, the set of inferencing task results 704, the set of simulation results 706, or the set of self-diagnostic results 2102 can be considered as additional, supplemental, contextual, or otherwise enriching information that aids or assists the LLM 310 in correctly or accurately synthesizing the malfunction diagnosis 2202 (e.g., in correctly or accurately inferring or predicting what is causing the particular malfunction symptom or how to solve it).

In various aspects, as mentioned above, the LLM 310 can generate the synthesized code 1304 in addition to (or, in some cases, instead of) the natural language response 1302. Also as mentioned above, the synthesized code 1304 can be one or more lines of computer code that can (upon execution, running, or compilation) perform any suitable computerized action with respect to the charged-particle microscope 302 or with respect to the natural language response 1302. As a non-limiting example, in situations where the natural language response 1302 comprises the malfunction diagnosis 2202, the LLM 310 might infer or predict that the sequential performance of one or more automated actions of the charged-particle microscope 302 (e.g., automated lens drying or wiping, automated electron gun reboot, automated gas injector cycling) can or would solve or rectify the malfunction symptom specified in the natural language malfunction query 2002. In such cases, execution of the synthesized code 1304 can cause the charged-particle microscope 302 to perform such sequence of automated actions, thereby resolving the particular malfunction symptom. In other cases, however, the LLM 310 might instead infer or predict that manual intervention or servicing is required to resolve the particular malfunction symptom. In such case, execution of the synthesized code 1304 can cause such manual intervention or servicing to be scheduled or otherwise flagged (e.g., can automatically insert a maintenance request for the charged-particle microscope 302 into an electronic servicing calendar or database).

As above, the presenter component 330 can electronically perform any suitable actions with respect to the natural language response 1302 or with respect to the synthesized code 1304, such as visually rendering or audibly playing the natural language response 1302. In some cases, the presenter component 330 can electronically execute, run, or compile the synthesized code 1304, thereby automatically resolving the particular malfunction symptom or otherwise automatically scheduling a service call to address the particular malfunction symptom. Accordingly, even if the user or technician is unskilled or untrained in the field of charged-particle microscopy, the user or technician can nevertheless competently address or handle malfunctions of the charged-particle microscope 302. In this way, the system 316 can be considered as providing real-time, specimen-conditioned troubleshooting guidance to the user or technician.

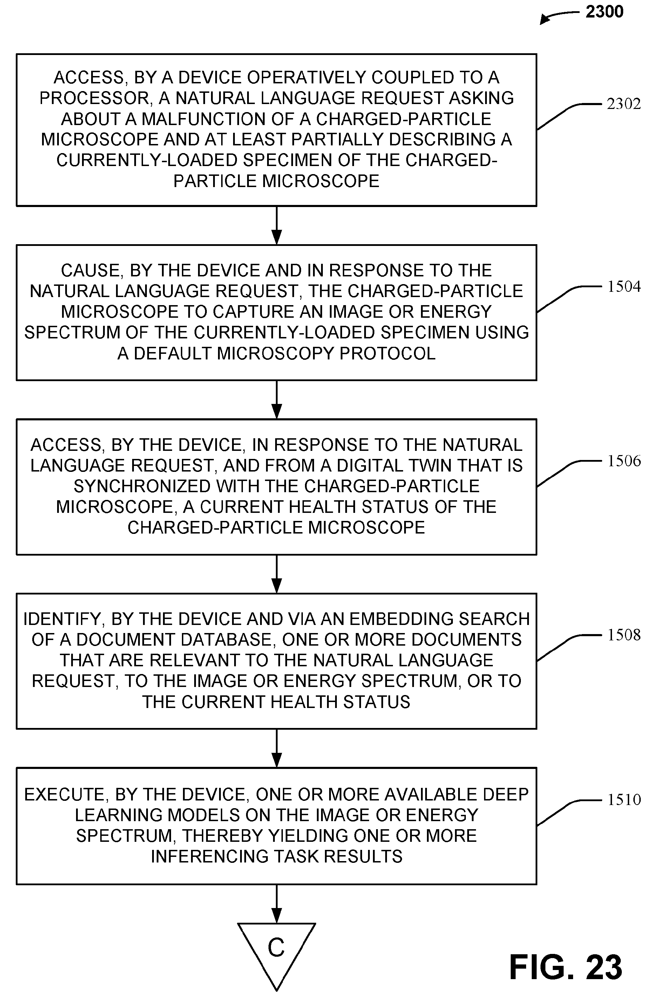

FIGs. 23-24 illustrate example, non-limiting flow diagrams of computer-implemented methods in accordance with one or more embodiments described herein.

First, consider FIG. 23. In various embodiments, act 2302 can include accessing, by a device (e.g., via 322) operatively coupled to a processor (e.g., 318), a natural language request (e.g., 2002) asking about a malfunction of a charged-particle microscope (e.g., 302) and at least partially describing a currently-loaded specimen (e.g., 306) of the charged-particle microscope.

In various aspects, as shown, the computer-implemented method 2300 can then proceed to acts 1504, 1506, 1508, and 1510, as described above. The computer-implemented method 2300 can then proceed to act 1602 of the computer-implemented method 2400.

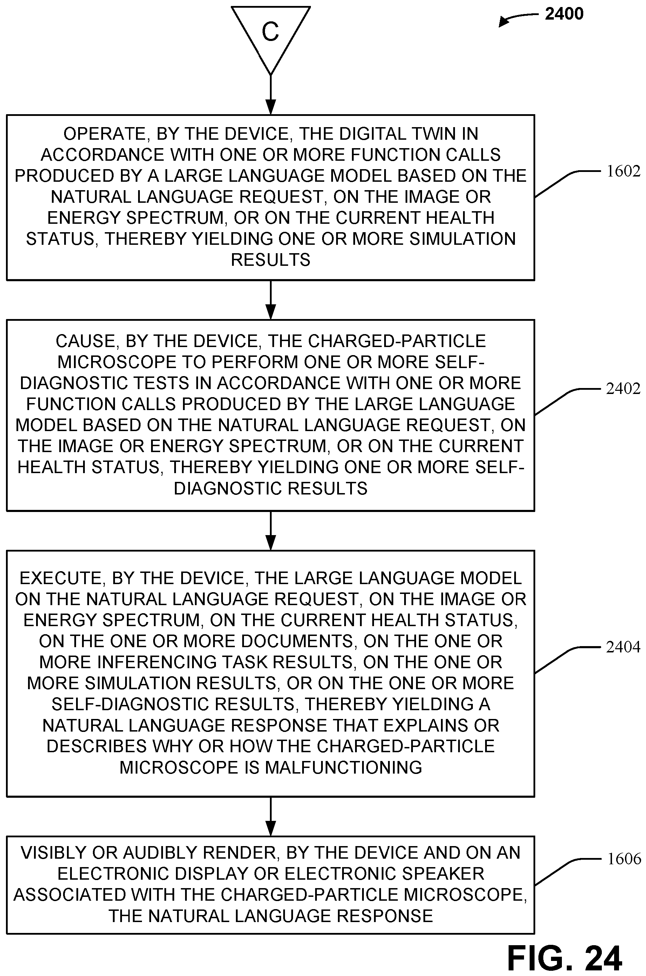

Now, consider FIG. 24. In various instances, act 1602 can be as described above, and the computer-implemented method 2400 can proceed to act 2402. In various cases, act 2402 can include causing, by the device (e.g., via 326), the charged-particle microscope to perform one or more self-diagnostic tests in accordance with one or more function calls (e.g., 2006) produced by the large language model (e.g., 310) based on the natural language request, on the image or energy spectrum, on the current health status. In various cases, this can cause the charged-particle microscope to yield one or more self-diagnostic results (e.g., 2102).

In various aspects, act 2404 can include executing, by the device (e.g., via 328), the large language model on the natural language request (e.g., 2002), on the image (e.g., 402) or energy spectrum (e.g., 404), on the current health status (e.g., 406), on the one or more documents (e.g., 702), on the one or more inferencing task results (e.g., 704), on the one or more simulation results (e.g., 706), or on the one or more self-diagnostic results (e.g., 2102). In various cases, this can cause the large language model to yield a natural language response (e.g., 1302 comprising 2202) that explains, describes, or teaches why or how the charged-particle microscope is malfunctioning.

As shown, the computer-implemented method 2400 can then proceed to act 1606.

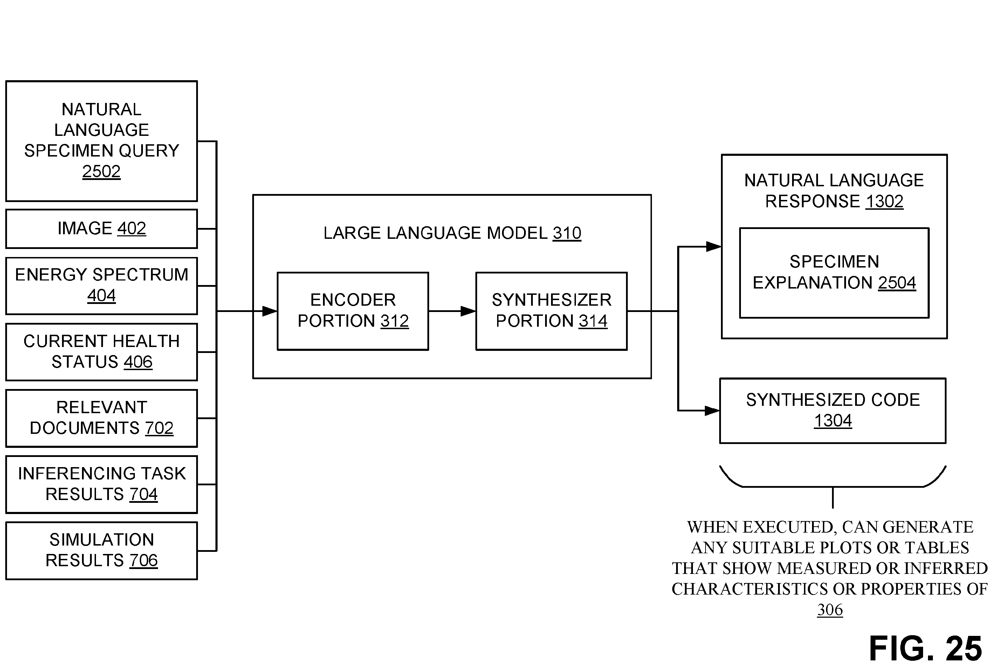

Now, consider FIG. 25. Rather than providing the natural language instruction 308, the user or technician of the charged-particle microscope 302 can instead provide a natural language specimen query 2502.

In various aspects, the natural language specimen query 2502 can be any suitable number of plain text or unstructured sentences or sentence fragments that request or command identification of any suitable physical, chemical, or compositional attribute of the currently-loaded specimen 306. As some non-limiting examples, the natural language specimen query 2502 can be any of the following: "What is the chemical makeup of this specimen?"; "Tell me the crystalline structure of this specimen."; or "What is the melting point of this specimen?".

As above, the natural language specimen query 2502 can be provided or inputted by the user or technician of the charged-particle microscope 302 via any suitable human-computer interface device associated with the charged-particle microscope 302.

Also as above, the state component 324 can electronically obtain, receive, retrieve, or otherwise access the image 402, the energy spectrum 404, or the current health status 406, in response to receipt or accessing of the natural language specimen query 2502.

Yet also as above, the context component 326 can electronically obtain, receive, retrieve, or otherwise access the set of inferencing task results 704, by respectively executing the set of available deep learning models 1002 on the image 402 or on the energy spectrum 404.

In various aspects, the context component 326 can electronically obtain, receive, retrieve, or otherwise access the set of relevant documents 702 as described with respect to FIGs. 8-9, but with the natural language instruction 308 being replaced by the natural language specimen query 2502.

Likewise, in various instances, the context component 326 can electronically obtain, receive, retrieve, or otherwise access the set of simulation results 706 as described with respect to FIGs. 11-12, but with the natural language instruction 308 being replaced by the natural language specimen query 2502. In some of such cases, the digital twin prompt 1102 can be the following sentences: "Specimen characterized by image 402 or energy spectrum 404. Microscope characterized by current health status 406. Design q different experiments for the digital twin 602 to best determine the specimen attribute identified in the natural language specimen query 2502."

So, in various aspects, the model component 328 can electronically execute the LLM 310 on a concatenation of the natural language specimen query 2502, the image 402, the energy spectrum 404, the current health status 406, the set of relevant documents 702, the set of inferencing task results 704, or the set of simulation results 706, and such execution can cause the LLM 310 to produce the natural language response 1302 or the synthesized code 1304.

In such embodiments, the natural language response 1302 can comprise a specimen explanation 2504. In various aspects, the specimen explanation 2504 can be one or more unstructured or plain text declarative sentences or sentence fragments that semantically answer the natural language specimen query 2502. That is, the specimen explanation 2504 can be synthesized text that describes, states, or lists (e.g., as bullet points) whatever physical, chemical, or compositional attributes of the currently-loaded specimen 306 are requested by the natural language specimen query 2502. Indeed, as mentioned above, the image 402 or the energy spectrum 404 can be considered as conveying at least some information regarding the chemical, physical, or compositional properties of the currently-loaded specimen 306. Because the LLM 310 can be conditioned on the image 402 or the energy spectrum 404, the LLM 310 can be considered as having access to that chemical, physical, or compositional information and can leverage that information to infer or predict an answer for the natural language specimen query 2502. The LLM 310 can accordingly synthesize the specimen explanation 2504 to state, describe, or list whatever properties, characteristics, or attributes of the currently-loaded specimen 306 are asked for by the natural language specimen query 2502. As above, note that the set of relevant documents 702, the set of inferencing task results 704, or the set of simulation results 706 can be considered as additional, supplemental, contextual, or otherwise enriching information that aids or assists the LLM 310 in correctly or accurately synthesizing the specimen explanation 2504 (e.g., in correctly or accurately inferring or predicting the requested attribute of the currently-loaded specimen 306).

In various aspects, as mentioned above, the LLM 310 can generate the synthesized code 1304 in addition to (or, in some cases, instead of) the natural language response 1302. Also as mentioned above, the synthesized code 1304 can be one or more lines of computer code that can (upon execution, running, or compilation) perform any suitable computerized action with respect to the charged-particle microscope 302 or with respect to the natural language response 1302. As a non-limiting example, in situations where the natural language response 1302 comprises the specimen explanation 2504, execution of the synthesized code 1304 can cause an electronic display of the charged-particle microscope 302 (or of any suitable computerized workstation associated with the charged-particle microscope 302) to display or render any suitable plots, tables, or other graphics showing any properties, characteristics, or attributes of the currently-loaded specimen 306 that the LLM 310 has measured or inferred.

As above, the presenter component 330 can electronically perform any suitable actions with respect to the natural language response 1302 or with respect to the synthesized code 1304, such as visually rendering or audibly playing the natural language response 1302. In some cases, the presenter component 330 can electronically execute, run, or compile the synthesized code 1304, thereby displaying various charts, tables, graphs, or plots regarding the currently-loaded specimen 306. Accordingly, even if the user or technician is unskilled or untrained in the field of charged-particle microscopy, the user or technician can nevertheless leverage the charged-particle microscope 302 to competently analyze the currently-loaded specimen 306. In this way, the system 316 can be considered as providing real-time, automated specimen analysis for the user or technician.

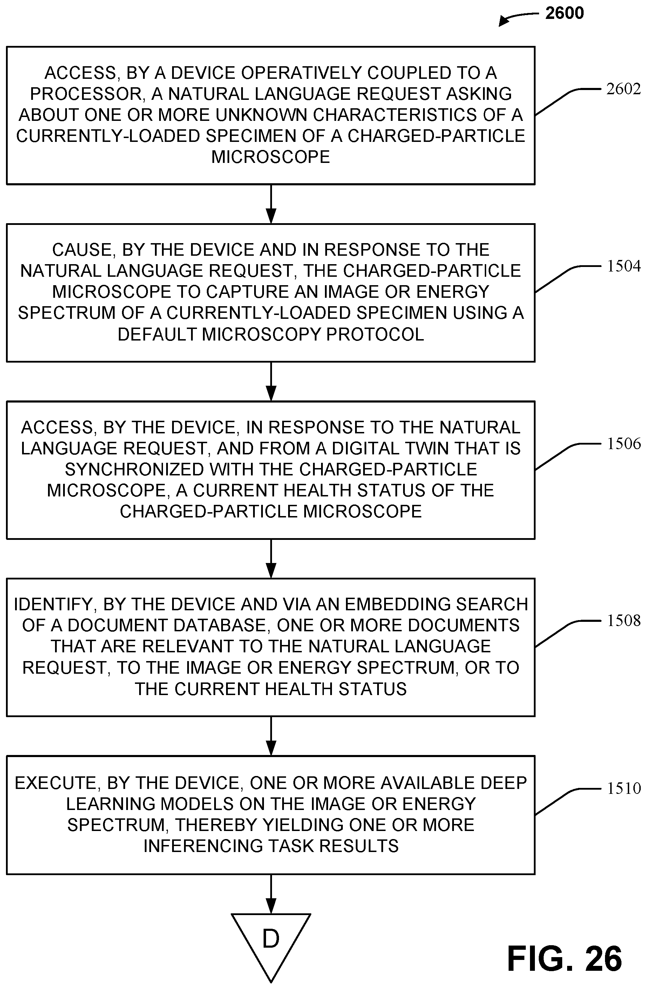

FIGs. 26-27 illustrate example, non-limiting flow diagrams of computer-implemented methods in accordance with one or more embodiments described herein.

First, consider FIG. 26. In various embodiments, act 2602 can include accessing, by a device (e.g., via 322) operatively coupled to a processor (e.g., 318), a natural language request (e.g., 2502) asking about one or more unknown characteristics of a currently-loaded specimen (e.g., 306) of a charged-particle microscope (e.g., 302).

In various aspects, as shown, the computer-implemented method 2600 can proceed to acts 1504, 1506, 1508, and 1510, as described above. The computer-implemented method 2600 can then proceed to act 1602 of the computer-implemented method 2700.

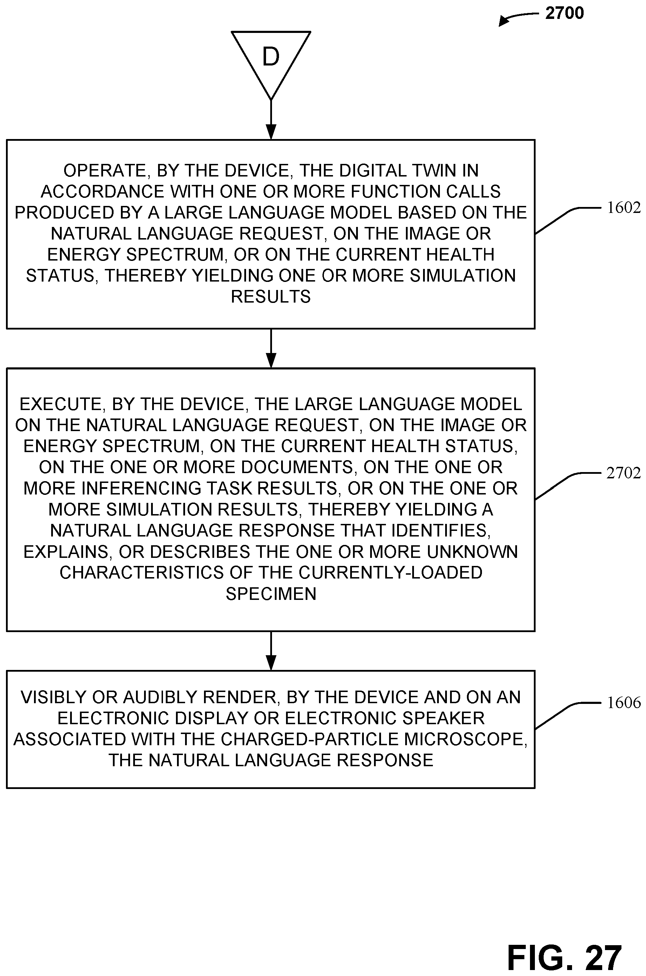

Now, consider FIG. 27. In various instances, act 1602 can be as described above, and the computer-implemented method 2700 can proceed to act 2702. In various cases, act 2702 can include executing, by the device (e.g., via 328), the large language model (e.g., 310) on the natural language request (e.g., 1702), on the image (e.g., 402) or energy spectrum (e.g., 404), on the current health status (e.g., 406), on the one or more documents (e.g., 702), on the one or more inferencing task results (e.g., 704), or on the one or more simulation results (e.g., 706). In various cases, this can cause the large language model to yield a natural language response (e.g., 1302 comprising 2504) that identifies, explains, or describes the one or more unknown characteristics of the currently-loaded specimen.

As shown, the computer-implemented method 2600 can then proceed to act 1606.

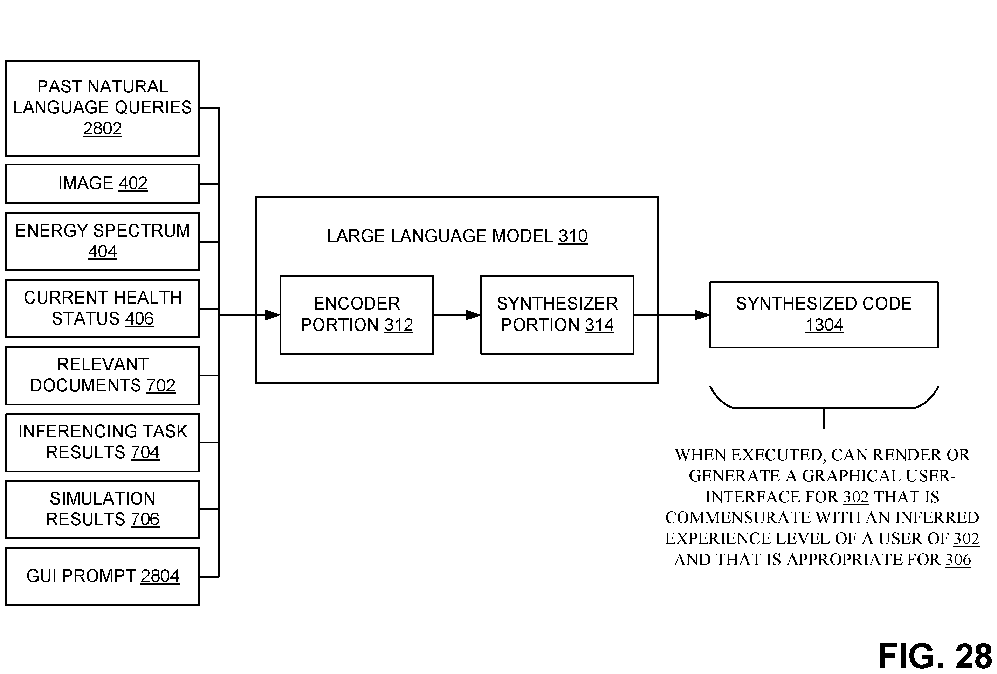

Next, consider FIG. 28. In various aspects, the user or technician of the charged-particle microscope 302 can have previously provided (e.g., typed or spoken) to the charged-particle microscope 302 a plurality of past natural language queries 2802. In various instances, the plurality of past natural language queries 2802 can comprise any suitable number of past natural language queries. In various cases, a past natural language query can be any suitable unstructured or plain text query as described herein (e.g., can be an instruction to set any of 304 to particular values; can be a workflow query; can be a malfunction query; can be a specimen query).

As above, the state component 324 can electronically obtain, receive, retrieve, or otherwise access the image 402, the energy spectrum 404, or the current health status 406.

Also as above, the context component 326 can electronically obtain, receive, retrieve, or otherwise access the set of inferencing task results 704, by respectively executing the set of available deep learning models 1002 on the image 402 or on the energy spectrum 404.

Yet also as above, the context component 326 can electronically obtain, receive, retrieve, or otherwise access the set of relevant documents 702, by performing an appropriate embedding search through the document repository 902 (e.g., by replacing 308 with 2802 in FIG. 8).

Still also as above, the context component 326 can electronically obtain, receive, retrieve, or otherwise access the set of simulation results 706, by using the LLM 310 to generate appropriate function calls to the digital twin 602 (e.g., by replacing 308 with 2802 in FIG. 11).

Now, in various aspects, there can be a GUI prompt 2804. In various instances, the GUI prompt 2804 can be one or more unstructured or plain text sentences or sentence fragments that request or command that a graphical user-interface (GUI) be constructed for the charged-particle microscope 302 that is suitable for both the user or technician and the currently-loaded specimen 306. As a non-limiting example, the GUI prompt 2804 can be the following sentences: "Specimen characterized by image 402 or energy spectrum 404. Microscope characterized by current health status 406. Create a microscope GUI that is relevant to the specimen and that is appropriate for a user who has asked the plurality of past natural language queries 2802."

So, in various aspects, the model component 328 can electronically execute the LLM 310 on a concatenation of the plurality of past natural language queries 2802, the image 402, the energy spectrum 404, the current health status 406, the set of relevant documents 702, the set of inferencing task results 704, or the set of simulation results 706, and such execution can cause the LLM 310 to produce the synthesized code 1304 (in some embodiments, the natural language response 1302 can be omitted).

In various aspects, the synthesized code 1304 can be one or more lines of computer code that can (upon execution, running, or compilation) perform any suitable computerized action with respect to the charged-particle microscope 302. As a non-limiting example, the synthesized code 1304 can define or otherwise serve as the source code or programming script for a specimen-tailored and user-tailored GUI of the charged-particle microscope 302.

In particular, it is possible that various of the plurality of configurable operating settings 304 are relevant or appropriate for some types of specimens but irrelevant or inappropriate for other types of specimens. For instance, the realm of possible microscopy protocols or settings that can be non-destructively or efficaciously applied to inorganic specimens might be different or otherwise non-identical to the realm of possible microscopy protocols or settings that can be non-destructively or efficaciously applied to organic specimens. As another instance, the realm of possible microscopy protocols or settings that can be non-destructively or efficaciously applied to metal specimens might be different or otherwise non-identical to the realm of possible microscopy protocols or settings that can be non-destructively or efficaciously applied to plastic specimens. In any case, the image 402 or the energy spectrum 404 can be considered as conveying at least some physical, chemical, or compositional information regarding the currently-loaded specimen 306. Because the LLM 310 can be conditioned on the image 402 or the energy spectrum 404, the LLM 310 can use that information to infer or predict which of the plurality of configurable operating settings 304 are relevant to or appropriate for the currently-loaded specimen 306 and which are not. Accordingly, the LLM 310 can create the synthesized code 1304 such that it defines or creates a GUI that contains or displays only those of the plurality of configurable operating settings 304 that are relevant to or appropriate for the currently-loaded specimen 306, and contains or displays none of the plurality of configurable operating settings 304 that are irrelevant to or inappropriate for the currently-loaded specimen 306. In this way, the GUI defined by the synthesized code 1304 can be considered as being tailored or customized to the currently-loaded specimen 306.

Additionally, it is possible that various of the plurality of configurable operating settings 304 are far too advanced or complicated for inexperienced, untrained, or unskilled users or technicians. In various cases, the plurality of past natural language queries 2802 can be considered as implicitly conveying or capturing a microscopy skill level of the user or technician. For instance, a history of asking more basic or simplistic queries can indicate that the user or technician has less microscopy skill, whereas a history of asking more complex or sophisticated queries can indicate that the user or technician instead has more microscopy skill. Because the LLM 310 can be conditioned on the plurality of past natural language queries 2802, the LLM 310 can use that implicit information to infer or predict a microscopy skill or experience level of the user or technician. Thus, the LLM 310 can identify which of the plurality of configurable operating settings 304 are commensurate or appropriate for the inferred microscopy skill or experience level and which are too advanced for the inferred microscopy skill or experience level. Accordingly, the LLM 310 can create the synthesized code 1304 such that it defines or creates a GUI that contains or displays only those of the plurality of configurable operating settings 304 that are appropriate or not too complicated for the inferred microscopy skill or experience level of the user or technician, and contains or displays none of the plurality of configurable operating settings 304 that are inappropriate or too complicated for the inferred microscopy skill or experience level of the user or technician. In this way, the GUI defined by the synthesized code 1304 can be considered as being tailored or customized to the user or technician.

Furthermore, it is possible that various of the plurality of configurable operating settings 304 are not presently safely invokable, activatable, or changeable, given the current health status 406. For instance, perhaps some components of the charged-particle microscope 302 are too worn to properly perform certain protocols or to safely adjust certain settings. Because the LLM 310 can be conditioned on the current health status 406, the LLM 310 can infer or predict which of the plurality of configurable operating settings 304 are not presently safely invokable, activatable, or changeable. Accordingly, the LLM 310 can create the synthesized code 1304 such that it defines or creates a GUI that contains or displays only those of the plurality of configurable operating settings 304 that are presently safely invokable, activatable, or changeable, and contains or displays none of the plurality of configurable operating settings 304 that are not presently safely invokable, activatable, or changeable. In this way, the GUI defined by the synthesized code 1304 can be considered as being tailored or customized based on a present-time health of the charged-particle microscope 302.

As above, the presenter component 330 can electronically perform any suitable actions with respect to the synthesized code 1304. In some cases, the presenter component 330 can electronically execute, run, or compile the synthesized code 1304, thereby rendering or activating the tailored or customized GUI for the charged-particle microscope 302. Accordingly, even wide varieties of users or technicians can intuitively or comfortably interact with the charged-particle microscope 302, regardless of their idiosyncratic or disparate microscopy skill levels.

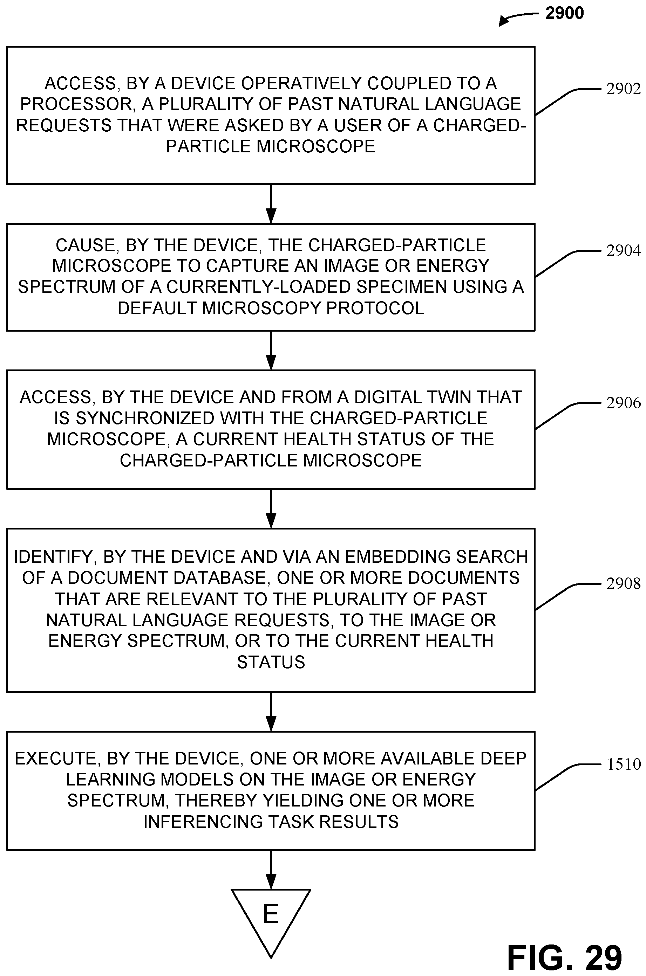

FIGs. 29-30 illustrate example, non-limiting flow diagrams of computer-implemented methods in accordance with one or more embodiments described herein.

First, consider FIG. 29. In various embodiments, act 2902 can include accessing, by a device (e.g., via 322) operatively coupled to a processor (e.g., 318), a plurality of past natural language requests (e.g., 2802) that were asked by a user of a charged-particle microscope (e.g., 302).

In various aspects, act 2904 can include causing, by the device (e.g., via 324), the charged-particle microscope to capture an image (e.g., 402) or energy spectrum (e.g., 404) of a currently-loaded specimen (e.g., 306) using a default microscopy protocol.

In various instances, act 2906 can include accessing, by the device (e.g., via 324) and from a digital twin (e.g., 602) that is synchronized with the charged-particle microscope, a current health status (e.g., 406) of the charged-particle microscope.

In various cases, act 2908 can include identifying, by the device (e.g., via 326) and via an embedding searching of a document database (e.g., 902), one or more documents (e.g., 702) that are relevant to the plurality of past natural language requests, to the image or energy spectrum, or to the current health status.

In various aspects, the computer-implemented method 2900 can proceed act 1510, as described above, and then to act 3002 of the computer-implemented method 3002.

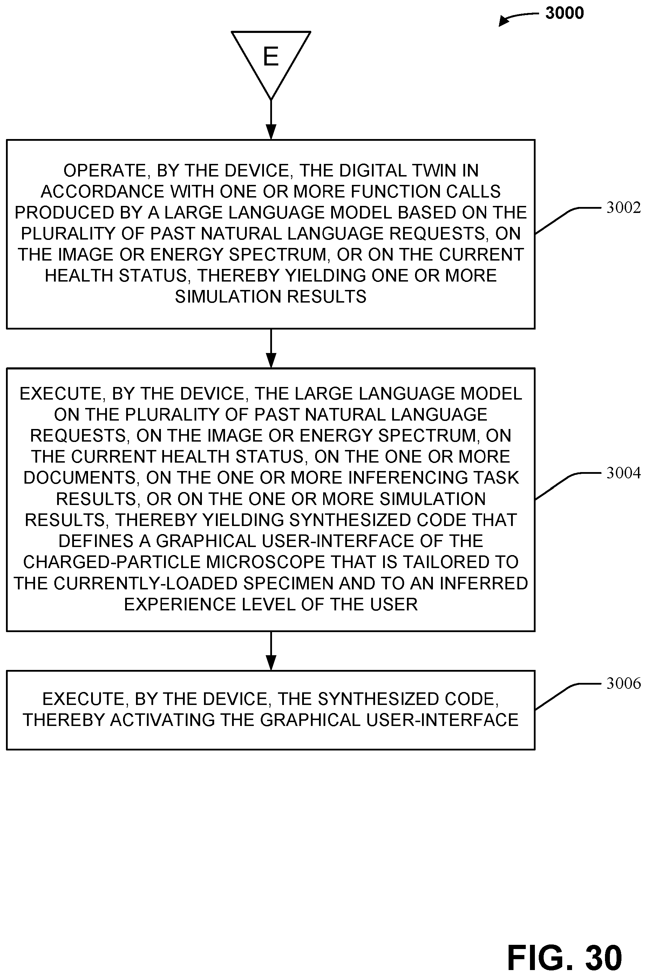

Now consider FIG. 30. In various embodiments, act 3002 can include operating, by the device (e.g., via 326), the digital twin in accordance with one or more function calls (e.g., 1104) produced by a large language model (e.g., 310) based on the plurality of past natural language requests, on the image or energy spectrum, or on the current health status. In various cases, this can cause the digital twin to yield one or more simulation results (e.g., 706).

In various aspects, act 3004 can include executing, by the device (e.g., via 328), the large language model on the plurality of past natural language requests, on the image or energy spectrum, on the current health status, on the one or more documents, on the one or more inferencing task results, or on the one or more simulation results. In various cases, this can cause the large language model to yield synthesized code (e.g., 1304) that defines a graphical user-interface of the charged-particle microscope that is tailored to the currently-loaded specimen and that is also tailored to an inferred experience level of the user.

In various instances, act 3006 can include executing, by the device (e.g., via 330), the synthesized code. In various cases, this can activate or otherwise present to the user the graphical user-interface.

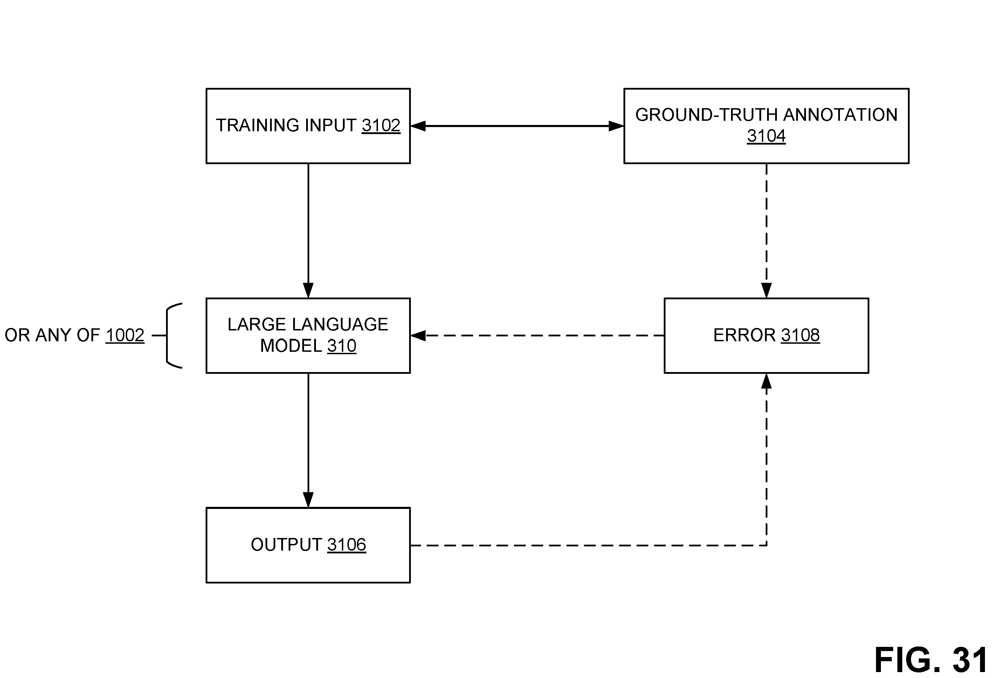

In order for the natural language response 1302 or the synthesized code 1304 to be accurate or correct in accordance with various embodiments described herein, the LLM 310 (as well as the set of available deep learning models 1002) can first undergo training. A non-limiting example of such training is described with respect to FIG. 31.

FIG. 31 illustrates an example, non-limiting block diagram showing how the LLM 310 (or each of the set of available deep learning models 1002) can be trained in accordance with one or more embodiments described herein.

In various aspects, prior to beginning training, the trainable internal parameters (e.g., convolutional kernels, weight matrices, bias values) of the LLM 310 (or of any of the set of deep learning models 1002) can be initialized in any suitable fashion (e.g., via random initialization) by the system 316.

In various embodiments, there can be a training input 3102 and a ground-truth annotation 3104. When it is desired to train the LLM 310, the training input 3102 can be any suitable textual, numerical, or graphical data that can be received by the LLM 310 as described herein. As some mere non-limiting examples, the training input 3102 can be any suitable natural language instruction, question, command, or query (e.g., such as any of 308, 1702, 2002, 2502, or 2802), which may or may not be concatenated with any suitable images (e.g., such 402), any suitable energy spectra (e.g., such as 404), any suitable microscope health statuses (e.g., such as 406), any suitable relevant documents (e.g., such as 702), any suitable inferencing task results (e.g., such as 704), any suitable digital twin simulation results (e.g., such as 706), any suitable microscope self-diagnostic results (e.g., such as 2102), or any suitable supplemental prompts (e.g., such as 1102, 1401, 2008, or 2804). In such case, the ground-truth annotation 3104 can be whatever correct or accurate synthesized textual content (e.g., such as 1302) or code (e.g., such as 1304) that is known or deemed to correspond to the training input 3102. Instead, when it is desired to train any of the set of available deep learning models 1002, the training input 3102 can be any suitable training image or training energy spectrum (or a concatenation thereof), and the ground-truth annotation 3104 can be whatever correct or accurate inferencing task result (e.g., correct or accurate classification label, correct or accurate segmentation mask, correct or accurate regression output) that is known or deemed to correspond to the training input 3102.

In any case, the system 316 can cause the LLM 310 (or any of the set of available deep learning models 1002) to be executed on the training input 3102, thereby causing the LLM 310 (or any of the set of available deep learning models 1002) to produce an output 3106. More specifically, in some cases, the training input 3102 can be fed or routed to the input layer of the LLM 310 (or of any of the set of available deep learning models 1002), the training input 3102 can complete a forward pass through the one or more hidden layers of the LLM 310 (or of any of the set of available deep learning models 1002), and the output layer of the LLM 310 (or of any of the set of available deep learning models 1002) can compute the output 3106 based on activation maps or feature maps provided by the one or more hidden layers of the LLM 310 (or of any of the set of available deep learning models 1002).

Note that the format, size, or dimensionality of the output 3106 can be dictated by the number, arrangement, sizes, or other characteristics of the neurons, convolutional kernels, attention blocks, or other internal parameters of the output layer (or of any other layers) of the LLM 310 (or any of the set of available deep learning models 1002). Accordingly, the output 3106 can be forced to have any desired format, size, or dimensionality, by adding, removing, or otherwise adjusting characteristics of the output layer (or of any other layers) of the LLM 310 (or of any of the set of available deep learning models 1002).

In various aspects, if the output 3106 is produced by the LLM 310, the output 3106 can be considered as the predicted or inferred textual content (e.g., predicted or inferred natural language response, predicted or inferred synthesized code, predicted or inferred function calls) that the LLM 310 has synthesized based on the training input 3102. Instead, if the output 3106 is produced by any of the set of available deep learning models 1002, the output 3106 can be considered as the predicted or inferred inferencing task result (e.g., predicted or inferred classification label, predicted or inferred segmentation mask, predicted or inferred regression output) that such available deep learning model has produced for the training input 3102. In any case, the ground-truth annotation 3104 can be considered as whatever correct or accurate result that is known or deemed to correspond to the training input 3102. Note that, if the LLM 310 (or any of the set of available deep learning models 1002) has so far undergone no or little training, then the output 3106 can be highly inaccurate. In other words, the output 3106 can be very different from the ground-truth annotation 3104.

In various aspects, an error 3108 (e.g., MAE, MSE, cross-entropy error) between the output 3106 and the ground-truth annotation 3104 can be computed by the system 316. In various instances, the trainable internal parameters of the LLM 310 (or of any of the set of available deep learning models 1002) can be incrementally updated via backpropagation (e.g., stochastic gradient descent) based on the error 3108.

In various cases, such execution-and-update procedure can be repeated for any suitable number input-annotation pairs. This can ultimately cause the trainable internal parameters of the LLM 310 (or the set of available deep learning models 1002) to become iteratively optimized for accurately performing text synthesis or code synthesis (or for accurately performing any other suitable inferencing task such as image or spectrum classification, segmentation, or regression). In various aspects, any suitable training batch sizes, any suitable error/loss functions, or any suitable training termination criteria can be utilized during such training.

Although the herein disclosure mainly describes the LLM 310 (or the set of available deep learning models 1002) as being trained in supervised fashion, this is a mere non-limiting example for ease of explanation and illustration. In various embodiments, any other suitable training paradigms can be used to train the LLM 310 or the set of available deep learning models 1002, such as unsupervised training or reinforcement learning, any of which may be federated or unfederated.

Although the herein disclosure mainly describes the LLM 310 as being trained or configured to synthesize the natural language response 1302 or the synthesized code 1304, these are mere non-limiting examples for ease of illustration and explanation. In various embodiments, the LLM 310 can be configured to synthesize any suitable visual graphics that can supplement the natural language response 1302. Non-limiting examples of such visual graphics can include: formatted reports or presentation slides that are based on, that are derived from, or that expound upon the natural language response 1302; or plots, graphs, or charts that are based on, that are derived from, or that expound upon the natural language response 1302. Accordingly, the presenter component 330 can visually render such visual graphics in addition to or otherwise in conjunction with the natural language response 1302.

Although the herein disclosure mainly describes the presenter component 330 as visually or audibly rendering or presenting the natural language response 1302 (or any associated visual graphics) to the user or technician of the charged-particle microscope 302, these are mere non-limiting examples for ease of explanation and illustration. In various embodiments, the presenter component 330 can electronically transmit the natural language response 1302 (or any associated visual graphics, or the synthesized code 1304) to any suitable computing device that is associated with the charged-particle microscope. As a non-limiting example, the presenter component 330 can share the natural language response 1302 (or any associated visual graphics, or the synthesized code 1304) with any suitable downstream software tools or applications that operate for or in conjunction with the charged-particle microscope 302 (e.g., some embodiments can involve sending the natural language response 1302 to such downstream software tools or applications rather than presenting the natural language response 1302 to the user or technician).

Although the herein disclosure mainly describes the LLM 310 as receiving natural language inputs (e.g., 308, 1702, 2002, 2502, 2802) provided by the user or technician of the charged-particle microscope 302, these are mere non-limiting examples for ease of explanation and illustration. In various embodiments, the LLM 310 can receive natural language inputs that are synthesized by any suitable upstream generative models (e.g., in some cases, any of 308, 1702, 2002, 2502, or 2802 can be synthesized by an upstream generative artificial intelligence model rather than being provided manually by the user or technician).

It is to be appreciated that multiple natural language inputs (e.g., multiple instances of 308, 1702, 2002, 2502, or 2802) can be provided (e.g., by the user or operator of the charged-particle microscope 302, or by any upstream generative artificial intelligence models) to the system 316. In some aspects, the system 316 can utilize the LLM 310 as described herein to synthesize a respective response to each of such multiple natural language inputs in the order in which such multiple natural language inputs are received. In other aspects, however, the system 316 can instead utilize the LLM 310 as described herein to synthesize a respective response to each of such multiple natural language inputs in any other suitable order (e.g., in an order different from that in which the multiple natural language inputs are received). In some cases, such multiple natural language inputs can be provided to the system 316 simultaneously or otherwise substantially concurrently with each other, such that they can be considered as collectively forming a single, overarching prompt. In such situations, it is to be appreciated that the multiple natural language inputs can be individually identified via application of any suitable prompt dissection or prompt segmentation techniques to such single, overarching prompt.

Although the herein disclosure mainly describes the system 316 as leveraging the LLM 310 to respond to natural language inputs (e.g., 308, 1702, 2002, 2502, 2802) that are associated with the charged-particle microscope 302, these are mere non-limiting examples for ease of explanation and illustration. In various embodiments, the system 316 can leverage the LLM 310 to periodically or regularly monitor the state or context of the charged-particle microscope 302, even in the absence of any natural language input (e.g., even in the absence of 308, 1702, 2002, 2502, and 2802). As a non-limiting example, in some embodiments, the state component 324 can electronically obtain the image 402, the energy spectrum 404, or the currently health status 406, in response to determination (e.g., via a weight sensor or pressure sensor) that an actuatable stage of the charged-particle microscope 302 is not empty. In such case, the context component 326 can electronically obtain, receive, retrieve, or otherwise access the set of inferencing task results 704, by respectively executing the set of available deep learning models 1002 on the image 402 or on the energy spectrum 404. Also in such case, the context component 326 can electronically obtain, receive, retrieve, or otherwise access the set of relevant documents 702 as described with respect to FIGs. 8-9, but with the natural language instruction 308 being omitted. Yet also in such case, the context component 326 can electronically obtain, receive, retrieve, or otherwise access the set of simulation results 706 as described with respect to FIGs. 11-12, but with the natural language instruction 308 being omitted. Accordingly, the model component 328 can electronically execute the LLM 310 on a concatenation of the image 402, the energy spectrum 404, the current health status 406, the set of relevant documents 702, the set of inferencing task results 704, or the set of simulation results 706, and such execution can cause the LLM 310 to produce the natural language response 1302 or the synthesized code 1304.

In such embodiments, the natural language response 1302 can comprise one or more unstructured or plain text declarative sentences or sentence fragments that semantically relate in any suitable fashion to the image 402, the energy spectrum 404, the current health status 406, the set of relevant documents 702, the set of inferencing task results 704, or the set of simulation results 706. In some aspects, the natural language response 1302 in such case can be synthesized text that describes or explains any suitable step, action, or task that is recommended (as inferred by the LLM 310) to be performed (e.g., by the user or technician, or by the charged-particle microscope 302 itself), given the state (e.g., 402, 404, or 406) or context (e.g., 702, 704, or 706) of the charged-particle microscope 302.

As a non-limiting example, the LLM 310 can infer that a particular microscopy workflow or protocol should be performed on the currently-loaded specimen 306 (e.g., to avoid specimen degradation or imaging artifacts). So, the natural language response 1302 can explain or describe how to perform such particular microscopy workflow or protocol, notwithstanding the absence of any inquiry or instruction by the user or technician of the charged-particle microscope 302. In some instances, the synthesized code 1304 can be configured to automatically perform all or part of that particular microscopy workflow or protocol.

As another non-limiting example, the LLM 310 can infer that a particular microscopy workflow or protocol should be performed on the currently-loaded specimen 306 (e.g., to avoid specimen degradation or imaging artifacts), but the LLM 310 can also infer that a requisite component (e.g., X-ray tube) of the charged-particle microscope 302 possesses too much wear to properly or safely conduct such particular microscopy workflow or protocol. So, the natural language response 1302 can explain the aforementioned inferences and can recommend that the requisite component be serviced, notwithstanding the absence of any inquiry or instruction by the user or technician of the charged-particle microscope 302. In some instances, the synthesized code 1304 can be configured to automatically schedule such servicing.

Various embodiments described herein can be considered as leveraging large language models to improve accessibility or ease of operation of charged-particle microscopes. In particular, various embodiments can involve conditioning an LLM on images or energy spectra captured by a charged-particle microscope. Such conditioning can cause the LLM to perform more informed or accurate synthesis of textual content or code for that charged-particle microscope than would otherwise be possible. In other words, the text or code synthesized by the LLM would be less accurate or less satisfying to users or technicians of the charged-particle microscope, if the LLM received as input textual prompts that are unaccompanied by images or energy spectra captured by that charged-particle microscope. Accordingly, image-or-spectra conditioning of LLMs as described herein can be considered as a concrete, tangible improvement in the field of charged-particle microscopy operation.

The scientific instrument systems, methods, or techniques disclosed herein may include interactions with a human user (e.g., via a user local computing device 3420 discussed herein with reference to FIG. 34). These interactions may include providing information to the user (e.g., information regarding the operation of a scientific instrument such as the scientific instrument 3410 of FIG. 34, information regarding a sample being analyzed or other test or measurement performed by a scientific instrument, information retrieved from a local or remote database, or other information) or providing an option for a user to input commands (e.g., to control the operation of a scientific instrument such as the scientific instrument 3410 of FIG. 34, or to control the analysis of data generated by a scientific instrument), queries (e.g., to a local or remote database), or other information. In some embodiments, these interactions may be performed through a graphical user interface (GUI) that includes a visual display on a display device (e.g., a display device 3310 discussed herein with reference to FIG. 33) that provides outputs to the user and/or prompts the user to provide inputs (e.g., via one or more input devices, such as a keyboard, mouse, trackpad, or touchscreen, included in other I/O devices 3312 discussed herein with reference to FIG. 33). The scientific instrument systems, methods, or techniques disclosed herein may include any suitable GUIs for interaction with a user.

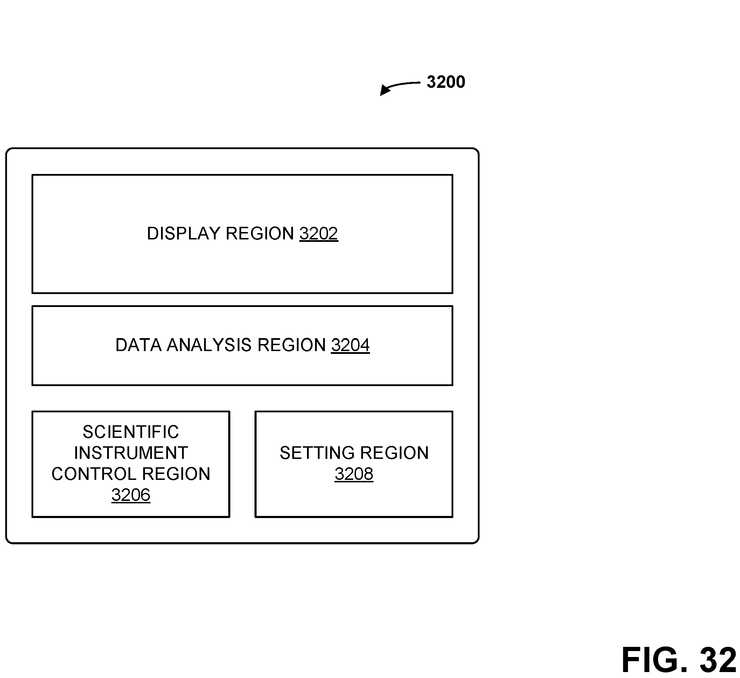

FIG. 32 depicts an example graphical user interface 3200 (hereafter "GUI 3200") that can be used in the performance of some or all of the support methods or techniques disclosed herein, in accordance with various embodiments. In various aspects, the GUI 3200 can be provided on any suitable electronic display (e.g., a display device 3310 discussed herein with reference to FIG. 33) of a computing device (e.g., a computing device 3300 discussed herein with reference to FIG. 33) of a scientific instrument support system (e.g., a scientific instrument support system 3400 discussed herein with reference to FIG. 34), and a user or technician can interact with the GUI 3200 using any suitable input device (e.g., any of other I/O devices 3312 discussed herein with reference to FIG. 33) and input technique (e.g., movement of a cursor, motion capture, facial recognition, gesture detection, voice recognition, actuation of buttons).

The GUI 3200 can include a data display region 3202, a data analysis region 3204, a scientific instrument control region 3206, and a setting region 3208. The particular number and arrangement of regions depicted in FIG. 32 is merely illustrative, and any number and arrangement of regions, including any desired features, can be included in other embodiments of the GUI 3200.

The data display region 3202 can display data generated by a scientific instrument (e.g., a scientific instrument 3410 discussed herein with reference to FIG. 34).

The data analysis region 3204 can display any suitable data analysis results (e.g., the results of analyzing the data illustrated in the data display region 3202 or other data). In some embodiments, the data display region 3202 and the data analysis region 3204 can be combined in the GUI 3200 (e.g., to include both data output from a scientific instrument and some analysis of the data in a common graph or region).

The scientific instrument control region 3206 can include options that allow a user or technician to control a scientific instrument (e.g., the scientific instrument 3410 discussed herein with reference to FIG. 34). For example, the scientific instrument control region 3206 can include configurable parameters that govern operation of such scientific instrument (e.g., configurable parameters that govern voltages or electric currents of the scientific instrument, that govern interior temperatures of the scientific instrument, or that govern fluid flow rates of the scientific instrument).

The setting region 3208 can include options that allow a user or technician to control any features or functions of the GUI 3200 (or of other GUIs) or to perform common computing operations with respect to the data display region 3202 and the data analysis region 3204 (e.g., saving data on a storage device, such as the storage device 3304 discussed herein with reference to FIG. 33, sending data to another user, labeling data).

As noted above, the scientific instrument module 102 can be implemented by one or more computing devices. FIG. 33 is a block diagram of a computing device 3300 that can perform some or all of the scientific instrument methods or techniques disclosed herein, in accordance with various embodiments. In some embodiments, the scientific instrument module 102 can be implemented by a single instance of the computing device 3300 or by multiple instances of the computing device 3300. Further, as discussed below, the computing device 3300 (or multiple instances thereof) that implements the scientific instrument module 102 can be part of one or more of a scientific instrument 3410, a user local computing device 3420, a service local computing device 3430, or a remote computing device 3440 of FIG. 34.

The computing device 3300 is illustrated as having a number of components, but any one or more of these components can be omitted or duplicated, as suitable for the application and setting. In some embodiments, some or all of the components included in the computing device 3300 can be attached to one or more motherboards and enclosed in a housing (e.g., including plastic, metal, or other materials). In some embodiments, some these components can be fabricated onto a single system-on-a-chip (SoC) (e.g., an SoC may include one or more instances of a processing device 3302 and one or more instances of a storage device 3304). Additionally, in various embodiments, the computing device 3300 can omit one or more of the components illustrated in FIG. 33, but can include interface circuitry (not shown) for coupling to the one or more omitted components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface) . For example, the computing device 3300 can omit a display device 3310, but can include display device interface circuitry (e.g., a connector and driver circuitry) to which a display device 3310 can be coupled.

The computing device 3300 can include a processing device 3302 (e.g., one or more processing devices). As used herein, the term "processing device" can refer to any device or portion of a device that processes electronic data from registers or memory to transform that electronic data into other electronic data that may be stored in registers or memories. The processing device 3302 can include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 3300 can include a storage device 3304 (e.g., one or more storage devices). The storage device 3304 can include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some embodiments, the storage device 3304 can include memory that shares a die with a processing device 3302. In such an embodiment, the memory may be used as cache memory and may include embedded dynamic random access memory (eDRAM) or spin transfer torque magnetic random access memory (STT-MRAM), for example. In some embodiments, the storage device 3304 can include non-transitory computer readable media having instructions thereon that, when executed by one or more processing devices (e.g., the processing device 3302), cause the computing device 3300 to perform any appropriate ones of or portions of the methods disclosed herein.

The computing device 3300 can include an interface device 3306 (e.g., one or more instances of the interface device 3306). The interface device 3306 can include one or more communication chips, connectors, or other hardware and software to govern communications between the computing device 3300 and other computing devices. For example, the interface device 3306 can include circuitry for managing wireless communications for the transfer of data to and from the computing device 3300. The term "wireless" and its derivatives may be used to describe circuits, devices, systems, methods, techniques, or communications channels that may communicate data through the use of modulated electromagnetic radiation through a nonsolid medium. The term does not imply that the associated devices do not contain any wires, although in some embodiments they might not. Circuitry included in the interface device 3306 for managing wireless communications may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2")). In some embodiments, circuitry included in the interface device 3306 for managing wireless communications can operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some embodiments, circuitry included in the interface device 3306 for managing wireless communications can operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some embodiments, circuitry included in the interface device 3306 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some embodiments, the interface device 3306 may include one or more antennas (e.g., one or more antenna arrays) to receipt and/or transmission of wireless communications.

In some embodiments, the interface device 3306 can include circuitry for managing wired communications, such as electrical, optical, or any other suitable communication protocols. For example, the interface device 3306 can include circuitry to support communications in accordance with Ethernet technologies. In some embodiments, the interface device 3306 can support both wireless and wired communication, or can support multiple wired communication protocols or multiple wireless communication protocols. For example, a first set of circuitry of the interface device 3306 may be dedicated to shorter-range wireless communications such as Wi-Fi or Bluetooth, and a second set of circuitry of the interface device 3306 may be dedicated to longer-range wireless communications such as global positioning system (GPS), EDGE, GPRS, CDMA, WiMAX, LTE, EV-DO, or others. In some embodiments, a first set of circuitry of the interface device 3306 can be dedicated to wireless communications, and a second set of circuitry of the interface device 3306 can be dedicated to wired communications.

The computing device 3300 can include battery/power circuitry 3308. The battery/power circuitry 3308 can include one or more energy storage devices (e.g., batteries or capacitors) or circuitry for coupling components of the computing device 3300 to an energy source separate from the computing device 3300 (e.g., alternating current line power).

The computing device 3300 can include a display device 3310 (e.g., multiple display devices). The display device 3310 can include any visual indicators, such as a heads-up display, a computer monitor, a projector, a touchscreen display, a liquid crystal display (LCD), a light-emitting diode display, or a flat panel display.

The computing device 3300 can include other input/output (I/O) devices 3312. The other I/O devices 3312 can include one or more audio output devices (e.g., speakers, headsets, earbuds, alarms), one or more audio input devices (e.g., microphones or microphone arrays), location devices (e.g., GPS devices in communication with a satellite-based system to receive a location of the computing device 3300), audio codecs, video codecs, printers, sensors (e.g., thermocouples or other temperature sensors, humidity sensors, pressure sensors, vibration sensors, accelerometers, gyroscopes), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 3300 can have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra mobile personal computer), a desktop computing device, or a server computing device or other networked computing component.

One or more computing devices implementing any of the scientific instrument modules, methods, or techniques disclosed herein may be part of a scientific instrument support system. FIG. 34 is a block diagram of an example scientific instrument support system 3400 in which some or all of the scientific instrument support methods disclosed herein may be performed, in accordance with various embodiments. The scientific instrument modules, methods, or techniques disclosed herein (e.g., the scientific instrument module 102; the computer-implemented method 200; the system 316; any of the computer-implemented methods 1500-1600, 1800-1900, 2300-2400, 2600-2700, or 2900-3000) can be implemented by one or more of a scientific instrument 3410, a user local computing device 3420, a service local computing device 3430, or a remote computing device 3440 of the scientific instrument support system 3400.

Any of the scientific instrument 3410, the user local computing device 3420, the service local computing device 3430, or the remote computing device 3440 can include any of the embodiments of the computing device 3300, and any of the scientific instrument 3410, the user local computing device 3420, the service local computing device 3430, or the remote computing device 3440 can take the form of any appropriate ones of the embodiments of the computing device 3300.

The scientific instrument 3410, the user local computing device 3420, the service local computing device 3430, or the remote computing device 3440 may each include a processing device 3402, a storage device 3404, and an interface device 3406. The processing device 3402 may take any suitable form, including any form of the processing device 3302, and the processing devices 3402 included in different ones of the scientific instrument 3410, the user local computing device 3420, the service local computing device 3430, or the remote computing device 3440 may take the same form or different forms. The storage device 3404 may take any suitable form, including any form of the storage device 3304, and the storage devices 3404 included in different ones of the scientific instrument 3410, the user local computing device 3420, the service local computing device 3430, or the remote computing device 3440 may take the same form or different forms. The interface device 3406 may take any suitable form, including any form of the interface device 3306, and the interface devices 3406 included in different ones of the scientific instrument 3410, the user local computing device 3420, the service local computing device 3430, or the remote computing device 3440 may take the same form or different forms.

The scientific instrument 3410, the user local computing device 3420, the service local computing device 3430, and the remote computing device 3440 can be in communication with other elements of the scientific instrument support system 3400 via communication pathways 3408. The communication pathways 3408 may communicatively couple the interface devices 3406 of different ones of the elements of the scientific instrument support system 3400, as shown, and may be wired or wireless communication pathways (e.g., in accordance with any of the communication techniques discussed herein with reference to the interface device 3306). The particular scientific instrument support system 3400 depicted in FIG. 34 includes communication pathways between each pair of the scientific instrument 3410, the user local computing device 3420, the service local computing device 3430, and the remote computing device 3440, but this "fully connected" implementation is merely illustrative, and in various embodiments, various ones of the communication pathways 3408 may be absent. For example, in some embodiments, a service local computing device 3430 can lack a direct communication pathway 3408 between its interface device 3406 and the interface device 3406 of the scientific instrument 3410, but can instead communicate with the scientific instrument 3410 via the communication pathway 3408 between the service local computing device 3430 and the user local computing device 3420 and the communication pathway 3408 between the user local computing device 3420 and the scientific instrument 3410.

The scientific instrument 3410 may include any appropriate scientific instrument, such as the charged-particle microscope 302.

The user local computing device 3420 can be a computing device (e.g., in accordance with any of the embodiments of the computing device 3300) that is local to a user of the scientific instrument 3410. In some embodiments, the user local computing device 3420 may also be local to the scientific instrument 3410, but this need not be the case; for example, a user local computing device 3420 that is in a user's home or office may be remote from, but in communication with, the scientific instrument 3410 so that the user may use the user local computing device 3420 to control or access data from the scientific instrument 3410. In some embodiments, the user local computing device 3420 may be a laptop, smartphone, or tablet device. In some embodiments the user local computing device 3420 can be a portable computing device.

The service local computing device 3430 can be a computing device (e.g., in accordance with any of the embodiments of the computing device 3300) that is local to an entity that services the scientific instrument 3410. For example, the service local computing device 3430 may be local to a manufacturer of the scientific instrument 3410 or to a third-party service company. In some embodiments, the service local computing device 3430 can communicate with the scientific instrument 3410, the user local computing device 3420, or the remote computing device 3440 (e.g., via a direct communication pathway 3408 or via multiple "indirect" communication pathways 3408, as discussed above) to receive data regarding the operation of the scientific instrument 3410, the user local computing device 3420, or the remote computing device 3440 (e.g., the results of self-tests of the scientific instrument 3410, calibration coefficients used by the scientific instrument 3410, the measurements of sensors associated with the scientific instrument 3410). In some embodiments, the service local computing device 3430 may communicate with the scientific instrument 3410, the user local computing device 3420, or the remote computing device 3440 (e.g., via a direct communication pathway 3408 or via multiple "indirect" communication pathways 3408, as discussed above) to transmit data to the scientific instrument 3410, the user local computing device 3420, or the remote computing device 3440 (e.g., to update programmed instructions, such as firmware, in the scientific instrument 3410, to initiate the performance of test or calibration sequences in the scientific instrument 3410, to update programmed instructions, such as software, in the user local computing device 3420 or the remote computing device 3440). A user of the scientific instrument 3410 can utilize the scientific instrument 3410 or the user local computing device 3420 to communicate with the service local computing device 3430 to report a problem with the scientific instrument 3410 or the user local computing device 3420, to request a visit from a technician to improve the operation of the scientific instrument 3410, to order consumables or replacement parts associated with the scientific instrument 3410, or for other purposes.

The remote computing device 3440 can be a computing device (e.g., in accordance with any of the embodiments of the computing device 3300 discussed herein) that is remote from the scientific instrument 3410 or from the user local computing device 3420. In some embodiments, the remote computing device 3440 can be included in a datacenter or other large-scale server environment. In some embodiments, the remote computing device 3440 may include network-attached storage (e.g., as part of the storage device 3404). The remote computing device 3440 can store data generated by the scientific instrument 3410, perform analyses of the data generated by the scientific instrument 3410 (e.g., in accordance with programmed instructions), facilitate communication between the user local computing device 3420 and the scientific instrument 3410, or facilitate communication between the service local computing device 3430 and the scientific instrument 3410.

In some embodiments, one or more of the elements of the scientific instrument support system 3400 illustrated in FIG. 34 can be omitted. Further, in some embodiments, multiple ones of various ones of the elements of the scientific instrument support system 3400 of FIG. 34 may be present. For example, a scientific instrument support system 3400 can include multiple user local computing devices 3420 (e.g., different user local computing devices 3420 associated with different users or in different locations). In another example, a scientific instrument support system 3400 may include multiple scientific instruments 3410, all in communication with service local computing device 3430 and/or a remote computing device 3440; in such an embodiment, the service local computing device 3430 may monitor these multiple scientific instruments 3410, and the service local computing device 3430 may cause updates or other information may be "broadcast" to multiple scientific instruments 3410 at the same time. Different ones of the scientific instruments 3410 in a scientific instrument support system 3400 can be located close to one another (e.g., in the same room) or farther from one another (e.g., on different floors of a building, in different buildings, in different cities, etc.). In some embodiments, a scientific instrument 3410 can be connected to an Internet-of-Things (IoT) stack that allows for command and control of the scientific instrument 3410 through a web-based application, a virtual or augmented reality application, a mobile application, or a desktop application. Any of these applications can be accessed by a user operating the user local computing device 3420 in communication with the scientific instrument 3410 by the intervening remote computing device 3440. In some embodiments, a scientific instrument 3410 may be sold by the manufacturer along with one or more associated user local computing devices 3420 as part of a local scientific instrument computing unit 3412.

In some embodiments, different ones of the scientific instruments 3410 included in a scientific instrument support system 3400 may be different types of scientific instruments 3410; for example, one scientific instrument 3410 may be a mass spectrometer, while another scientific instrument 3410 may be a chromatograph or autosampler. In some such embodiments, the remote computing device 3440 or the user local computing device 3420 can combine data from different types of scientific instruments 3410 included in a scientific instrument support system 3400.

In various instances, machine learning algorithms or models can be implemented in any suitable way to facilitate any suitable aspects described herein. To facilitate some of the above-described machine learning aspects of various embodiments, consider the following discussion of artificial intelligence (Al). Various embodiments described herein can employ artificial intelligence to facilitate automating one or more features or functionalities. The components can employ various Al-based schemes for carrying out various embodiments/examples disclosed herein. In order to provide for or aid in the numerous determinations (e.g., determine, ascertain, infer, calculate, predict, prognose, estimate, derive, forecast, detect, compute) described herein, components described herein can examine the entirety or a subset of the data to which it is granted access and can provide for reasoning about or determine states of the system or environment from a set of observations as captured via events or data. Determinations can be employed to identify a specific context or action, or can generate a probability distribution over states, for example. The determinations can be probabilistic; that is, the computation of a probability distribution over states of interest based on a consideration of data and events. Determinations can also refer to techniques employed for composing higher-level events from a set of events or data.

Such determinations can result in the construction of new events or actions from a set of observed events or stored event data, whether or not the events are correlated in close temporal proximity, and whether the events and data come from one or several event and data sources. Components disclosed herein can employ various classification (explicitly trained (e.g., via training data) as well as implicitly trained (e.g., via observing behavior, preferences, historical information, receiving extrinsic information, and so on)) schemes or systems (e.g., support vector machines, neural networks, expert systems, Bayesian belief networks, fuzzy logic, data fusion engines, and so on) in connection with performing automatic or determined action in connection with the claimed subject matter. Thus, classification schemes or systems can be used to automatically learn and perform a number of functions, actions, or determinations.

A classifier can map an input attribute vector, z = (z₁, z₂, z₃, z₄, *zₙ*), to a confidence that the input belongs to a class, as by f(z) = *confidence*(*class*). Such classification can employ a probabilistic or statistical-based analysis (e.g., factoring into the analysis utilities and costs) to determinate an action to be automatically performed. A support vector machine (SVM) can be an example of a classifier that can be employed. The SVM operates by finding a hyper-surface in the space of possible inputs, where the hyper-surface attempts to split the triggering criteria from the non-triggering events. Intuitively, this makes the classification correct for testing data that is near, but not identical to training data. Other directed and undirected model classification approaches include, e.g., naïve Bayes, Bayesian networks, decision trees, neural networks, fuzzy logic models, or probabilistic classification models providing different patterns of independence, any of which can be employed. Classification as used herein also is inclusive of statistical regression that is utilized to develop models of priority.

In order to provide additional context for various embodiments described herein, FIG. 35 and the following discussion are intended to provide a brief, general description of a suitable computing environment 3500 in which the various embodiments of the embodiment described herein can be implemented. While the embodiments have been described above in the general context of computer-executable instructions that can run on one or more computers, those skilled in the art will recognize that the embodiments can be also implemented in combination with other program modules or as a combination of hardware and software.

Generally, program modules include routines, programs, components, data structures, etc., that perform particular tasks or implement particular abstract data types. Moreover, those skilled in the art will appreciate that the inventive methods can be practiced with other computer system configurations, including single-processor or multi-processor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD-ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

With reference again to FIG. 35, the example environment 3500 for implementing various embodiments of the aspects described herein includes a computer 3502, the computer 3502 including a processing unit 3504, a system memory 3506 and a system bus 3508. The system bus 3508 couples system components including, but not limited to, the system memory 3506 to the processing unit 3504. The processing unit 3504 can be any of various commercially available processors. Dual microprocessors and other multi-processor architectures can also be employed as the processing unit 3504.

The system bus 3508 can be any of several types of bus structure that can further interconnect to a memory bus (with or without a memory controller), a peripheral bus, and a local bus using any of a variety of commercially available bus architectures. The system memory 3506 includes ROM 3510 and RAM 3512. A basic input/output system (BIOS) can be stored in a non-volatile memory such as ROM, erasable programmable read only memory (EPROM), EEPROM, which BIOS contains the basic routines that help to transfer information between elements within the computer 3502, such as during startup. The RAM 3512 can also include a high-speed RAM such as static RAM for caching data.

The computer 3502 further includes an internal hard disk drive (HDD) 3514 (e.g., EIDE, SATA), one or more external storage devices 3516 (e.g., a magnetic floppy disk drive (FDD) 3516, a memory stick or flash drive reader, a memory card reader, etc.) and a drive 3520, e.g., such as a solid state drive, an optical disk drive, which can read or write from a disk 3522, such as a CD-ROM disc, a DVD, a BD, etc. Alternatively, where a solid state drive is involved, disk 3522 would not be included, unless separate. While the internal HDD 3514 is illustrated as located within the computer 3502, the internal HDD 3514 can also be configured for external use in a suitable chassis (not shown). Additionally, while not shown in environment 3500, a solid state drive (SSD) could be used in addition to, or in place of, an HDD 3514. The HDD 3514, external storage device(s) 3516 and drive 3520 can be connected to the system bus 3508 by an HDD interface 3524, an external storage interface 3526 and a drive interface 3528, respectively. The interface 3524 for external drive implementations can include at least one or both of Universal Serial Bus (USB) and Institute of Electrical and Electronics Engineers (IEEE) 1394 interface technologies. Other external drive connection technologies are within contemplation of the embodiments described herein.

The drives and their associated computer-readable storage media provide nonvolatile storage of data, data structures, computer-executable instructions, and so forth. For the computer 3502, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 3512, including an operating system 3530, one or more application programs 3532, other program modules 3534 and program data 3536. All or portions of the operating system, applications, modules, or data can also be cached in the RAM 3512. The systems and methods described herein can be implemented utilizing various commercially available operating systems or combinations of operating systems.

Computer 3502 can optionally comprise emulation technologies. For example, a hypervisor (not shown) or other intermediary can emulate a hardware environment for operating system 3530, and the emulated hardware can optionally be different from the hardware illustrated in FIG. 35. In such an embodiment, operating system 3530 can comprise one virtual machine (VM) of multiple VMs hosted at computer 3502. Furthermore, operating system 3530 can provide runtime environments, such as the Java runtime environment or the .NET framework, for applications 3532. Runtime environments are consistent execution environments that allow applications 3532 to run on any operating system that includes the runtime environment. Similarly, operating system 3530 can support containers, and applications 3532 can be in the form of containers, which are lightweight, standalone, executable packages of software that include, e.g., code, runtime, system tools, system libraries and settings for an application.

Further, computer 3502 can be enable with a security module, such as a trusted processing module (TPM). For instance with a TPM, boot components hash next in time boot components, and wait for a match of results to secured values, before loading a next boot component. This process can take place at any layer in the code execution stack of computer 3502, e.g., applied at the application execution level or at the operating system (OS) kernel level, thereby enabling security at any level of code execution.

A user can enter commands and information into the computer 3502 through one or more wired/wireless input devices, e.g., a keyboard 3538, a touch screen 3540, and a pointing device, such as a mouse 3542. Other input devices (not shown) can include a microphone, an infrared (IR) remote control, a radio frequency (RF) remote control, or other remote control, a joystick, a virtual reality controller or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 3504 through an input device interface 3544 that can be coupled to the system bus 3508, but can be connected by other interfaces, such as a parallel port, an IEEE 1394 serial port, a game port, a USB port, an IR interface, a BLUETOOTH^{®} interface, etc.

A monitor 3546 or other type of display device can be also connected to the system bus 3508 via an interface, such as a video adapter 3548. In addition to the monitor 3546, a computer typically includes other peripheral output devices (not shown), such as speakers, printers, etc.

The computer 3502 can operate in a networked environment using logical connections via wired or wireless communications to one or more remote computers, such as a remote computer(s) 3550. The remote computer(s) 3550 can be a workstation, a server computer, a router, a personal computer, portable computer, microprocessor-based entertainment appliance, a peer device or other common network node, and typically includes many or all of the elements described relative to the computer 3502, although, for purposes of brevity, only a memory/storage device 3552 is illustrated. The logical connections depicted include wired/wireless connectivity to a local area network (LAN) 3554 or larger networks, e.g., a wide area network (WAN) 3556. Such LAN and WAN networking environments are commonplace in offices and companies, and facilitate enterprise-wide computer networks, such as intranets, all of which can connect to a global communications network, e.g., the Internet.

When used in a LAN networking environment, the computer 3502 can be connected to the local network 3554 through a wired or wireless communication network interface or adapter 3558. The adapter 3558 can facilitate wired or wireless communication to the LAN 3554, which can also include a wireless access point (AP) disposed thereon for communicating with the adapter 3558 in a wireless mode.

When used in a WAN networking environment, the computer 3502 can include a modem 3560 or can be connected to a communications server on the WAN 3556 via other means for establishing communications over the WAN 3556, such as by way of the Internet. The modem 3560, which can be internal or external and a wired or wireless device, can be connected to the system bus 3508 via the input device interface 3544. In a networked environment, program modules depicted relative to the computer 3502 or portions thereof, can be stored in the remote memory/storage device 3552. It will be appreciated that the network connections shown are example and other means of establishing a communications link between the computers can be used.

When used in either a LAN or WAN networking environment, the computer 3502 can access cloud storage systems or other network-based storage systems in addition to, or in place of, external storage devices 3516 as described above, such as but not limited to a network virtual machine providing one or more aspects of storage or processing of information. Generally, a connection between the computer 3502 and a cloud storage system can be established over a LAN 3554 or WAN 3556 e.g., by the adapter 3558 or modem 3560, respectively. Upon connecting the computer 3502 to an associated cloud storage system, the external storage interface 3526 can, with the aid of the adapter 3558 or modem 3560, manage storage provided by the cloud storage system as it would other types of external storage. For instance, the external storage interface 3526 can be configured to provide access to cloud storage sources as if those sources were physically connected to the computer 3502.

The computer 3502 can be operable to communicate with any wireless devices or entities operatively disposed in wireless communication, e.g., a printer, scanner, desktop or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a predefined structure as with a conventional network or simply an ad hoc communication between at least two devices.

FIG. 36 is a schematic block diagram of a sample computing environment 3600 with which the disclosed subject matter can interact. The sample computing environment 3600 includes one or more client(s) 3610. The client(s) 3610 can be hardware or software (e.g., threads, processes, computing devices). The sample computing environment 3600 also includes one or more server(s) 3630. The server(s) 3630 can also be hardware or software (e.g., threads, processes, computing devices). The servers 3630 can house threads to perform transformations by employing one or more embodiments as described herein, for example. One possible communication between a client 3610 and a server 3630 can be in the form of a data packet adapted to be transmitted between two or more computer processes. The sample computing environment 3600 includes a communication framework 3650 that can be employed to facilitate communications between the client(s) 3610 and the server(s) 3630. The client(s) 3610 are operably connected to one or more client data store(s) 3620 that can be employed to store information local to the client(s) 3610. Similarly, the server(s) 3630 are operably connected to one or more server data store(s) 3640 that can be employed to store information local to the servers 3630.

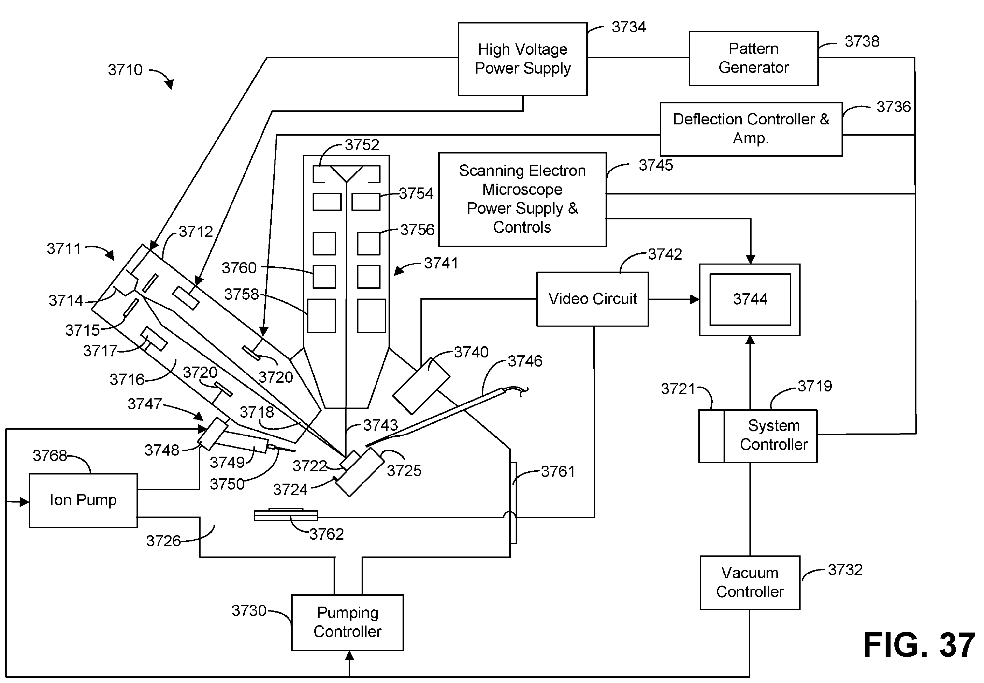

An example, non-limiting apparatus for performing various embodiments described herein is shown in FIG. 37. FIG. 37 illustrates a non-limiting example of a dual beam system 3710 with a vertically mounted scanning electron microscope (SEM) column and a focused ion beam (FIB) column mounted at an angle of approximately 52 degrees from the vertical. Such dual beam systems are commercially available, for example, from FEI Company, Hillsboro, Oregon, the assignee of the present application. While FIG. 37 shows an example of suitable microscopy hardware with which various embodiments described herein can be implemented, it is to be appreciated that such microscopy hardware is non-limiting. In other words, various embodiments described herein can be implemented in conjunction with any other suitable types of microscopy hardware. The dual beam system 3710 is a non-limiting example of the charged-particle microscope 302 or of any other scientific instruments discussed above.

A scanning electron microscope 3741, along with a power supply and control unit 3745, can be provided with the dual beam system 3710. An electron beam 3743 can be emitted from a cathode 3752 by applying voltage between the cathode 3752 and an anode 3754. The electron beam 3743 can be focused to a fine spot by means of a condensing lens 3756 and an objective lens 3758. The electron beam 3743 can be scanned two-dimensionally on any suitable specimen by means of a deflection coil 3760. Operation of the condensing lens 3756, the objective lens 3758, or the deflection coil 3760 can be controlled by the power supply and control unit 3745.

The electron beam 3743 can be focused onto a substrate 3722, which can be on a movable X-Y stage 3725 within a lower chamber 3726. When the electrons in the electron beam 3743 strike the substrate 3722, secondary electrons can be emitted. These secondary electrons can be detected by a secondary electron detector 3740 as discussed below. A scanning transmission electron microscopy (STEM) detector 3762, located beneath a transmission electron microscopy (TEM) sample holder 3724 and the movable X-Y stage 3725, can collect electrons that are transmitted through the sample mounted on the TEM sample holder 3724 as discussed above.

The dual beam system 3710 can also include a focused ion beam (FIB) system 3711 which can comprise an evacuated chamber having an upper neck portion 3712 within which can be located an ion source 3714 and a focusing column 3716 including extractor electrodes and an electrostatic optical system. The axis of the focusing column 3716 can be tilted 52 degrees (or any other suitable angular displacement) from the axis of the electron column. The ion column 3712 can include an ion source 3714, an extraction electrode 3715, a focusing element 3717, deflection elements 3720, and a focused ion beam 3718. The focused ion beam 3718 can pass from the ion source 3714 through the focusing column 3716 and between electrostatic deflection means schematically indicated at numeral 3720 toward the substrate 3722, which can comprise, for example, a semiconductor device positioned on the movable X-Y stage 3725 within the lower chamber 3726.

The movable X-Y stage 3725 can move in a horizontal plane (along X and Y axes) and vertically (along Z axis). The movable X-Y stage 3725 can tilt approximately sixty (60) degrees and rotate about the Z axis. In some embodiments, a separate TEM sample stage (not shown) can be used. Such a TEM sample stage can be moveable in the X, Y, and Z axes. A door 3761 can be opened for inserting the substrate 3722 onto the movable X-Y stage 3725 or also for servicing an internal gas supply reservoir, if one is used. The door 3761 can be interlocked so that it cannot be opened if the system is under vacuum.

An ion pump 3768 can be employed for evacuating the neck portion 3712. The chamber 3726 can be evacuated with a turbomolecular and mechanical pumping system 3730 under the control of a vacuum controller 3732. Such vacuum system can provide within the chamber 3726 a vacuum of between approximately 1 x 10⁻⁷ Torr and 5 x 10⁻⁴ Torr. If an etch assisting, an etch retarding gas, or a deposition precursor gas is used, the chamber background pressure may rise, typically to about 1 x 10⁻⁵ Torr.

A high voltage power supply 3734 can provide an appropriate acceleration voltage to electrodes in the focusing column 3716 for energizing and the focused ion beam 3718. When it strikes the substrate 3722, material can be sputtered (that is, physically ejected) from the sample. Alternatively, the focused ion beam 3718 can decompose a precursor gas to deposit a material.

The high voltage power supply 3734 can be connected to the ion source 3714 (which can be a liquid metal ion source) as well as to appropriate electrodes in the ion beam focusing column 3716 for forming an approximately 1 keV to 60 keV ion beam 3718 and directing the same toward a sample. A deflection controller and amplifier 3736, operated in accordance with a prescribed pattern provided by a pattern generator 3738, can be coupled to the deflection elements 3720 (which can be deflection plates) whereby the focused ion beam 3718 may be controlled manually or automatically to trace out a corresponding pattern on the upper surface of the substrate 3722. In some systems, the deflection elements 3720 can be placed before the final lens. Beam blanking electrodes (not shown) within the ion beam focusing column 3716 can cause the focused ion beam 3718 to impact onto a blanking aperture (not shown) instead of the substrate 3722 when a blanking controller (not shown) applies a blanking voltage to a blanking electrode.

The ion source 3714 can provide a metal ion beam of gallium, for example. In other examples, the ion source 3714 may be a plasma ion source that extracts ions from a generated plasma. The source can be capable of being focused into a sub one-tenth micrometer wide beam at the substrate 3722 for either modifying the substrate 3722 by ion milling, enhanced etch, material deposition, or for the purpose of imaging the substrate 3722.

A charged particle detector 3740, such as an Everhart Thornley or multichannel plate, used for detecting secondary ion or electron emission can be connected to a video circuit 3742 that can supply drive signals to a video monitor 3744 and receive deflection signals from a system controller 3719. The location of the charged particle detector 3740 within the lower chamber 3726 can vary in different embodiments. For example, the charged particle detector 3740 can be coaxial with the ion beam and include a hole for allowing the ion beam to pass. In other embodiments, secondary particles can be collected through a final lens and then diverted off axis for collection.

A micromanipulator 3747 can precisely move objects within the vacuum chamber. The micromanipulator 3747 may comprise precision electric motors 3748 positioned outside the vacuum chamber to provide X, Y, Z, and theta control of a portion 3749 positioned within the vacuum chamber. The micromanipulator 3747 can be fitted with different end effectors for manipulating small objects. In various embodiments described herein, the end effector can be a thin probe 3750.

A gas delivery system 3746 can extend into the lower chamber 3726 for introducing and directing a gaseous vapor toward the substrate 3722. U.S. Pat. No. 5,851,413 to Casella et al. for "Gas Delivery Systems for Particle Beam Processing," assigned to the assignee of the present invention, describes a suitable gas delivery system 3746. Another gas delivery system is described in U.S. Pat. No. 5,435,850 to Rasmussen for a "Gas Injection System," also assigned to the assignee of the present invention. For example, iodine can be delivered to enhance etching, or a metal organic compound can be delivered to deposit a metal.

The system controller 3719 can control the operations of the various parts of the dual beam system 3710. Through the system controller 3719, a user can cause the focused ion beam 3718 or the electron beam 3743 to be scanned in a desired manner through commands entered into any suitable user interface (not shown). Alternatively, the system controller 3719 may control the dual beam system 3710 in accordance with programmed instructions stored in a memory 3721. In various embodiments, any of the one or more software components 321 (e.g., the access component 322, the state component 324, the context component 326, the model component 328, the presenter component 330) can be implemented in or otherwise executed by the system controller 3719.

Various embodiments may be a system, a method, an apparatus or a computer program product at any possible technical detail level of integration. The computer program product can include a computer readable storage medium (or media) having computer readable program instructions thereon for causing a processor to carry out aspects of various embodiments. The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network or a wireless network. The network can comprise copper transmission cables, optical transmission fibers, wireless transmission, routers, firewalls, switches, gateway computers or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of various embodiments can be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions can execute entirely on the user's computer, partly on the user's computer, as a stand-alone software package, partly on the user's computer and partly on a remote computer or entirely on the remote computer or server. In the latter scenario, the remote computer can be connected to the user's computer through any type of network, including a local area network (LAN) or a wide area network (WAN), or the connection can be made to an external computer (for example, through the Internet using an Internet Service Provider). In some embodiments, electronic circuitry including, for example, programmable logic circuitry, field-programmable gate arrays (FPGA), or programmable logic arrays (PLA) can execute the computer readable program instructions by utilizing state information of the computer readable program instructions to personalize the electronic circuitry, in order to perform various aspects.

Various aspects are described herein with reference to flowchart illustrations or block diagrams of methods, apparatus (systems), and computer program products according to various embodiments. It will be understood that each block of the flowchart illustrations or block diagrams, and combinations of blocks in the flowchart illustrations or block diagrams, can be implemented by computer readable program instructions. These computer readable program instructions can be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart or block diagram block or blocks. These computer readable program instructions can also be stored in a computer readable storage medium that can direct a computer, a programmable data processing apparatus, or other devices to function in a particular manner, such that the computer readable storage medium having instructions stored therein comprises an article of manufacture including instructions which implement aspects of the function/act specified in the flowchart or block diagram block or blocks. The computer readable program instructions can also be loaded onto a computer, other programmable data processing apparatus, or other device to cause a series of operational acts to be performed on the computer, other programmable apparatus or other device to produce a computer implemented process, such that the instructions which execute on the computer, other programmable apparatus, or other device implement the functions/acts specified in the flowchart or block diagram block or blocks.

The flowcharts and block diagrams in the Figures illustrate the architecture, functionality, and operation of possible implementations of systems, methods, and computer program products according to various embodiments. In this regard, each block in the flowchart or block diagrams can represent a module, segment, or portion of instructions, which comprises one or more executable instructions for implementing the specified logical function(s). In some alternative implementations, the functions noted in the blocks can occur out of the order noted in the Figures. For example, two blocks shown in succession can, in fact, be executed substantially concurrently, or the blocks can sometimes be executed in the reverse order, depending upon the functionality involved. It will also be noted that each block of the block diagrams or flowchart illustration, and combinations of blocks in the block diagrams or flowchart illustration, can be implemented by special purpose hardware-based systems that perform the specified functions or acts or carry out combinations of special purpose hardware and computer instructions.

While the subject matter has been described above in the general context of computer-executable instructions of a computer program product that runs on a computer or computers, those skilled in the art will recognize that this disclosure also can or can be implemented in combination with other program modules. Generally, program modules include routines, programs, components, data structures, etc. that perform particular tasks or implement particular abstract data types. Moreover, those skilled in the art will appreciate that various aspects can be practiced with other computer system configurations, including single-processor or multiprocessor computer systems, mini-computing devices, mainframe computers, as well as computers, hand-held computing devices (e.g., PDA, phone), microprocessor-based or programmable consumer or industrial electronics, and the like. The illustrated aspects can also be practiced in distributed computing environments in which tasks are performed by remote processing devices that are linked through a communications network. However, some, if not all aspects of this disclosure can be practiced on stand-alone computers. In a distributed computing environment, program modules can be located in both local and remote memory storage devices.

As used in this application, the terms "component," "system," "platform," "interface," and the like, can refer to or can include a computer-related entity or an entity related to an operational machine with one or more specific functionalities. The entities disclosed herein can be either hardware, a combination of hardware and software, software, or software in execution. For example, a component can be, but is not limited to being, a process running on a processor, a processor, an object, an executable, a thread of execution, a program, or a computer. By way of illustration, both an application running on a server and the server can be a component. One or more components can reside within a process or thread of execution and a component can be localized on one computer or distributed between two or more computers. In another example, respective components can execute from various computer readable media having various data structures stored thereon. The components can communicate via local or remote processes such as in accordance with a signal having one or more data packets (e.g., data from one component interacting with another component in a local system, distributed system, or across a network such as the Internet with other systems via the signal). As another example, a component can be an apparatus with specific functionality provided by mechanical parts operated by electric or electronic circuitry, which is operated by a software or firmware application executed by a processor. In such a case, the processor can be internal or external to the apparatus and can execute at least a part of the software or firmware application. As yet another example, a component can be an apparatus that provides specific functionality through electronic components without mechanical parts, wherein the electronic components can include a processor or other means to execute software or firmware that confers at least in part the functionality of the electronic components. In an aspect, a component can emulate an electronic component via a virtual machine, e.g., within a cloud computing system.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. As used herein, the term "and/or" is intended to have the same meaning as "or." Moreover, articles "a" and "an" as used in the subject specification and annexed drawings should generally be construed to mean "one or more" unless specified otherwise or clear from context to be directed to a singular form. As used herein, the terms "example" or "exemplary" are utilized to mean serving as an example, instance, or illustration. For the avoidance of doubt, the subject matter disclosed herein is not limited by such examples. In addition, any aspect or design described herein as an "example" or "exemplary" is not necessarily to be construed as preferred or advantageous over other aspects or designs, nor is it meant to preclude equivalent exemplary structures and techniques known to those of ordinary skill in the art.

The herein disclosure describes non-limiting examples. For ease of description or explanation, various portions of the herein disclosure utilize the term "each," "every," or "all" when discussing various examples. Such usages of the term "each," "every," or "all" are non-limiting. In other words, when the herein disclosure provides a description that is applied to "each," "every," or "all" of some particular object or component, it should be understood that this is a non-limiting example, and it should be further understood that, in various other examples, it can be the case that such description applies to fewer than "each," "every," or "all" of that particular object or component.

As it is employed in the subject specification, the term "processor" can refer to substantially any computing processing unit or device comprising, but not limited to, single-core processors; single-processors with software multithread execution capability; multi-core processors; multi-core processors with software multithread execution capability; multi-core processors with hardware multithread technology; parallel platforms; and parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, or any combination thereof designed to perform the functions described herein. Further, processors can exploit nano-scale architectures such as, but not limited to, molecular and quantum-dot based transistors, switches and gates, in order to optimize space usage or enhance performance of user equipment. A processor can also be implemented as a combination of computing processing units. In this disclosure, terms such as "store," "storage," "data store," data storage," "database," and substantially any other information storage component relevant to operation and functionality of a component are utilized to refer to "memory components," entities embodied in a "memory," or components comprising a memory. It is to be appreciated that memory or memory components described herein can be either volatile memory or nonvolatile memory, or can include both volatile and nonvolatile memory. By way of illustration, and not limitation, nonvolatile memory can include read only memory (ROM), programmable ROM (PROM), electrically programmable ROM (EPROM), electrically erasable ROM (EEPROM), flash memory, or nonvolatile random access memory (RAM) (e.g., ferroelectric RAM (FeRAM). Volatile memory can include RAM, which can act as external cache memory, for example. By way of illustration and not limitation, RAM is available in many forms such as synchronous RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM), and Rambus dynamic RAM (RDRAM). Additionally, the disclosed memory components of systems or computer-implemented methods herein are intended to include, without being limited to including, these and any other suitable types of memory.

What has been described above include mere examples of systems and computer-implemented methods. It is, of course, not possible to describe every conceivable combination of components or computer-implemented methods for purposes of describing this disclosure, but many further combinations and permutations of this disclosure are possible. Furthermore, to the extent that the terms "includes," "has," "possesses," and the like are used in the detailed description, claims, appendices and drawings such terms are intended to be inclusive in a manner similar to the term "comprising" as "comprising" is interpreted when employed as a transitional word in a claim.

The descriptions of the various embodiments have been presented for purposes of illustration, but are not intended to be exhaustive or limited to the embodiments disclosed. Many modifications and variations will be apparent without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

Various non-limiting aspects are described in the following examples.

EXAMPLE 1: A system can comprise: a processor that executes computer-executable components stored in a non-transitory computer-readable memory, wherein the computer-executable components comprise: an access component that can access a natural language instruction provided by a user of a charged-particle microscope, wherein the natural language instruction can request or command that the charged-particle microscope undergo a configurable settings adjustment or that the charged-particle microscope perform an automated task; a state component that can cause, in response to receipt of the natural language instruction, the charged-particle microscope to capture, according to a default microscopy protocol, an image or an energy spectrum of a specimen that is currently loaded on a stage of the charged-particle microscope; and a model component that can execute a large language model on both the natural language instruction and the image or energy spectrum of the specimen, thereby yielding a natural language response that can indicate how implementing the natural language instruction would affect the specimen.

EXAMPLE 2: The system of any preceding example can be implemented, wherein the computer-executable components can comprise: a presenter component that can: visibly render the natural language response or a visual graphic associated with the natural language response on an electronic display associated with the charged-particle microscope; audibly play the natural language response on an electronic speaker associated with the charged-particle microscope; or transmit the natural language response to a computing device associated with the charged-particle microscope.

EXAMPLE 3: The system of any preceding example can be implemented, wherein the natural language instruction can be: plain text that is typed into a graphical user-interface text field associated with the charged-particle microscope; or plain text that is transcribed from an audio recording captured by a microphone associated with the charged-particle microscope.

EXAMPLE 4: The system of any preceding example can be implemented, wherein the natural language response can indicate that implementing the natural language instruction would harm or charge the specimen, and wherein the natural language response can further indicate that the charged-particle microscope should undergo an alternative configurable settings adjustment or that the charged-particle microscope should perform an alternative automated task.

EXAMPLE 5: The system of any preceding example can be implemented, wherein the computer-executable components can comprise: a presenter component that can cause the charged-particle microscope to undergo the alternative configurable settings adjustment or to perform the alternative automated task.

EXAMPLE 6: The system of any preceding example can be implemented, wherein the computer-executable components can comprise: a context component that can identify, via an embedding search of a document repository, one or more documents that are relevant to the natural language instruction and to the image or energy spectrum of the specimen, wherein the large language model can receive as input the natural language instruction, the image or energy spectrum of the specimen, and the one or more documents.

EXAMPLE 7: The system of any preceding example can be implemented, wherein the computer-executable components can comprise: a context component that can execute one or more available deep learning models on the image or energy spectrum of the specimen, thereby yielding one or more inferencing task results, wherein the large language model can receive as input the natural language instruction, the image or energy spectrum of the specimen, and the one or more inferencing task results.

EXAMPLE 8: The system of any preceding example can be implemented, wherein the charged-particle microscope can be synchronized with a digital twin, and wherein: the large language model can receive as input the natural language instruction, the image or energy spectrum of the specimen, and a current health status of the charged-particle microscope as indicated by the digital twin; or the large language model can receive as input the natural language instruction, the image or energy spectrum of the specimen, and one or more simulation results regarding the charged-particle microscope produced by the digital twin.

In various embodiments, any combination or combinations of examples 1-8 can be implemented.

EXAMPLE 9: A computer-implemented method can comprise: accessing, by a device operatively coupled to a processor, a natural language instruction provided by a user of a charged-particle microscope, wherein the natural language instruction requests or commands that the charged-particle microscope undergo a configurable settings adjustment or that the charged-particle microscope perform an automated task; causing, by the device and in response to receipt of the natural language instruction, the charged-particle microscope to capture, according to a default microscopy protocol, an image or an energy spectrum of a specimen that is currently loaded on a stage of the charged-particle microscope; and executing, by the device, a large language model on both the natural language instruction and the image or energy spectrum of the specimen, thereby yielding a natural language response that indicates how implementing the natural language instruction would affect the specimen.

EXAMPLE 10: The computer-implemented method of any preceding example can be implemented, further comprising: visibly rendering, by the device, the natural language response or a visual graphic associated with the natural language response on an electronic display associated with the charged-particle microscope; audibly playing, by the device, the natural language response on an electronic speaker associated with the charged-particle microscope; or transmitting, by the device, the natural language response to a computing device associated with the charged-particle microscope.

EXAMPLE 11: The computer-implemented method of any preceding example can be implemented, wherein the natural language instruction can be: plain text that is typed into a graphical user-interface text field associated with the charged-particle microscope; or plain text that is transcribed from an audio recording captured by a microphone associated with the charged-particle microscope.

EXAMPLE 12: The computer-implemented method of any preceding example can be implemented, wherein the natural language response can indicate that implementing the natural language instruction would harm or charge the specimen, and wherein the natural language response can further indicate that the charged-particle microscope should undergo an alternative configurable settings adjustment or that the charged-particle microscope should perform an alternative automated task.

EXAMPLE 13: The computer-implemented method of any preceding example can be implemented, further comprising: causing, by the device, the charged-particle microscope to undergo the alternative configurable settings adjustment or to perform the alternative automated task.

EXAMPLE 14: The computer-implemented method of any preceding example can be implemented, further comprising: identifying, by the device and via an embedding search of a document repository, one or more documents that are relevant to the natural language instruction and to the image or energy spectrum of the specimen, wherein the large language model can receive as input the natural language instruction, the image or energy spectrum of the specimen, and the one or more documents.

EXAMPLE 15: The computer-implemented method of any preceding example can be implemented, further comprising: executing, by the device, one or more available deep learning models on the image or energy spectrum of the specimen, thereby yielding one or more inferencing task results, wherein the large language model can receive as input the natural language instruction, the image or energy spectrum of the specimen, and the one or more inferencing task results.

EXAMPLE 16: The computer-implemented method of any preceding example can be implemented, wherein the charged-particle microscope can be synchronized with a digital twin, and wherein: the large language model can receive as input the natural language instruction, the image or energy spectrum of the specimen, and a current health status of the charged-particle microscope as indicated by the digital twin; or the large language model can receive as input the natural language instruction, the image or energy spectrum of the specimen, and one or more simulation results regarding the charged-particle microscope produced by the digital twin.

In various embodiments, any combination or combinations of examples 9-16 can be implemented.

EXAMPLE 17: A computer program product for facilitating large language model assistance for charged-particle microscope operation can comprise a non-transitory computer-readable memory having program instructions embodied therewith. In various aspects, the program instructions can be executable by a processor to cause the processor to: access a plain text command provided by a user of a scanning electron microscope, wherein the plain text command can request that the scanning electron microscope perform a specified microscopy action; in response to receipt of the plain text command, cause the scanning electron microscope to capture, via a default microscopy protocol, an image or energy spectrum of a specimen that is currently loaded on a stage of the scanning electron microscope; execute a large language model on both the plain text command and the image or energy spectrum of the specimen, wherein the large language model can produce as output a plain text response that indicates whether the specified microscopy action would damage the specimen; and visibly or audibly render the plain text response on an electronic display or on an electronic speaker associated with the scanning electron microscope.

EXAMPLE 18: The computer program product of any preceding example can be implemented, wherein the plain text response can indicate that the specified microscopy action would damage the specimen, and wherein the plain text response can further indicate that such damage is avoidable by an alternative microscopy action.

EXAMPLE 19: The computer program product of any preceding example can be implemented, wherein the program instructions can be further executable to cause the processor to: instruct the scanning electron microscope to perform the alternative microscopy action.

EXAMPLE 20: The computer program product of any preceding example can be implemented, wherein the large language model can receive as input the plain text command, the image or energy spectrum of the specimen, and one or more simulation results produced by a digital twin that is synchronized with the scanning electron microscope.

In various embodiments, any combination or combinations of examples 17-20 can be implemented.

In various embodiments, any combination or combinations of examples 1-20 can be implemented.

## Claims

1. A computer-implemented method, comprising:
accessing, by a device operatively coupled to a processor, a natural language instruction associated with a charged-particle microscope, wherein the natural language instruction requests or commands that the charged-particle microscope undergo a configurable settings adjustment or that the charged-particle microscope perform an automated task;
causing, by the device and in response to receipt of the natural language instruction, the charged-particle microscope to capture, according to a default microscopy protocol, an image or an energy spectrum of a specimen that is currently loaded on a stage of the charged-particle microscope; and
executing, by the device, a large language model on both the natural language instruction and the image or energy spectrum of the specimen, thereby yielding a natural language response that indicates how implementing the natural language instruction would affect the specimen.

2. The computer-implemented method of claim 1, further comprising:
visibly rendering, by the device, the natural language response or a visual graphic associated with the natural language response on an electronic display associated with the charged-particle microscope;
audibly playing, by the device, the natural language response on an electronic speaker associated with the charged-particle microscope; or
transmitting, by the device, the natural language response to a computing device associated with the charged-particle microscope.

3. The computer-implemented method of claim 1 or claim 2, wherein the natural language instruction is: plain text that is typed into a graphical user-interface text field associated with the charged-particle microscope; or plain text that is transcribed from an audio recording captured by a microphone associated with the charged-particle microscope.

4. The computer-implemented method of any one of the preceding claims, wherein the natural language response indicates that implementing the natural language instruction would harm or charge the specimen, and wherein the natural language response further indicates that the charged-particle microscope should undergo an alternative configurable settings adjustment or that the charged-particle microscope should perform an alternative automated task.

5. The computer-implemented method of claim 4, further comprising:
causing, by the device, the charged-particle microscope to undergo the alternative configurable settings adjustment or to perform the alternative automated task.

6. The computer-implemented method of any one of the preceding claims, further comprising:
identifying, by the device and via an embedding search of a document repository, one or more documents that are relevant to the natural language instruction and to the image or energy spectrum of the specimen, wherein the large language model receives as input the natural language instruction, the image or energy spectrum of the specimen, and the one or more documents.

7. The computer-implemented method of any one of the preceding claims, further comprising:
executing, by the device, one or more available deep learning models on the image or energy spectrum of the specimen, thereby yielding one or more inferencing task results, wherein the large language model receives as input the natural language instruction, the image or energy spectrum of the specimen, and the one or more inferencing task results.

8. The computer-implemented method of any one of the preceding claims, wherein the charged-particle microscope is synchronized with a digital twin, and wherein:
the large language model receives as input the natural language instruction, the image or energy spectrum of the specimen, and a current health status of the charged-particle microscope as indicated by the digital twin; or
the large language model receives as input the natural language instruction, the image or energy spectrum of the specimen, and one or more simulation results regarding the charged-particle microscope produced by the digital twin.

9. A computer program for facilitating large language model assistance for charged-particle microscope operation, the computer program comprising program code which is executable by a processor to carry out the method steps of any one of claims 1-8.

10. The computer program of claim 9, wherein the plain text response indicates that the specified microscopy action would damage the specimen, and wherein the plain text response further indicates that such damage is avoidable by an alternative microscopy action.

11. The computer program of claim 10, wherein the program code is further executable to cause the processor to:
instruct the scanning electron microscope to perform the alternative microscopy action.

12. The computer program product of claim 9, claim 10 or claim 11, wherein the large language model receives as input the plain text command, the image or energy spectrum of the specimen, and one or more simulation results produced by a digital twin that is synchronized with the scanning electron microscope.

13. A system comprising a memory within which is stored the computer program of any one of claims 9-12, and a processor configured to execute the computer program stored in the memory.

14. A computer program product upon which is embodied the computer program of any one of claims 9-12.
